(19) Europäisches Patentamt
European Patent Office
Office européen des brevets

(11) EP 2 354 851 B1

(12) # EUROPEAN PATENT SPECIFICATION

(45) Date of publication and mention of the grant of the patent:
**03.12.2014 Bulletin 2014/49**

(51) Int Cl.:
*G03F 7/09* (2006.01) *G03F 7/11* (2006.01)
*G03F 7/033* (2006.01) *G03F 7/035* (2006.01)

(21) Application number: **11152669.5**

(22) Date of filing: **31.01.2011**

(54) **Lithographic printing plate precursor and method of preparing lithographic printing plate**

Lithographiedruckplattenvorläufer und Verfahren zur Herstellung einer Lithographiedruckplatte

Précurseur de plaque d’impression lithographique et procédé pour la préparation d’une plaque d’impression lithographique

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **29.01.2010 JP 2010019676**

(43) Date of publication of application:
**10.08.2011 Bulletin 2011/32**

(73) Proprietor: **Fujifilm Corporation**
**Minato-ku**
**Tokyo 106-0031 (JP)**

(72) Inventors:
- **Abe, Junya**
**Shizuoka (JP)**
- **Iwai, Yu**
**Shizuoka (JP)**
- **Ishiguro, Yuriko**
**Shizuoka (JP)**

(74) Representative: **Hoffmann Eitle**
**Patent- und Rechtsanwälte PartmbB**
**Arabellastraße 30**
**81925 München (DE)**

(56) References cited:
**JP-A- 2009 244 422**
**US-A1- 2003 190 548**
**US-A1- 2009 114 108**

EP 2 354 851 B1

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

## FIELD OF THE INVENTION

The present invention relates to a lithographic printing plate precursor capable of being subjected to a so-called direct plate making, in which the plate making is directly conducted based on digital signals, for example, from a computer using various kinds of lasers and a method of preparing a lithographic printing plate, particularly, to a lithographic printing plate precursor suitable for simple processing and a method of preparing a lithographic printing plate.

## BACKGROUND OF THE INVENTION

A solid laser, semiconductor laser and gas laser having a large output and a small size, which radiate an ultraviolet ray, visible light or infrared ray having a wavelength of 300 to 1,200 nm, have become easily available, and these lasers are very useful for recording light sources used in the direct plate making based on digital data, for example, from a computer. Various investigations on recording materials sensitive to such various laser beams have been made. Typical examples thereof include firstly recording materials capable of being recorded with a infrared laser having an image-recording wavelength of 760 nm or longer, for example, positive type recording materials described in U.S. Patent 4,708,925 and acid catalyst crosslinking type negative type recording materials described in JP-A-8-276558 (the term "JP-A" as used herein means an "unexamined published Japanese patent application"), and secondly recording materials responsive to an ultraviolet ray or visible light laser having a wavelength of from 300 to 700 nm, for example, radical polymerization type negative type recording materials described in U.S. Patent 2,850,445 and JP-B-44-20189 (the term "JP-B" as used herein means an "examined Japanese patent publication").

Further, with respect to hitherto known lithographic printing plate precursors (hereinafter, also referred to as PS plates), after image exposure a step of removing the non-image area by dissolution (development processing) using an aqueous strongly alkaline solution is indispensable and a post-processing step, for example, washing the printing plate after the development processing with water, treatment of the printing plate after the development processing with a rinse solution containing a surfactant or treatment of the printing plate after the development processing with an oil-desensitizing solution containing gum arabic or a starch derivative, is also necessary. The point that such additional wet treatments are indispensable is a large subject of investigation in hitherto known PS plates. Even when the first half (image exposure) of plate making process is simplified by the above-described digital processing, the effects due to the simplification is still insufficient as long as the last half (development processing) is the troublesome wet treatment.

Particularly, the consideration for global environment has become a great concern throughout the field of industry in recent years. In view of the consideration for global environment, a treatment with a developer closer to a neutral range and a small amount of waste liquid are subjects of further investigations. In particular, it is desirable that the wet type post-processing is simplified or changed to a dry processing.

From this viewpoint, as one method for simplifying the processing step, a method of one solution processing or one bath processing wherein development and a gum solution treatment are simultaneously conducted is known. Specifically, the method is a simple development process wherein a lithographic printing plate precursor is subjected after image exposure without undergoing a pre-water washing step to removal of a protective layer, removal of a non-image area and a gum solution treatment simultaneously with one solution or one bath and then drying without undergoing a post-water washing step to perform a printing step. The lithographic printing plate precursor suitable for such a simple development process is required to have an image-recording layer soluble in a processing solution which is not strongly alkaline in order to eliminate the post-water washing step and also to have a hydrophilic surface of support in order to improve stain resistance of the non-image area. However, it is substantially impossible for hitherto known PS plates to realize high printing durability and chemical resistance while fulfilling such requirements.

In order to fulfill such requirements, a lithographic printing plate precursor wherein a support is subjected to a hydrophilizing treatment with polyvinylphosphonic acid is proposed (see, for example, JP-A-2009-98590). With respect to the plate making thereof, development is conducted with a processing solution having pH oaf 9.8 after image exposure with ultraviolet laser.

However, the hydrophilizing treatment with polyvinylphosphonic acid is poor in the hydrophilicity for improving the stain resistance and there is a problem on the stain resistance as a lithographic printing plate.

Also, instead of using the polyvinylphosphonic acid, a lithographic printing plate precursor having a layer containing a binder polymer prepared by copolymerization of a monomer having a sulfonic acid group and a monomer having a support adsorbing group formed on a surface of support is proposed (see, for example, JP-A-2009-216924). The lithographic printing plate precursor according to the proposal has an advantage of excellent stain resistance due to high hydrophilicity of the sulfonic acid group. However, because of the high hydrophilicity adhesion force between the surface of support and the image-recording layer decreases to largely deteriorate printing durability and chemical resistance. Thus, it is extremely difficult to achieve a good balance between the printing durability and chemical resistance

and the stain resistance and a lithographic printing plate precursor of a simple processing type which is excellent in the stain resistance and has sufficient printing durability has not been known yet.

As another method for simplifying the processing step, a method referred to as on-press development wherein an exposed lithographic printing plate precursor is mounted on a cylinder of a printing machine and the non-image area of the lithographic printing plate precursor is removed by supplying dampening water and ink while rotating the cylinder is known. Specifically, according to the method, the lithographic printing plate precursor is exposed imagewise and mounted on a printing machine as it is to complete development processing in a conventional process of printing.

A lithographic printing plate precursor suitable for the on-press development is required to have an image-fanning layer soluble in dampening water or an ink solvent and to have a bright room handling property suitable for development on a printing machine placed in a bright room. However, it is substantially impossible for hitherto known PS plates to sufficiently fulfill such requirements.

In order to fulfill such requirements, a lithographic printing plate precursor having provided on a hydrophilic support an image-forming layer in which fine particles of thermoplastic hydrophobic polymer are dispersed in a hydrophilic binder polymer is proposed (see, for example, Japanese Patent 2938397). In the plate making, the lithographic printing plate precursor is imagewise exposed to an infrared laser to agglomerate (fuse) the fine particles of thermoplastic hydrophobic polymer by heat generated by light-to-heat conversion thereby forming an image, and mounted on a cylinder of a printing machine to carry out on-press development by supplying at least any one of dampening water and ink Since a lithographic printing plate precursor has the sensitive zone in an infrared region, it also has the handling property in a bright room.

However, the image formed by the agglomeration (fusion) of the fine particles of thermoplastic hydrophobic polymer is insufficient in the strength thereof and has a problem of printing durability as a lithographic printing plate.

A lithographic printing plate precursor including microcapsules containing a polymerizable compound incorporated therein instead of the thermoplastic fine particles is also proposed. It is further proposed to use a thermally degradable polymer in a shell of the microcapsule (see, for example, JP-A-2000-211262, JP-A-2001-277740, JP-A-2002-29162, JP-A-2002-46361, JP-A-2002-137562 and JP-A-2002-326470). In the lithographic printing plate precursor according to such a proposal, it is advantageous that the polymer image formed by a reaction of the polymerizable compound is excellent in the strength in comparison with the image formed by the fusion of the fine particles.

However, in the hitherto known lithographic printing plate precursors described in Japanese Patent 2938397, JP-A-2000-211262, JP-A-2001-277740, JP-A-2002-29162, JP-A-2002-46361, JP-A-2002-137562 and 1P-A-2002-326470, printing durability of the image formed by laser exposure is insufficient and thus further improvements have been requested. Specifically, in such a lithographic printing plate precursor of a simple processing type, a support having a surface of high hydrophilicity is used and as a result, the image area is apt to be removed from the support with dampening water during printing and sufficient printing durability can not be obtained. On the contrary, when the surface of support renders hydrophobic, ink also adheres on the non-image area during printing to cause printing stain. Thus, it is extremely difficult to achieve a good balance between the printing durability and the stain resistance and a lithographic printing plate precursor of a simple processing type which provides good stain resistance and sufficient printing durability has not been known yet.

In JP-A-2001-166491, a support for lithographic printing plate precursor comprising the support having thereon a hydrophilic layer comprising a polymer compound which chemically bonds directly to a surface of the support and has a hydrophilic group is described, In JP-A-2003-63166, JP-A-2004-276603 and JP-A-2008-213177, supports for lithographic printing plate precursor comprising an aluminum support or aluminum support subjected to a silicate treatment having a hydrophilic surface in which a hydrophilic polymer having reactive group capable of chemically bonding to a surface of the support directly or through a constituting component having a crosslinked structure is chemically bonded are described. In JP-A-2006-78999, a lithographic printing plate precursor comprising a support and an image-recording layer containing a polymerization initiator, a polymerizable compound and a binder polymer soluble or swellable in water or an aqueous alkali solution and containing a copolymer including at least a repeating unit having at least one ethylenically unsaturated bond and a repeating unit having at least one functional group capable of interacting with a surface of the support in the image-recording layer or other layer thereof is described. However, the lithographic printing plate precursors described in JP-A-2001-166491, JP-A-2003-6316C and JP-A-2004-276603 have a problem in that the stain resistance is still insufficient, In particular, when plate making and printing were conducted after the lapse of time from the preparation of the lithographic printing plate precursor, there is a problem of deteriorating the stain resistance.

US-A-2009 114 108 and US 2003 190 548 disclose a lithographic printing plate precursor wherein a layer contains a polymer having a specific side chain structure.

## SUMMARY OF THE INVENTION

Therefore, an object of the present invention is to provide a lithographic printing plate precursor which is capable of being subjected to direct plate making based on digital data, for example, from a computer, by image-recording using

various kinds of lasers, particularly, can be developed also with an aqueous solution having pH of 10.5 or less or on a printing machine, is excellent in developing property, and can provide a lithographic printing plate exhibiting high chemical resistance, high printing durability, good stain resistance and good stain resistance after the lapse of time, and a method of preparing a lithographic printing plate.

As a result of the intensive investigations, the inventors have found that the above-described object can be achieved by using a lithographic printing plate precursor and a method of preparing a lithographic printing plate described below. Specifically, the present invention provides lithographic printing plate precursor comprising an image-recording layer and a support, wherein the image-recording layer adjacent to the support or an undercoat layer provided between the support and the image-recording layer contains (A) a polymer containing a side chain having a structure represented by formula (I) or (II) shown below:

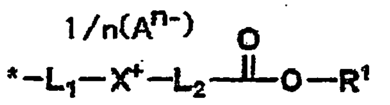 (I) 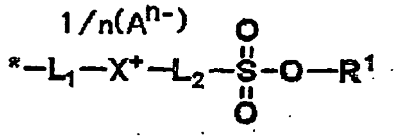 (II)

in formulae (1) and (II), $R^1$ represents a monovalent group, $L_1$ represents a divalent connecting group connecting to a main chain of the polymer, $L_2$ represents a divalent connecting group, $X^+$ represents $-N^+R^2R^3-$, $-S^+R^2-$, $-I^+-$, $P^+R^2R^3-$ or a group represented by formula (III) shown below, $R^2$ and $R^3$ each independently represents an alkyl group, an aryl group or a heteroaryl group, each of which may be substituted, or $R^2$ and $R^3$ may be combined with each other to form a ring, $1/n(A^{n-})$ represents an anion for making the structure represented by formula (I) or (II) neutral, n represents an integer from 1 to 3, and * represents a site connecting to the main chain of the polymer:

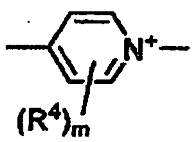 (III)

in formula (III), $R^4$ represents a hydrogen atom or a monovalent group, and m represents an integer from 1 to 4 as claimed in claim 1. Embodiments thereof are described in claims 2-11.

The present invention also provides a method of preparing a lithographic printing plate as claimed in present Claim 12.

The function of the invention is presumed as follows. Specifically, by incorporating (A) the polymer containing a side chain having a structure represented by formula (I) or (II) into the image-recording layer adjacent to the support or the undercoat layer provided between the support and the image-recording layer, an ester bond in the structure represented by formula (I) or (II) is hydrolyzed to undergo functionality change to a highly hydrophilic zwitter-ion with a developer or dampening water penetrating in the non-image area. As a result, the developing property or on-press development property increases and printed materials excellent in the stain resistance are obtained. In particular, since the zwitterionic unit is formed after the development, detachment of the image area from the support arising from high hydrophilicity of the surface of support before the development is prevented to achieve excellent printing durability. Also, deterioration of the stain resistance or decrease in the development property caused by electrostatic interaction of the zwitterionic unit with the image-recording layer is prevented to attain stably the stain resistance and developing property even with the lapse of time.

According to the present invention, a lithographic printing plate precursor having high productivity which is capable of being subjected to a so-called direct plate making, in which the plate making is directly conducted based on digital signals, for example, from a computer using various kinds of lasers, can be developed also with an aqueous solution having pH of 10.5 or less or on a printing machine, is excellent in developing property, and can provide a lithographic printing plate exhibiting high chemical resistance, high printing durability, good stain resistance and good stain resistance after the lapse of time can be obtained.

BRIEF DESCRIPTION OF THE DRAWINGS

Fig. 1 is a view schematically showing a configuration of an automatic development processor.

Description of reference numerals and signs]

1: Lithographic printing plate precursor

4: Pre-heating unit

S ; Heating chamber

6: Developing unit

10: Drying unit

12: Carrying-in roller

14: Skewer roller

16: Transport roller

20: Developing tank

22: Transport roller

24: Brush roller

26: Squeeze roller

28: Backup roller

36: Guide roller

38: Skewer roller

DETATLED DESCRIPTION OF THE INVENTION

In the specification, with respect to the description of a group in a compound represented by a formula, when the group is not indicated whether substituted or unsubstituted, unless otherwise indicated specifically, the group includes not only the unsubstituted group but also the substituted group, if the group is able to have a substituent. For example, the description "R represents an alkyl group, an aryl group or a heterocyclic group" in a formula means that "R represents an unsubstituted alkyl group, a substituted alkyl group, an unsubstituted aryl group, a substituted aryl group, an unsubstituted heterocyclic group or a substituted heterocyclic group".

The lithographic printing plate precursor according to the invention, will be described in detail below.

The lithographic printing plate precursor according to the invention is a lithographic printing plate precursor including an image-recording layer and a support and optionally including an undercoat layer provided between the support and the image-recording layer, wherein the image-recording layer adjacent to (contacting with) the support or the undercoat layer provided between the support and the image-recording layer contains (A) a polymer (hereinafter, also referred to as a specific polymer compound) containing a side chain having a structure represented by formula (I) or (II) shown below. The image-recording layer preferably contains (B) a polymerization initiator, (C) a polymerizable compound, (D) a sensitizing dye, and (E) a binder polymer. The image-recording layer according to the invention may further contain other components, if desired. The constituting components of the lithographic printing plate precursor according to the invention will be described in detail below.

(A) Specific polymer compound

The specific polymer compound according to the invention is a polymer containing a side chain having a

structure represented by formula (I) or (II) shown below. The specific polymer compound is described in detail below. First, formulae (I) and (II) are described below.

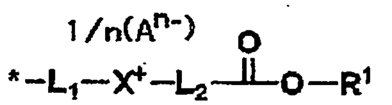 (I) 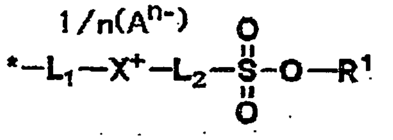 (II)

In formulae (I) and (II), $R^1$ represents a monovalent group, $L_1$ represents a divalent connecting group connecting to a main chain, of the polymer, $L_2$ represents a divalent connecting group, $X^+$ represents $-N^+R^2R^3$ $-S^+R^2-$, $-I^+-$, $-P^+R^2R^3$ - or a group represented by formulae (III) shown below, $R^2$ and $R^3$ each independently represents an alkyl group, an aryl group or a heteroaryl group, each of which may be substituted, or $R^2$ and $R^3$ may be combined with each other to form a ring, $1/n(A^{n-})$ represents an anion for making the structure represented by formula (I) or (II) neutral, n represents an integer from 1 to 3, and * represents a site connecting to the main chain of the polymer.

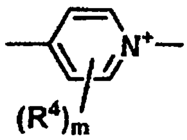 (III)

In formula (III), $R^4$ represents a hydrogen atom or a monovalent group, and m represents an integer from 1 to 4.
In formulae (I) and (II) the monovalent group represented by $R^1$ is preferably an alkyl group having from 1 to 50 carbon atoms or an aryl group, from 1 to 40 carbon atoms, more preferably an alkyl group having from 3 to 40 carbon atoms or an aryl group, and still more preferably an alkyl group having from 3 to 30 carbon atoms which may be substituted or may be branched.
The alkyl group or aryl group may have a substituent. As the substituent, a monovalent non-metallic atomic group exclusive of a hydrogen atom is used. Preferable examples of the substituent include a halogen atom (for example, -F, -Br, -Cl or -I), a hydroxy group, an alkoxy group, an aryloxy group, a mercapto group, an alkylthio group, an arylthio group, an alkyldithio group, an aryldithio group, an amino group, an N-alkylamano group, an N,N-dfarylamino group, an N-a3kyl-N-arylarzazna group, an acyloxy group, a carbamoyloxy group, an N-alkylcarbamoyloxy group, an N-arylcarbamoyloxy group, an N,N-dialkylcarbamoyloxy group, an N,N-diarylcarbamoyloxy group, an N-allcyl-N-arylcarbamoyloxy group, an alkylsulfoxy group, an arylsulfoxy group, an acylthio group, an acylamino group, an N-alkylacylamino group, an N-arylacylamino group, a ureido group, an N-alkylureido group, an N',N'-dialkyluxeida group, an N'-arylureido group, an N',N'-diarylureido group, an N'-allcyl-N'-arylureido group, an N-alkylureido group, an N-arylureido group, an N'-alkyl-N-alkylureido group, an N'-alkyl-N-arylureido group, an N',N'-diakl-N-alkylurcido group, an N',N-dialkyl-N-aTylureido group, an N'-aryl-N-alkylureido group, an N'-aryl-N-arylureido group, an N',N'-diaryl-N-alkylureido group, an N',N'-diary-N-arylureido group, an N'-alkyl-N'-aryl-N-alkylureido group, an N'-alkyl-N'-aryl-N-arylureido group, an alkoxycarbonylamino group, an aryloxycarbonylamino group, an N-alkyl-N-alkoxycarbonylamino group, an N-alkyl-N-aryloxycarbonylamino group, an N-aryl-N-alkoxycarbonylamino group, an N-aryl-N-aryloxycarbonylamino group, a formyl group, an acyl group, a carboxyl group, an alkoxycarbonyl group, an aryloxycarbonyl group, a carbamoyl group, an N-alkyLcarbamoyl group, an N,N-dialkylcarbamoyl group, an N-arylcarbamoyl group, an N,N-diarylcarbamoyl group, an N-alkyl-N-arylearbamoyl group, an alkylsulfinyl group, an arylsulfinyl group, an alkylsulfonyl group, an arylsulfonyl group, an alkoxysulfonyl group, an aryloxysulfonyl group, a sulfinamoyl group, an N-alkylsulfinamoyl group, an N,N-dialkylsulfinamoyl group, an N-arylsulfinamoyl group, an N,N-diarylsulfinamoyl group, an N-alkyl-N-arylsuUnarnoyl group, a sulfamoyl group, an N-alkylsulfamoyl group, an N,N-dialkylsulfamoyl group, an N-arylsulfamoyl group, an N,N-diarylsulfamoyl group, an N-alkyl-N-arylsulfainoyl group, a dialkylphosphono group ($-P0_3(alkyl)_2$), a diarylphosphono group ($-PO_3(aryl)_2$), an alkylarylphosphono group ($-PO_3(alkyl)(aryl)$), a dialkylphosphonooxy group ($-OPO_3(alkyl)_2$), a diarylphosphonooxy group ($-OPO_3(aryl)_2$), an alkylarylphosphonooxy group ($-OPO_3(alkyl)(aryl)$), a morpholino group, a cyano group, a nitro group, an aryl group, a an alkenyl group and an alkynyl group.
Particularly preferable substituent includes a halogen atom (for example, -F, -Br, -Cl or -I), a hydroxy group, an alkoxy group, an aryloxy group, a mercapto group, an amino group and a dialkylamino group.
Specific examples of the alkyl group for $R^1$ include a methyl group, an ethyl group, a propyl group, a butyl group, a pentyl group, a hexyl group, a heptyl group, an octyl group, a nonyl group, a decyl group, an undecyl group, a dodecyl group, a tridecyl group, a hexadecyl group, an octadecyl group, an eucosyl group, an isopropyl group, an isobutyl

group, a sec-butyl group, a tert-butyl group, an isopentyl group, a neopentyl group, a 1-methylbutyl group, an isohexyl group, a 2-ethylhexyl group, a 2-methylhexyl group, a cyclohexyl group, a cyclopentyl group, a 2-norbomyl group, a chloromethyl group, a bromomethyl group, a 2-chloroethyl group, a trifluoromethyl group, a methoxymethyl group, a methoxyethoxyethyl group, an allyloxymethyl group, a phenoxymethyl group, a methylthiomethyl group, a tolylthiomethyl group, an ethylaminoethyl group, a diethylaminopropyl group, a morpholinopropyl group, an acetyloxymethyl group, a benzoyloxymethyl group, an N-cyclohexylcarbamoyloxyethyl group, an N-phenylcarbamoyloxyethyl group, an acetylaminoethyl group, an N-methylbenzoylaminopropyl group, a 2-oxoethyl group, a 2-oxopropyl group, a carboxypropyl group, a methoxycarbonylethyl group, an allyloxycarbonylbutyl group, a chlorophenoxycarbonylmethyl group, a carbamoylmethyl group, an N-methylcarbamoylethyl group, an N,N-dipropylcarbamoylmethyl group, an N-(methoxyphenyl)csrbamoylethyl group, a sulfamoylbutyl group, an N-ethylsulfamoylmethyl group, an N,N-clipropylsulfamaylprapyl group, an N-tolylsulfamoylpropyl group, a benzyl group, a phenethyl group, an a-methylbenzyl group, a 1-methyl-1-phenylethyl group, a p-methylbenzyl group, a cinnamyl group, an allyl group, a 1-propenylmethyl group, a 2-butenyl group, a 2-methylallyl group, a 2-methylpropenylmethyl group, a 2-propynyl group, a 2-butynyl group and a 3-butynyl group.

Specific examples of the aryl group for $R^1$ include a phenyl group, a biphenyl group, a naphthyl group, a tolyl group, a xylyl group, a mesityl group, a cumenyl group, a chlorophenyl group, a bromophenyl group, a chloromethylphenyl group, a hydroxyphenyl group, a methoxyphenyl group, an ethoxyphenyl group, a phenoxyphenyl group, an acetoxyphenyl group, a benzoyloxyphenyl group, a methylthiophenyl group, a phenylthiophenyl group, a methylaminophenyl group, a dimethylaminophenyl group, an acetylaminophenyl group, a carboxyphenyl group, a methoxycarbonylphenyl group, an ethoxycarbonylphenyl group, a phenoxycarbonylphenyl group, an N-phenylcarbamoylphenyl group, a nitrophenyl group and a cyanophenyl group.

In formulae (I) and (II), the divalent connecting group represented by $L_1$ or $L_2$ is composed of from 1 to 60 carbon atoms, from 0 to 10 nitrogen atoms, from 0 to 50 oxygen atoms, from 1to 100 hydrogen atoms and from 0 to 20 sulfur atoms. More specifically, the structural units shown below and the connecting groups constructed from a combination thereof are exemplified.

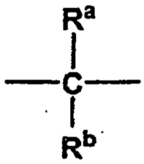
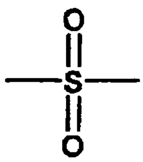
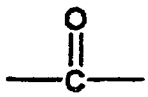
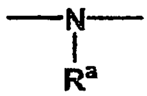
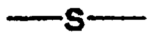

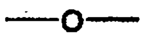
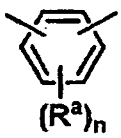
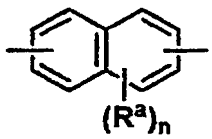
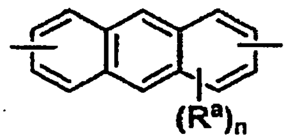

In the structural units shown above, $R^a$ and $R^b$ each represents a hydrogen atom, an alkyl group having from 1 to 20 carbon atoms, an aryl group having from 6 to 20 carbon atoms or a halogen atom, and n represents an integer from 1 to 4.

In formulae (I) and (II), the divalent connecting group represented by $L_1$ is preferably -COO- or -CONH-.

In formulae (I) and (II), the divalent connecting group represented by $L_2$ is preferably an alkylene group which may be substituted, more preferably an alkylene group having from 1 to 14 carbon atoms which may be substituted, still more preferably an alkylene group having from 1 to 5 carbon atoms which may be substituted, and particularly preferably a methylene group which may be substituted from the standpoint of stability of the zwitter-ion generated after hydrolysis. The substituent for the alkyl group is not particularly restricted and includes, for example, those described for the substituent for the alkyl group or aryl group represented by $R^1$ above.

In formulae (I) and (II), the alkyl group and aryl group represented by $R^2$ or $R^3$ included in $X^+$ are same as the alkyl group and aryl group described with respect to $R^1$ including the specific examples thereof, respectively. The ring formed by combining $R^2$ and $R^3$ is preferably a 5-member or 6-membered ring which may be substituted and which may contain a hetero atom as the ring-fomiing atom. From the standpoint of the effect and ease in synthesis, $R^2$ and $R^3$ each preferably represents an alkyl group having from 1 to 12 carbon atoms which may be substituted or an aryl group having from 6 to 12 carbon atoms which may be substituted, and each particularly preferably represents an alkyl group having from 1 to 12 carbon atoms which may be substituted.

$X^+$ is preferably $-N^+R^2R^3-$ $-S^+R^2-$, and particularly preferably $-N^+R^2R^3-$.

In formulae (I) and (II), from the standpoint of stability of a coating solution, $A^{n-}$ is preferably a halide ion, a perchlorate ion, a tetrafluoroborate ion, a hexafluorophosphate ion or a sulfonate ion, more preferably a perchlorate ion, a hexafluorophosphate ion or an arylsulfonate ion, and particularly preferably a hexafluorophosphate ion. More than one $X^+$ may be neutralized with one counter anion,

From the standpoint of ease in synthesis of the specific polymer compound, n is particularly preferably 1.

In formula (III), the monovalent group represented by $R^4$ is not particularly restricted and includes, for example, the group described for the substituent for the alkyl group or aryl group represented by $R^1$ above.

Of the structures represented by formulae (I) and (II), the structure represented by formula (I) is particularly preferred in the specific polymer compound according to the invention. The specific polymer compound may have both the structure represented by formula (I) and the structure represented by formula (II).

The specific polymer compound according to the invention is preferably a polymer containing a repeating unit (al) having the structure represented by formula (I) or (II). Specific examples of the polymer includes a (meth)acrylic polymer, a styryl polymer, a polyurethane resin, a polyvinyl alcohol resin, a polyvinyl formal resin, a polyamide resin, a polyester resin and an epoxy resin. Particularly, a (meth)acrylic polymer or a styryl polymer is preferred. As the repeating unit having the structure represented by formula (I) or (II), a repeating unit represented by formula (A1) shown below is preferred.

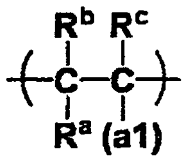 (A1)

In formula (A1), $R^a$ to $R^c$ each independently represents a hydrogen atom, an alkyl group having from 1 to 6 carbon atoms or a halogen atom, and (al) represents a structure represented by formula (I) or (II) which connects to the carbon atom at the site represented by * in formula (I) or (II).

$R^a$ to $R^c$ each preferably represents a hydrogen atom or an alkyl group having from 1 to 6 carbon atoms, and particularly preferably represents a hydrogen atom, a methyl group or an ethyl group.

The ratio of the repeating unit (a1) having the structure represented by formula (I) or (II) in the specific polymer compound according to the invention is preferably from 1 to 99% by mole, more preferably from 1 to 90% by mole, still more preferably from 1 to 80% by mole, based on the total repeating units, from the standpoint of stain resistance and printing durability.

Specific examples of the repeating unit (al) having the structure represented by formula (I) or (II) are set forth in the specific examples of the specific polymer compound according to the invention below.

Further, the specific polymer compound according to the invention preferably contains a repeating unit (a2) having at least one functional group capable of interacting with a surface of the support in order to increase an adhesion property to the support. The functional group capable of interacting with a surface of the support includes, for example, a group capable of undergoing interaction, for example, forming an ionic bond or a hydrogen bond or undergoing polar interaction, with metal, a metal oxide, a hydroxy group or the like present on the support subjected to anodizing treatment or hydrophilizing treatment is exemplified. Specific examples of the functional group capable of interacting with a surface of the support are set forth below.

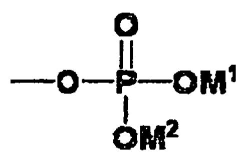
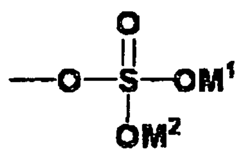
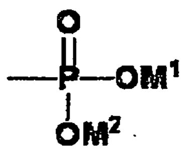
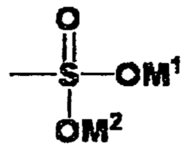

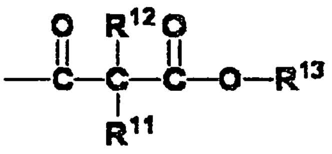
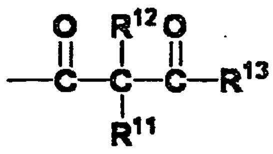
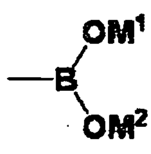
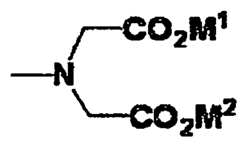

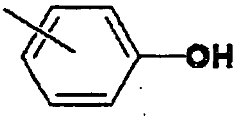 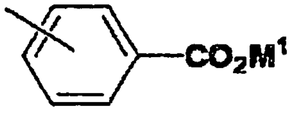 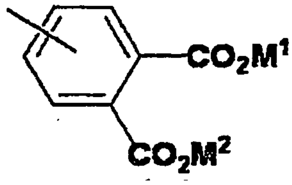

In the formulae above, $R^{11}$ to $K^{13}$ each independently represents a hydrogen atom, an alkyl group having from 1 to 10 carbon atoms, an alkynyl group having from 2 to 10 carbon atoms, an alkenyl group having from 2 to 10 carbon atoms or an aryl group having from 6 to 15 carbon atoms, and $M^1$ and $M^2$ each independently represents a hydrogen atom, a metal atom included in alkali metal or alkaline earth metal or an ammonium group.

From the standpoint of the stain resistance and printing durability, the functional group capable of interacting with a surface of the support is preferably a carboxylic acid group a sulfonic acid group, a phosphoric acid ester group or a salt thereof or a phosphonic acid group or a salt thereof. In view of further improvement in the stain resistance, a phosphoric acid ester group or a salt thereof or a phosphonic acid group or a salt thereof is more preferred, and a phosphonic acid group or a salt thereof is particularly preferred.

The repeating unit (a2) having at least one functional group capable of interacting with a surface of the support is preferably a repeating unit represented by formula (A2) shown below,

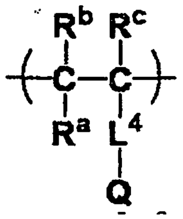 (A2)

In formula (A2), $R^a$ to $R^c$ have the same meanings as $R^a$ to $R^c$ defined in formula (A1) respectively, $L^4$ represents a single bond or a divalent connecting group, and Q represents a functional group capable of interacting with a surface of the support.

The divalent connecting group represented by $L^4$ is composed of from 1 to 60 carbon atoms, from 0 to 10 nitrogen atoms, from 0 to 50 oxygen atoms, from 1 to 100 hydrogen atoms and from 0 to 20 sulfur atoms. More specifically, the connecting groups described with respect to the divalent connecting group represented by $L^1$ or $L^2$ in formula (I) or (II) above are exemplified.

The functional group capable of interacting with a surface of the support represented by Q is preferably that described above.

The ratio of the repeating unit (a2) having at least one functional group capable of interacting with a surface of the support in the specific polymer compound according to the invention is preferably 99% by mole or less, more preferably from 10 to 95% by mole, still more preferably from 20 to 95% by mole, based on the total repeating units, from the standpoint of stain resistance and printing durability.

Further, the specific polymer compound according to the invention may contain as a copolymerization component, a repeating unit (hereinafter, also referred to as other repeating unit) other than (al) the repeating unit having a structure represented by formula (I) or (II) and (a2) the repeating unit having a functional group capable of interacting with a surface of the support. As the other repeating unit, repeating units derived from conventionally knows various monomers are exemplified.

Preferable examples of the other repeating unit include repeating units derived from known monomers, for example, acrylates, methacrylates, acrylamides, methacrylamides, vinyl esters, styrenes, acrylic acid, methacrylic acid, acrylonitrile, maleic anhydride and maleimide. By introducing the other repeating unit, various physical properties, for example, film-forming property, film strength, hydrophilicity, hydrophobicity, solubility, reactivity or stability can be appropriately improved or controlled.

Specific examples of the acrylate include methyl acrylate, ethyl acrylate, n- or iso-propyl acrylate, n-, iso-, sec- or tert-butyl acrylate, amyl acrylate, 2-ethylhexyl acrylate, dodecyl acrylate, chloroethyl acrylate, 2-hydroxyethyl acrylate, 2-hydroxypropyl acrylate, 2-hydroxypentyl acrylate, cyclohexyl acrylate, trimethylolpropane monoacrylate, pentaerythritol monoacrylate, benzyl acrylate, methoxybenzyl acrylate, chlorobenzyl acrylate, hydroxybenzyl acrylate, hydroxyphenetyl acrylate, dihydroxyphenetyl acrylate, furfuryl acrylate, tetrahydrofurfuryl acrylate, phenyl acrylate, hydroxyphenyl acrylate, chlorophenyl acrylate, sulfamoylphenyl acrylate, 2-(hydroxyphenylcarbonyloxy)ethyl acrylate and polyalkylene glycol acrylate.

Specific examples of the methacrylate include methyl methacrylate, ethyl methacrylate, nor iso-propyl methacrylate, n-, iso-, sec- or tert-butyl methacrylate, amyl methacrylate, 2-ethylhexyl methacrylate, dodecyl methacrylate, chloroethyl methacrylate, 2-hydroxyethyl methacrylate, 2-hydroxypropyl methacrylate, 2-hydroxypentyl methacrylate, cyclohexyl methacrylate, trimethylolpropane monomethacrylate, pentacrythritol monomethacrylate, benzyl methacrylate, methoxybenzyl methacrylate, chlozobenzyl methacrylate, hydroxybenzyl methacrylate, hydroxyphenetyl methacrylate, dihydroxyphenetyl methacrylate, furfuryl methacrylate, tetrahydrofurfuryl methacrylate, phenyl methacrylate, hydroxyphenyl methacrylate, chlorophenyl methacrylate, sulfamoylphenyl methacrylate, 2-(hydroxyphenylearbonyloxy)ethyl methacrylate and polyalkylene glycol methacrylate.

Specific examples of the acrylamide include acrylamide, N-methylacrylamide, N-ethylacrylamide, N-propylacrylamide, N-butylacrylamide, N-benzylacrylamide, N-hydroxyethylacrylamide, N-phenylacrylamide, N-tolylacrylamide, N-(hydroxyphenyl)acrylamide, N-(sulfamoylphenyl)acrylamide, N-(phenylsulfonyl)acrylamide, N-(tolylsulfonyl)acrylamide, N,N-dirzaethylacrylamide, N-methyl-N-phenylacrylamide, N-hydroxyethyl-N-methylacrylamide and polyalkylene glycol acrylamide.

Specific examples of the methacrylamide include methacrylamide, N-methylmethacrylamide, N-ethyhnethacrylamide, N-propylmethacrylamide, N-bulylmethacrylamide, N-benzylmethacrylamide, N-hydroxyethylmethacrylamide, N-phenylmethacrylamide, N-tolylmethacrylamide, N-(hydroxyphenyl)methacrylamide, N-(su1fanloylphenyl)methacrylamide, N-(phenylsulfonyl)methacrylamide, N-(tolylsulfonyl)methacrylamide, NN-dimethyhnethaerylamide, N methyl-N-phenylmethacrylamide, N-hydroxyethyl-N-methylmethacrylamide and polyalkylene glycol methacrylamide.

Specific examples of the vinyl ester include vinyl acetate, vinyl butyrate and vinyl benzoate. Specific examples of the styrene include styrene, methylstyrene, dimethylstyrene, trimethylstyrene, ethylstyrene, propylstyrene, cyclohexylstyrene, chloromethylstyrene, trifluoromethylstyrene, ethoxymethylstyrene, acetoxymethylstyrene, methoxystyrene, dimethoxystyrene, chlorostyrene, dichlorostyrene, bromostyrene, iodostyrene, fluorostyrene and carboxystyrene.

The ratio of the other repeating unit in the specific polymer compound according to the invention is preferably from 0 to 60% by mole, more preferably from 0 to 50% by mole, and still more preferably from 0 to 40% by mole.

Moreover, the specific polymer compound according to the invention may be imparted with a crosslinking property in order to increase the film strength of the image area. In order to impart the crosslinking property to the specific polymer compound according to the invention, a crosslinkable functional group is introduced into a main chain or side chain of the specific polymer compound. The crosslinkable functional group may be introduced by copolymerization or may be introduced by a polymer reaction.

The term "crosslinkable functional group" as used herein means a group having a function of capable of crosslinking the binder polymer in the process of a radical polymerization reaction which is caused in the image-recording layer, when the lithographic printing plate precursor is exposed to light. The crosslinkable group is not particularly restricted as long as it has such a function and includes, for example, an ethylenically unsaturated bond group or an epoxy group as a functional group capable of conducting an addition polymerization reaction. Also, a functional group capable of forming a radical upon irradiation with light may be used and such a crosslinkable functional group includes, for example, a thiol group, a halogen atom and an onium salt structure. Among them, the ethylenically unsaturated bond group is preferred, and functional groups represented by formulae (i) to (iii) shown below are particularly preferred.

Formula (i):

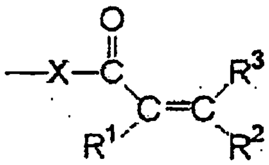

In formula (i), $R^1$ to $R^3$ each independently represents a hydrogen atom or a monovalent organic group. $R^1$ preferably includes, for example, a hydrogen atom or an alkyl group which may have a substituent. Among them, a hydrogen atom or a methyl group is preferred because of high radical reactivity. $R^2$ and $R^3$ each independently preferably includes, for example, a hydrogen atom, a halogen atom, an amino group, a carboxyl group, an alkoxycarbonyl group, a suite group, a nitro group, a cyano group, an alkyl group which may have a substituent, an aryl group which may have a substituent, an alkoxy group which may have a substituent, an aryloxy group which may have a substituent, an alkylamino group which may have a substituent, an arylamino group which may have a substituent, an alkylsulfonyl group which may have a substituent and an arylsulfonyl group which may have a substituent. Among them, a hydrogen atom, a carboxyl group, an alkoxycarbonyl group, an alkyl group which may have a substituent or an aryl group which may have a substituent is preferred because of high radical reactivity.

X represents an oxygen atom, a sulfur atom or $-N(R^{12})-$, and $R^{12}$ represents a hydrogen atom or a monovalent

organic group. The monovalent organic group represented by $R^{12}$ includes, for example, an alkyl group which may have a substituent. $R^{12}$ is preferably a hydrogen atom, a methyl group, an ethyl group or an isopropyl group because of high radical reactivity.

Examples of the substituent introduced include an alkyl group, an alkenyl group, an alkynyl group, an aryl group, an alkoxy group, an aryloxy group, a halogen atom, an amino group, an alkylamino group, an arylamino group, a carboxyl group, an alkoxycarbonyl group, a sulfo group, a nitro group, a cyano group, an amido group, an alkylsulfonyl group and an arylsulfonyl group.

Formula (ii):

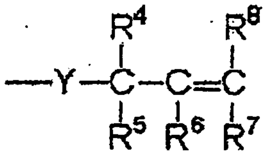

In formulae (ii), $R^4$ to $R^8$ each independently represents a hydrogen atom or a monovalent organic group. $R^4$ to $R^8$ each independently preferably includes, for example, a hydrogen atom, a halogen atom, an amino group, a carboxyl group, an alkoxycarbonyl group, a sulfo group, a nitro group, a cyano group, an alkyl group which may have a substituent, an aryl group which may have a substituent, an alkoxy group which may have a substituent, an aryloxy group which may have a substituent, an alkylamino group which may have a substituent, an arylamino group which may have a substituent, an alkylsulfonyl group which may have a substituent and an arylsulfonyl group which may have a substituent. Among them, a hydrogen atom, a carboxyl group, an alkoxycarbonyl group, an alkyl group which may have a substituent or an aryl group which may have a substituent is preferred.

Examples of the substituent introduced include those described in Formula (i).

Y represents an oxygen atom, a sulfur atom or $-N(R^{12})_$, and $R^{12}$ has the same meaning as $R^{12}$ defined in Formula (i). Preferable examples for $R^{12}$ are also same as those described in Formula (i).

Formula (iii):

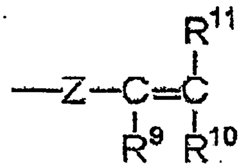

In formula (iii), $R^9$ to $R^{11}$ each independently represents a hydrogen atom or a monovalent organic group. $R^9$ preferably represents a hydrogen atom or an alkyl group which may have a substituent. Among them, a hydrogen atom or a methyl group is preferred because of high radical reactivity. $R^{10}$ and $R^{11}$ each independently preferably represents, for example, a hydrogen atom, a halogen atom, an ammo group, a carboxyl group, an alkoxycarbonyl group, a sulfo group, a nitro group, a cyano group, an alkyl group which may have a substituent, an aryl group which may have a substituent, an alkoxy group which may have a substituent, an aryloxy group which may have a substituent, an alkylamino group which may have a substituent, an arylamino group which may have a substituent, an alkylsulfonyl group which may have a substituent and an arylsulfonyl group which may have a substituent. Among them, a hydrogen atom, a carboxyl group, an alkoxycarbonyl group, an alkyl group which may have a substituent or an aryl group which may have a substituent is preferred because of high radical reactivity.

Examples of the substituent introduced include those described in Formula (i).

Z represents an oxygen atom, a sulfur atom, $-N(R^{13})-$ or a phenylene group which may have a substituent. $R^{13}$ includes, for example, an alkyl group which may have a substituent. Among them, a methyl group, an ethyl group or an isopropyl group is preferred because of high radical reactivity.

In the specific polymer compound having the crosslinking property, for example, a free radical (a polymerization initiating radical or a propagating radical in the process of polymerization of the polymerizable compound) is added to the crosslinkable functional group to cause an addition-polymerization between the specific polymer compounds directly or through a polymerization chain of the polymerizable compound, as a result, crosslinkage is formed between the specific polymer compound molecules to effect curing. Alternatively, an atom (for example, a hydrogen atom on the carbon atom adjacent to the functional crosslinkable group) in the specific polymer compound is withdrawn by a free radical to produce a polymer radical and the polymer radicals combine with each other to form crosslinkage between

the specific polymer compound molecules to effect curing.

Although the specific polymer compound according to the invention is able to synthesize by any hitherto known method, a radical polymerization method is preferably used for the synthesis thereof. Ordinary radical polymerization methods are described, for example, in Shin Kobunshi Jikkengaku 3, Kobunsbi no Gosei.Hanno 1, (New Polymer Experimentation 3. Synthesis and Reaction of Polymer 1), edited by The Society of Polymer Science, Japan, (Kyoritsu Shuppan Co., Ltd.), Shin Jikken Kagaku Koza 19, Kobunshi Kagaku (1), (New Experimental Chemistry Course 19, Polymer, Chemistry (I)), edited by The Chemical Society of Japan, (Maruzen Co., Ltd.) and Busshitsu Kogaku Koza. Kobunshi Gosei Kagaku, (Material Engineering Course, Polymer Synthesis Chemistry), (Tokyo Denki University Press) and these methods can be applied.

The weight average molecular weight of the specific polymer compound according to the invention can be appropriately set according to performance design of the lithographic printing plate precursor. When the weight average molecular weight thereof is too low, the printing durability may decrease. Thus, it is preferably from 2,000 to 1,000,000, and more preferably from 5,000 to 100,000, particularly preferably from 7,000 to 70,000, from the standpoint of the printing durability and stain resistance.

Specific examples of the specific polymer compound according to the invention are set forth below together with the weight average molecular weight thereof, but the invention should not be construed as being limited thereto. The composition ratio in the polymer structure is indicated by a molar percentage.

(P-1) 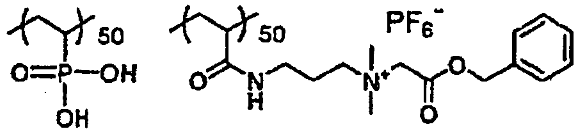 Mw:18,000

(P-2) 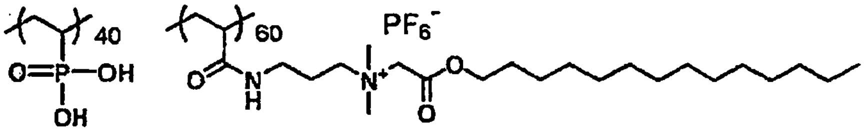 Mw:24,000

(P-3) 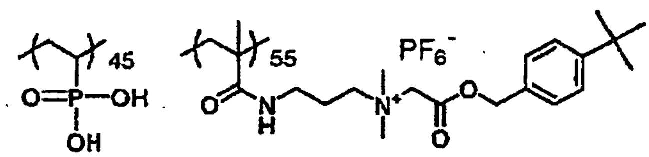 Mw:16,000

(P-4) 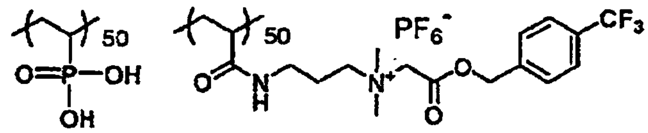 Mw:21,000

(P-5) 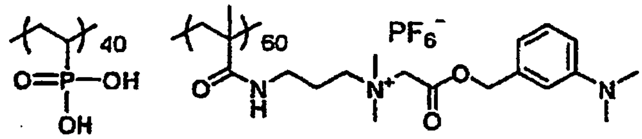 Mw:22,000

(P-6) 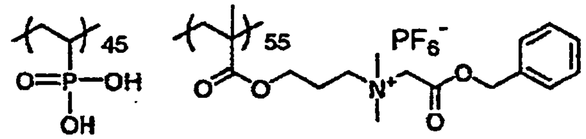 Mw:15,000

(P-7) 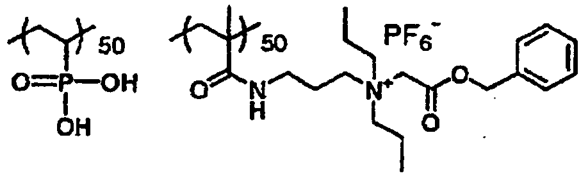 Mw:30,000

(P-8) 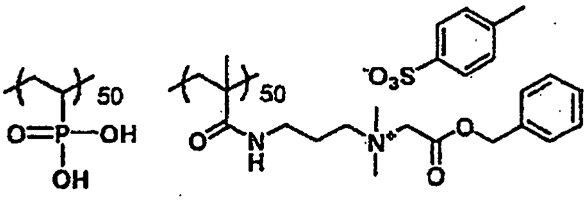 Mw:28,000

(P-9) 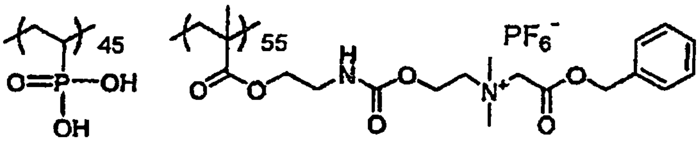 Mw:21,000

(P-10) 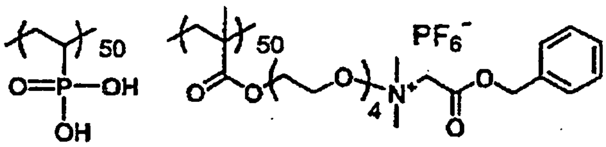 Mw:20,000

(P-11) 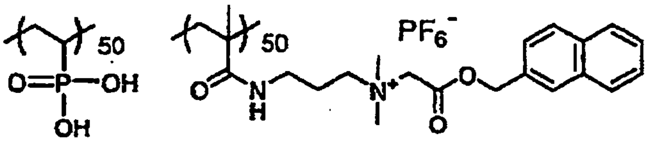 Mw:19,000

(P-12) 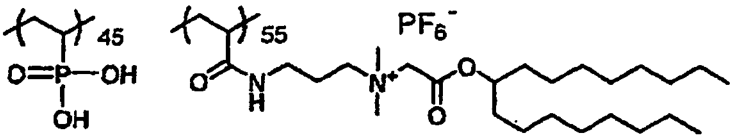 Mw:15,000

(P-13) 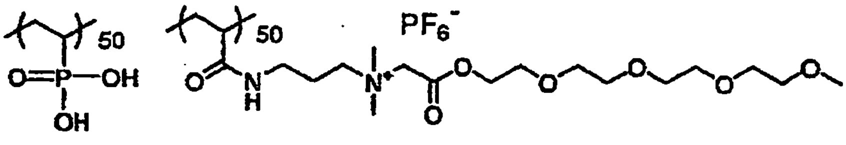 Mw:20,000

(P-14) 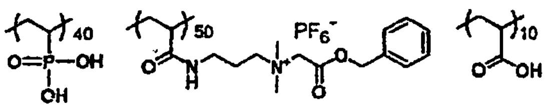 Mw:20,000

(P-15) 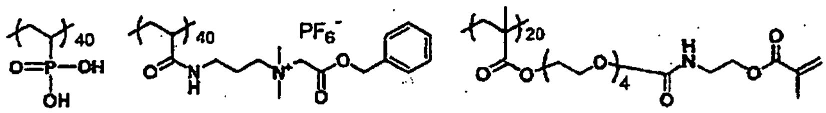 Mw:19,000

(P-16) 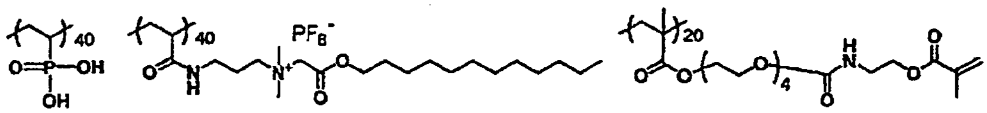 Mw:18,000

(P-17) 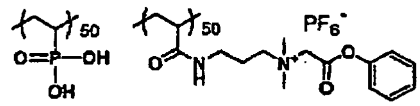 Mw:20,000

(P-18) 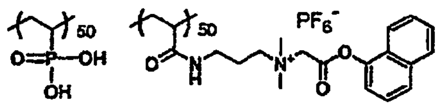 Mw:24,000

(P-19) 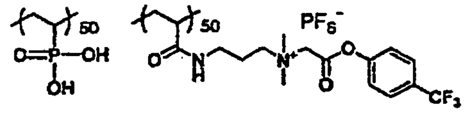 Mw:19,000

(P-20) 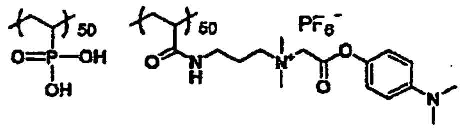 Mw:15,000

(P-21) 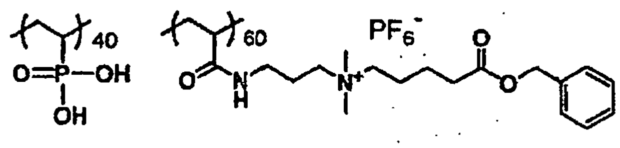 Mw:14,000

(P-22) 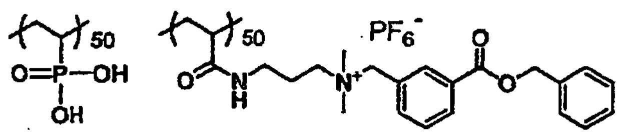 Mw:21,000

(P-23) 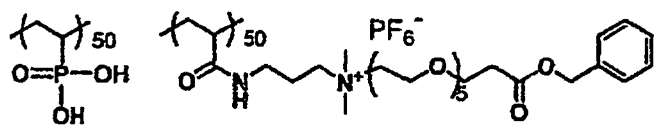 Mw:13,000

(P-24) 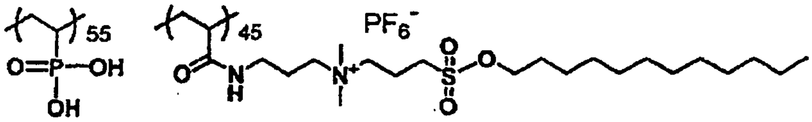 Mw:32,000

(P-25) 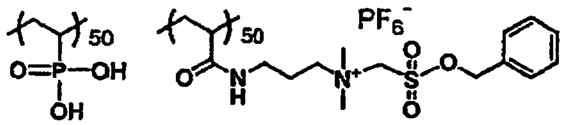 Mw:22,000

(P-26) 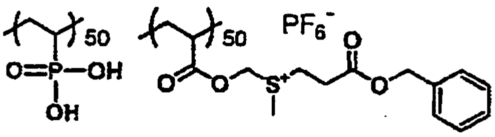 Mw:16,000

(P-27) 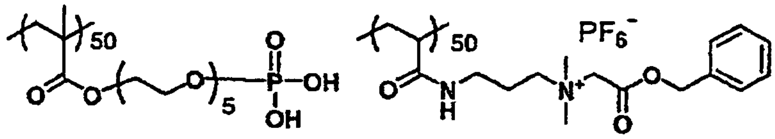 Mw:15,000

(P-28) 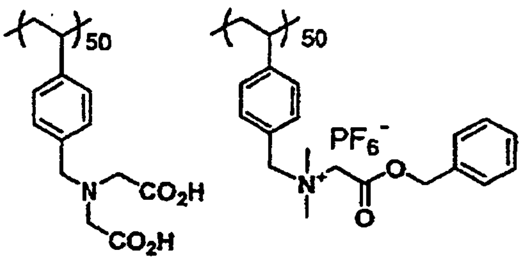 Mw:19,000

(P-29) 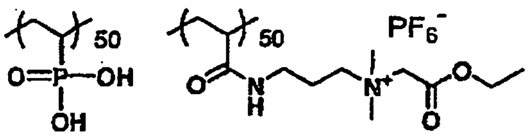 Mw:18,000

(P-30) 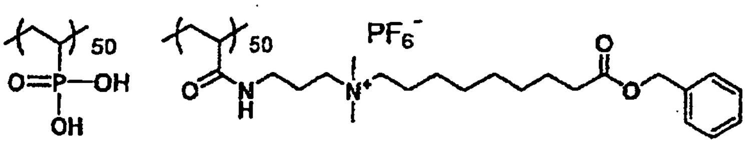 Mw:19,000

(P-31) 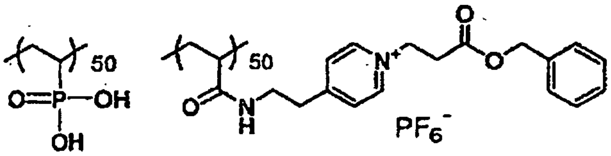 Mw:19,000

(P-32) 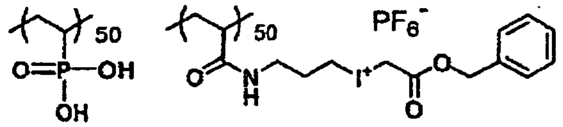 Mw:21,000

(P-33) 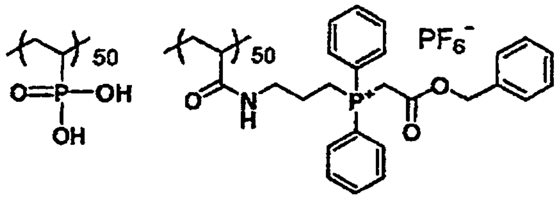 Mw:22,000

(P-34) 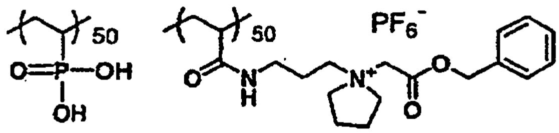 Mw:24,000

(P-35) 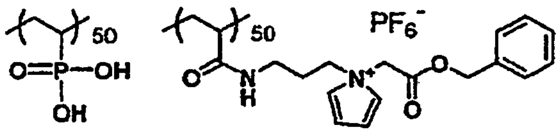 Mw:26,000

(P-36) 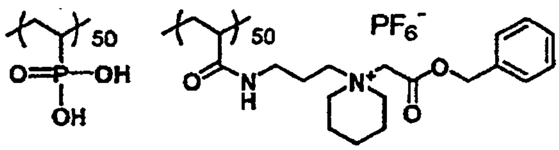 Mw:17,000

(P-37) 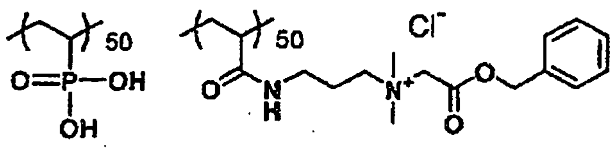 Mw:20,000

(P-38) 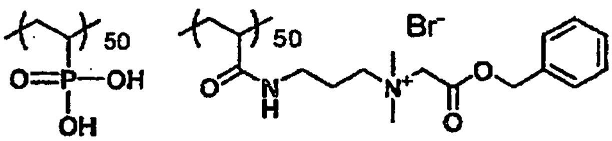 Mw:21,000

(P-39) 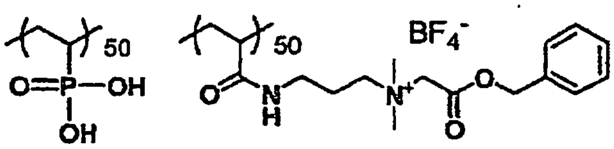 Mw:19,000

(P-40) 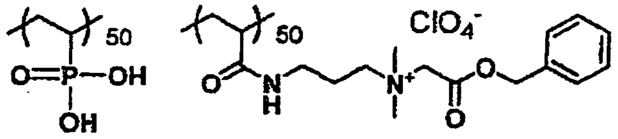 Mw:20,000

(P-41) 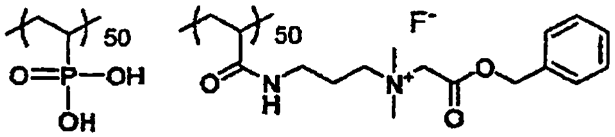 Mw:18,000

(P-42) 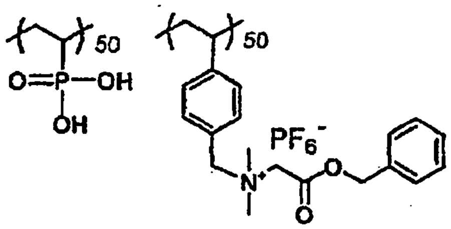 Mw:17,000

(P-43) 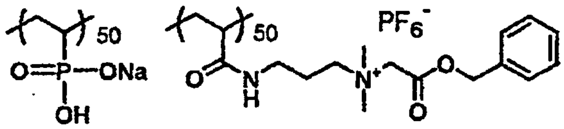 Mw:24,000

(P-44) 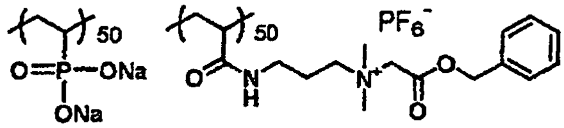 Mw:24,000

(P-45) 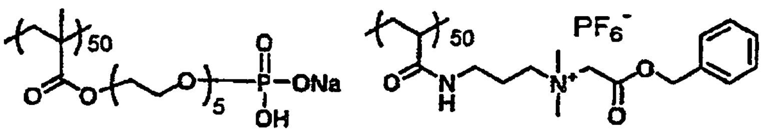 Mw:21,000

(P-46) 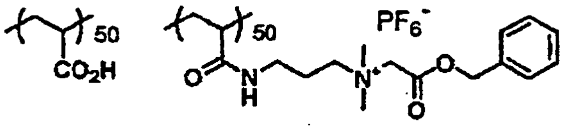 Mw:24,000

(P-47) 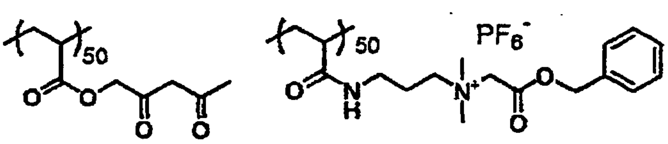 Mw:18,000

(P-48) 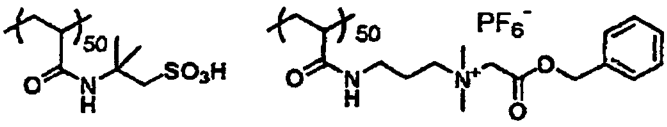 Mw:19,000

(P-49) 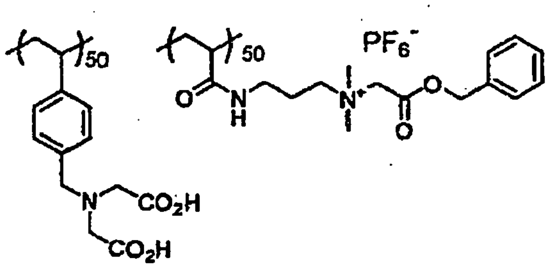 Mw:18,000

(P-50) 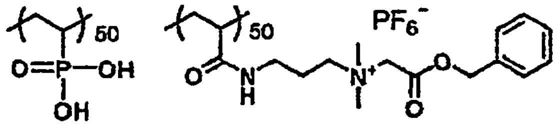 Mw:80,000

(P-51) 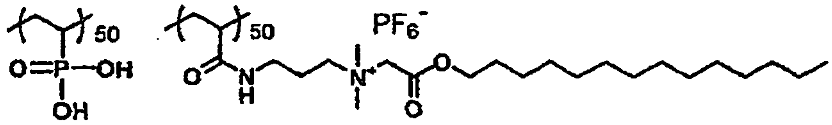 Mw:81,000

(P-52) 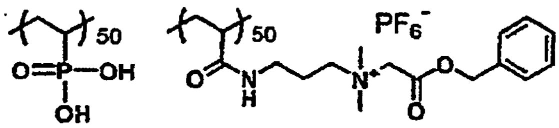 Mw:200,000

(P-53) 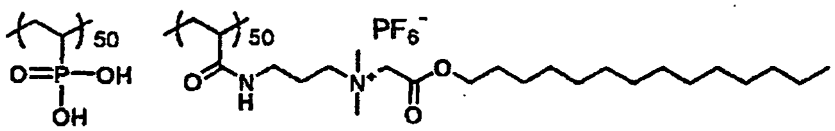 Mw:220,000

(P-54) 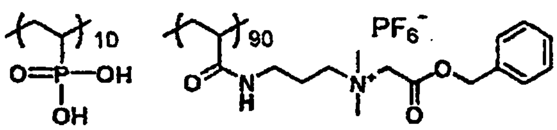 Mw:20,000

The specific polymer compound according to the invention is incorporated into the image-recording layer adjacent to the support or an undercoat layer provided between the support and the image-recording layer. The incorporation of the specific polymer compound into the image-recording layer or undercoat layer can be conducted by adding the specific polymer compound to a coating solution for image-recording layer or a coating solution for undercoat layer. The specific polymer compound is used by adding to the coating solution for image-recording layer or coating solution for undercoat layer so as to have a coating amount (solid content) preferably from 0.1 to 100 mg/$m^2$, and more preferably from 1 to 30 mg/$m^2$

[Image-recording layer]

(B) Polymerization initiator

The image-recording layer according to the invention includes a polymerization initiator (hereinafter, also referred to as an initiator compound). In the invention, a radical polymerization initiator is preferably used.

As the initiator compound, initiator compounds known to those skilled in the art can be used without limitation. Specifically, the initiator compound includes, for example, a trihalomethyl compound, a carbonyl compound, an organic peroxide, an azo compound, an azide compound, a metallocene compound, a hexaarylbiimidazole compound, an organic boron compound, a disulfone compound, an oxime ester compound, an onium salt and a iron arene complex. Among them, at least one compound selected from the hexaarylbiimidazole; compound, onium salt, trihalomethyl compound and metallocene compound is preferred, and the hexaarylbiimidazole compound and the onium salt are particularly preferred. Two or more kinds of the polymerization initiator may be appropriately used in combination.

The hexaarylbiimidazole compound includes, for example, lophine dimers described in European Patent 24629 and European Patent 107792 and U. S. Patent 4,410,621, specifically, 2,2'-bis(o-chlorophenyl)-4,4',5,5'-tetraphenylbiimidazole, 2,2'-bis(o-bromophenyl)-4,4',5,5'-tetraphenylbiimidazole, 2,2'-bis(o,p-dichlorophenyl)-4,4',5,5'-tetraphenylbüumidazole, 2,2'-bis(o-chlorophenyl)-4,4',5,5'-tetra(m-methoxyphenyl)biimidazole, 2,2'-bis(o,o'-dichlorophenyl)-4,4',5,5'-tetraphenylbiimidazole, 2,2'-bis(o-nitrophenyl)-4,4',5,5'-tetraphenylbiimidazole, 2,2'-bis(o-methylphenyl)-4,4',5,5'-tetraphenylbiimidazole and 2,2'-bis(o-trifluoromethylphenyl)-4,4',5,5'-tetraphenylbiimidazole.

The hexaarylbiimidazale compound is particularly preferably used together with the sensitizing dye having an absorption maximum in a wavelength range from 300 to 450 nm described above.

As the onium salts, for example, diazonium salts described in S. I. Schlesinger, Photogr. Sci. Eng, 18, 387 (1974) and T. S. Bal et al., Polymer, 21, 423 (1980) and JP-A-5-158230, ammonium salts described in U.S. Patent 4,069,055 and JP-A-4-365049, phosphonium salts described in U.S. Patents 4,069,055 and 4,069,056, iodonium salts described in European Patent 104,143, U. S. Patent Publication No. 2008/0311520, JP-A-2-150848, JP-A-2008-195018 and J.V. Crivello et al., Macromolecules, 10 (6), 1307 (1977), sulfonium salts described in European Patents 370,693, 233,567, 297,443 and 297,442, U.S. Patents 4,933,377, 4,760,013, 4,734,444 and 2,833,827, German Patents 2,904,626, 3,604,580 and 3,604,581, selenonium salts described in J.V. Crivello et al., J. Polymer Sci., Polymer Chem. Ed., 17,1047 (1979), arsonium salts described in C.S. Wen et al., Teh. Proc. Conf. Rad. Curing ASIA, p. 478, Tokyo, Oct. (1988), and azinium salts described in JP-A-2008-195018 are exemplified.

Of the onium salts, the iodonium salts, sulfonium salts and azinium salts are more preferred. Specific examples of these compounds are set forth below, but the invention should not be construed as being limited thereto.

Of the iodonium salts, a diphenyliodonium salt is preferred. In particular, a diphenyliodonium salt substituted with an electron donating group, for example, an alkyl group or an alkoxy group is preferred, and an asymmetric diphenyliodonium salt is more preferred. Specific examples of the iodonium salt include diphenyliodonium hexafluorophosphate, 4-methoxyphenyl-4-(2-methylpropyl)phenyliodonium hexafluorophosphate, 4-(2-methylpropyl)phenyl-p-tolyliodonium hexafluorophosphate, 4-hexyloxyphenyl-2,4,6-trimethoxyphenyliodonium hexafluorophosphate, 4-hexyloxyphenyl-2,4-diethoxyphenyliodonium tetrafluoroborate, 4-octyloxyphenyl-2,4,6-trimethaxyphenyliodonium 1-perfluorobutazresulfonate, 4-actyloxyphenyl-2,4,6-trimethoxyphenyliodonium hexafluorophosphate and bis(4-tert-butylphenyl)iodonium tetraphenylborate.

Examples of the sulfonium salt include triphenylsulfonium hexafluorophosphate, triphenylsulfonium benzoylformate, bis(4-chlorophenyl)phenylsulfonium benzoylformate, bis(4-chlorophenyl)-4-methylphenylsulfonium tetrafluoroborate, tris(4-chlorophenyl)sulfonium 3,5-bis(methoxycarbonyl)benzenesulfonate and tris(4-chlorophenyl)sulfonium hexafluorophosphate.

Examples of the azinium salt include 1-cyclohexylmethyloxypyridinium hexafluorophosphate, 1-cydohexyloxy-4-phenylpyridinium hexafluorophosphate, 1-ethoxy-4-phenylpyridinium hexafluorophosphate, 1-(2-ethylhexyloxy)-4-phenylpyridinium hexafluorophosphate, 4-chloro-1-cyclohexylmethyloxypyridinium hexafluorophosphate, 1-ethoxy-4-cyanopyridinium hexafluorophosphate, 3,4-dichloro-1-(2-ethylhexyloxy)pyridinium hexafluorophosphate, 1-benzyloxy-4-phenylpyridinium hexafluorophosphate, 1-phenethyloxy-4-phenylpyridinium hexafluorophosphate, 1-(2-ethylhexyloxy)-4-phenylpyridinium p-toluenesulfonate, 1-(2-ethylhexyloxy)-4-phenylpyridinium perfluorobutanesulfonate, 1-(2-ethylhexyloxy)-4-phenylpyridinium bromide and 1-(2-ethylhexyloxy)-4-phenylpyridinium tetrafluoroborate.

The onium salt is particularly preferably used together with an infrared absorbing agent having an absorption maximum in a wavelength range from 750 to 1,400 nm.

In addition, polymerization initiators described in Paragraph Nos. [0071] to [0129] of JP-A-2007-206217 are preferably used.

The polymerization initiators are preferably used individually or in combination of two or more thereof.

The content of the polymerization initiator used in the image-recording layer is preferably from 0.01 to 20% by weight, more preferably from 0.1 to 15% by weight, still more preferably from 1.0 to 10% by weight, based on the total

solid content of the image-recording layer.

(C) Polymerizable compound

The polymerizable compound for use in the image-recording layer is an addition-polymerizable compound having at least one ethylenically unsaturated double bond and it is selected from compounds having at least one, preferably two or more, terminal ethylenically unsaturated double bonds. The polymerizable compound has a chemical form, for example, a monomer, a prepolymer, specifically, a dimer, a trimer or an oligomer, or a mixture thereof. Examples of the monomer include unsaturated carboxylic acids (for example, acrylic acid, methacrylic acid, itaconic acid, crotonic acid, isocrotonic acid or maleic acid) and esters or amide thereof Preferably, esters of an unsaturated carboxylic acid with a polyhydric alcohol compound and amides of an unsaturated carboxylic acid with a polyvalent amine compound are used. An addition reaction product of an unsaturated carboxylic acid ester or amide having a nucleophilic substituent, for example, a hydroxy group, an amino group or a mercapto group, with a monofunctional or polyfunctional isocyanate or epoxy compound, or a dehydration condensation reaction product of the unsaturated carboxylic acid ester or amide with a monofunctional or polyfunctional carboxylic acid is also preferably used. Moreover, an addition reaction product of an unsaturated carboxylic acid ester or amide having an electrophilic substituent, for example, an isocyanate group or an epoxy group, with a monofunctional or polyfunctional alcohol, amine or thiol, or a substitution reaction product of an unsaturated carboxylic acid ester or amide having a releasable substituent, for example, a halogen atom or a tosyloxy group with a monofunctional or polyfunctional alcohol, amine or thiol is also preferably used. In addition, compounds in which the unsaturated carboxylic acid described above is replaced by an unsaturated phosphonic acid, styrene, vinyl ether or the like can also be used. These are described, for examples, in JP-T-2006-508380 (the term "JP-T" as used herein means a published Japanese translation of a PCT patent application), JP-A-2002-287344, JP-A-2008-256850, JP-A-2001-342222, JP-A-9-179296, JP-A-9-179297, JP-A-9-179298, JP-A-2004-294935, JP-A-2006-243493, JP-A-2002-275129, JP-A-2003-64130, JP-A-2003-280187 and JP-A-10-333321.

Specific examples of the monomer, which is an ester of a polyhydric alcohol compound with an unsaturated carboxylic acid, include, as an acrylic acid ester, for example, ethylene glycol diacrylate, 1,3-butanediol diacrylate, tetramethylene glycol diacrylate, propylene glycol diacrylate, trimethylolpropane triacrylate, hexanediol diacrylate, tetraethylene glycol diacrylate, pentaerythritol tetraaerylate, sorbitol triacrylate, isocyanuric acid ethylene oxide (EO) modified triacrylate and polyester acrylate oligomer. As a methacrylic acid ester, for example, tetramethylene glycol dimethacrylate, neopentyl glycol dimethacrylate, trimethylolpropane trimethacrylate, ethylene glycol dimethacrylate, pentaerythritol trimethacrylate, bis[p-(3-methacryloxy-2-hydroxypropoxy)phenyl]dimethylmethane and bis[p-(methacryloxyethoxy)phenyl]dimethylmcthane are exemplified. Specific examples of the monomer, which is an amide of a polyvalent amine compound with an unsaturated carboxylic acid, include methylene bisacrylamide, methylene bismethacrylamide, 1,6-hexamethylene bisacrylamide, 1,6-hexamethylene bismethacrylamide, diethylenetriamine trisacrylamide, xylylene bisacrylamide and xylylene bismethacrylamide.

Urethane type addition-polymerizable compounds produced using an addition reaction between an isocyanate and a hydroxy group are also preferably used and specific examples thereof include vinylurethane compounds having two or more Polymerizable vinyl groups per molecule obtained by adding a vinyl monomer containing a hydroxy group represented by formula (A) shown below to a polyisocyanate compound having two or more isocyanate groups per molecule, described in JP-B-48-41708.

$$CH2=C(R_4)COOCH_2CH(R_5)OH \qquad (A)$$

wherein $R_4$ and $R_5$ each independently represents H or $CH_3$.

Also, urethane acrylates described in JP-A-51-37193, JP-B-2-32293, JP-B-2-16765, JP-A-2003-344997 and JP-A-2006-65210, urethane compounds having an ethylene oxide skeleton described in JP-B-58-49860, JP-B-56-17654, JP-B-62-39417, JP-B-62-39418, JP-A-2000-250211 and JP-A-2007-94138, and urethane compounds having a hydrophilic group described in U.S. Patent 7,153,632, JP-T-8-505958, JP-A-2007-293221 and JP-A-2007-293223 are preferably used.

Of the compounds described above, in case of the lithographic printing plate precursor to which on-press development is applied, an isocyanuric acid ethyleneoxide-modined acrylate, for example, tris(acryloyloxyethyl) isocyanurate or bis(acryloyloxyethyl) hydroxyethyl isocyanurate is particularly preferred from the standpoint of excellent balance between hydrophilicity relating to the on-press development property and polymerization ability relating to the printing durability.

Details of the method of using the polymerizable compound, for example, selection of the structure, individual or combination use or an amount added, can be appropriately determined in accordance with the characteristic design of the final lithographic printing plate precursor. The polymerizable compound is used preferably in a range from 5 to 75% by weight, more preferably in a range from 25 to 70% by weight, particularly preferably in a range from 30 to 60%

by weight, based on the total solid content of the image-recording layer.

(D) Sensitizing dye

The sensitizing dye for use in the image-recording layer is not particularly restricted as far as it absorbs light at the image exposure to form the excited state and provides energy to the polymerization initiator described above with electron transfer, energy transfer or heat generation thereby improving the polymerization initiation function. Particularly, a Sensitizing dye having an absorption maximum in a wavelength range from 300 to 450 nm or from 750 to 1,400 nm is preferably used.

Examples of the sensitizing dye having an absorption maximum in a wavelength range from 300 to 450 nm include merocyanines, benzopyranes, coumarins, aromatic ketones, anthracenes, styryls and oxazoles.

Of the sensitizing dyes having an absorption maximum in a wavelength range from 300 to 450 nm, a dye represented by formula (IX) shown below is more preferred in view of high sensitivity.

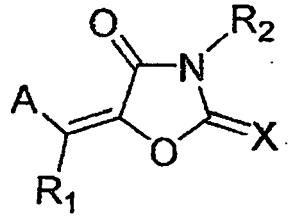

(IX)

In formula (IX), A represents an aryl group which may have a substituent or a heteroaryl group which may have a substituent, X represents an oxygen atom, a sulfur atom or =N($R_3$), and $R_1$, $R_2$ and $R_3$ each independently represents a monovalent non-metallic atomic group, or A and $R_1$ or $R_2$ and $R_3$ may be combined with each other to form an aliphatic or aromatic ring.

The formula (IX) will be described in more detail below. The monovalent noun-metallic atomic group represented by $R_1$, $R_2$ or $R_3$ is preferably a hydrogen atom, a substituted or unsubstituted alkyl group, a substituted or unsubstituted alkenyl group, a substituted or unsubstituted aryl group, a substituted or unsubstituted heteroaryl group, a substituted or unsubstituted alkoxy group, a substituted or unsubstituted alkylthio group, a hydroxy group or a halogen atom.

The aryl group which may have a substituent and heteroaryl group which may have a substituent represented by A are same as the substituted or unsubstituted aryl group and substituted or unsubstituted heteroaryl group described for any one of $R_1$, $R_2$ and $R_3$, respectively.

Specific examples of the sensitizing dye preferably used include compounds described in Paragraph Nos. [0047] to [0053] of JP-A-2007-58170, Paragraph Nos. [0036] to [0037] of JP-A-2007-93866 and Paragraph Nos. [0042] to [0047] of JP-A-2007-72816.

Further, sensitizing dyes described in JP-A-2006-189604, JP-A-2007-171406, JP-A-2007-206216, JP-A-2007-206217, JP-A-2007-225701, JP-A-2007-225702, JP-A-2007-31,65 82 and JP-A-2007-328243 are also preferably used.

Next, the sensitizing dye having an absorption maximum in a wavelength range from 750 to 1,400 (hereinafter, also referred to as an "infrared absorbing agent") is described below. The infrared absorbing agent used is preferably a dye or a pigment.

As the dye, commercially available dyes and known dyes described in literatures, for example, Senryo Binran (Dye Handbook) compiled by The Society of Synthetic Organic Chemistry, Japan (1970) can be used. Specifically, the dyes includes azo dyes, metal complex azo dyes, pyrazolone azo dyes, naphthoquinone dyes, anthraquinone dyes, phthalocyanine dyes, carbonium dyes, quinoneimine dyes, methine dyes, cyanine dyes, squarylium dyes, pyrylium salts and metal thiolate complexes.

Of the dyes, cyanine dyes, squarylium dyes, pyrylium dyes, nickel thiolate complexes and indolenine cyanine dyes are particularly preferred. Further, cyanine dyes and indolenine cyanine dyes are preferred. As particularly preferable examples of the dye, cyanine dyes represented by formula (a) shown below are exemplified.
Formula (a):

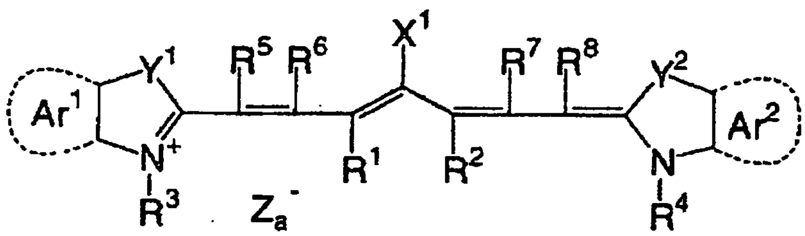

In formula (a), $X^1$ represents a hydrogen atom, a halogen atom, $-NPh_2$, $-X^2-L^1$ or a group shown below. $X^2$ represents an oxygen atom, a nitrogen atom or a sulfur atom, $L^1$ represents a hydrocarbon group having item 1 to 12 carbon atoms, an aryl group containing a hetero atom (a nitrogen atom, a sulfur atom, an oxygen atom, a halogen atom or a selenium atom) or a hydrocarbon group having from 1 to 12 carbon atoms and containing a hetero atom. $Xa^-$ has the same meaning as $Za^-$ defined hereinafter. $R^a$ represents a hydrogen atom or a substituent selected from an alkyl group, an aryl group, a substituted or unsubstituted amino group and a halogen atom.

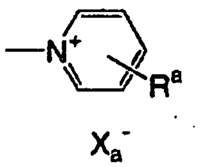

$R^1$ and $R^2$ each independently represents a hydrocarbon group having from 1 to 12 carbon atoms. In view of the preservation stability of a coating solution for image-forming layer, it is preferred that $R^1$ and $R^2$ each represent a hydrocarbon group having two or more carbon atoms. Also, $R^1$ and $R^2$ may be combined with each other to form a ring and in case of forming the ring, to form a 5-membered or 6-membered ring is particularly preferred.

$Ar^1$ and $Ar^2$, which may be the same or different, each represents an aryl group which may have a substituent. Preferable examples of the aryl group include a benzene ring group and a naphthalene ring group. Preferable examples of the substituent include a hydrocarbon group having 12 or less carbon atoms, a halogen atom and an alkoxy group having 12 or less carbon atoms. $Y^1$ and $Y^2$, which may be the same or different, each represents a sulfur atom or a dialkylmethylene group having 12 or less carbon atoms. $R^3$ and $R^4$, which may be the same or different, each represents a hydrocarbon group having 20 or less carbon atoms, which may have a substituent. Preferable examples of the substituent include an alkoxy group having 12 or less carbon atoms, a carboxyl group and a sulfo group. $R^5$, $R^6$, $R^7$ and $R^8$, which may be the same or different, each represents a hydrogen atom or a hydrocarbon group having 12 or less carbon atoms. From the standpoint of the availability of raw materials, a hydrogen atom is preferred. $Za^-$ represents a counter anion. However, $Za^-$ is not necessary when the cyanine dye represented by formula (a) has an anionic substituent in the structure thereof and the neutralization of charge is not needed. Preferable examples of the counter ion for $Za^-$ include a halide ion, a perchlorate ion, a tetrafluoroborate ion, a hexafluorophosphate ion and a sulfonate ion, and particularly preferable examples thereof include a perchlorate ion, a hexafluorophosphate ion and an arylsulfonate ion in view of the preservation stability of a coating solution for image-recording layer.

Specific examples of the cyanine dye represented by formula (a) include compounds described in Paragraph Nos. [0017] to [0019] of JP-A-2001-133969, Paragraph Nos. [0016] to [0021] of JP-A-2002-23360 and Paragraph Nos. [0012] to [0037] of JP-A-200240638, preferably compounds described in Paragraph Nos. [0034] to [0041] of JP-A-2002-278057 and Paragraph Nos. [0080] to [0086] of JP-A-2008-195018, and particularly preferably compounds described in Paragraph Nos. [0035] to [0043] of JP-A-2007-90850.

Also, compounds described in Paragraph Nos. [0008] to [0009] of JP-A-5-5005 and Paragraph Nos. [0022] to [0025] of JP-A-2001-222101 are preferably used.

The infrared absorbing dyes may be used individually or in combination of two or more thereof and may be used together with an infrared absorbing agent other than the infrared absorbing dye, for example, a pigment. As the pigment, compounds described in Paragraph Nos. [0072] to [0076] of JP-A-2008-195018 are preferred.

The content of the sensitizing dye is preferably from 0.05 to 30 parts by weight, more preferably from 0.1 to 20 parts by weight, particularly preferably from 0.2 to 10 parts by weight, per 100 parts by weight of the total solid content of the image-recording layer.

(E) Binder polymer

As the binder polymer contained in the image-recording layer according to the invention, a polymer capable of holding the components of image-recording layer on the support and capable of being removed with a developer is used. The binder polymer used includes a (meth)acrylic polymer, a polyurethane resin, a polyvinyl alcohol resin, a polyvinyl butyral resin, a polyvinyl formal resin, a polyamide resin, a polyester resin and an epoxy resin. Particularly, a (meth)acrylic polymer, a polyurethane resin or a polyvinyl butyral resin is preferably used, and a (meth)acrylic polymer or a polyurethane resin is more preferably used.

The term "(meth)acrylic polymer" as used herein means a copolymer containing as a polymerization component, (meth)acrylic acid or a (meth)acrylic acid derivative, for example, a (meth)acrylate (including, for example, an alkyl ester, aryl ester and allyl ester), (meth)acrylamide or a (meth)acrylamide derivative. The term "polyurethane resin." as used herein means a polymer formed by a condensation reaction of a compound having two or more isocyanate groups and a compound having two or more hydroxy groups.

The term "polyvinyl butyral resin" as used herein means a polymer synthesized by a reaction (acetalization reaction) of polyvinyl alcohol obtained by partial or full saponification of polyvinyl acetate with butylaldehyde under an acidic condition and includes a polymer wherein an acid group or the like is introduced by a method of reacting the remaining hydroxy group with a compound having the acid group or the like.

One preferable example of the (meth)acrylic polymer according to the invention is a copolymer containing a repeating unit having an acid group. Examples of the acid group include a carboxylic acid group, a sulfonic acid group, a phosphonic acid group, a phosphoric acid group and a sulfonamido group. Particularly, a carboxylic acid group is preferred. As the repeating unit having an acid group, a repeating unit derived from (meth)acrylic acid or a repeating unit represented by formula (I) shown below is preferably used.

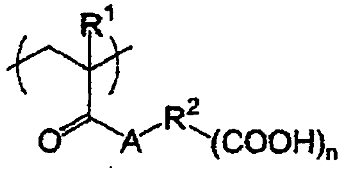
(I)

In formula (I), $R^1$ represents a hydrogen atom or a methyl group, $R^2$ represents a single bond or an (n+1) valent connecting group, A represents an oxygen atom or $-NR^3-$, wherein $R^3$ represents a hydrogen atom or a monovalent hydrocarbon group having from 1 to 10 carbon atoms, and n represents an integer from 1 to 5.

The connecting group represented by $R^2$ in formula (I) is constructed from a hydrogen atom, a carbon atom, an oxygen atom, a nitrogen atom, a sulfur atom and a halogen atom and preferably contains from 1 to 80 atoms. Specific examples of the connecting group include an alkylene group, a substituted alkylene group, an arylene group and a substituted arylene group. The connecting group may have a structure wherein a plurality of such divalent groups is connected to each other via any of an amido bond, an ether bond, a urethane bond, a urea bond and an ester bond. $R^2$ is preferably a single bond, an alkylene group, a substituted alkylene group or a structure wherein a plurality of an alkylene group and/or a substituted alkylene group is connected to each other via any of an amid bond, an ether bond, a urethane bond, a urea bond and an ester bond, particularly preferably a single bond, an alkylene group having from 1 to 5 carbon atoms, a substituted alkylene group having from 1 to 5 carbon atoms or a structure wherein a plurality of an alkylene group having from 1 to 5 carbon atoms and/or a substituted alkylene group having from 1 to 5 carbon atoms is connected to each other via any of an amido bond, an ether bond, a urethane bond, a urea bond and an ester bond, and most preferably a single bond, an alkylene group having from 1 to 3 carbon atoms, a substituted alkylene group having from 1 to 3 carbon atoms or a structure wherein a plurality of an alkylene group having from 1 to 3 carbon atoms and/or a substituted alkylene group having from 1 to 3 carbon atoms is connected to each other via any of an amido bond, an ether bond, a urethane bond, a urea bond and an ester bond.

Examples of the substituent include a monovalent non-metallic atomic group exclusive of a hydrogen atom, for example, a halogen atom (e.g., -F, -Br, -Cl or -I), a hydroxy group, a cyano group, an alkoxy group, an aryloxy group, a mercapto group, an alkylthio group, an arylthio group, an alkylcarbonyl group, an arylcarbonyl group, a carboxyl group and a conjugate base group thereof, an alkoxycarbonyl group, an aryloxycarbonyl group, a carbamoyl group, an aryl group, an alkenyl group and an alkenyl group.

$R^3$ is preferably a hydrogen atom or a hydrocarbon group having from 1 to 5 carbon atoms, more preferably a hydrogen atom or a hydrocarbon group having from 1 to 3 carbon atoms, and particularly preferably a hydrogen atom or a methyl group. n is preferably from 1 to 3, more preferably 1 or 2, and particularly preferably 1.

A ratio (% by mole) of the polymerization component having a carboxylic acid group in the total polymerization components of the (meth)acrylic polymer is preferably from 1 to 70% in view of developing property. Considering good

compatibility between the developing property and printing durability, it is more preferably from 1 to 50%, and particularly preferably from 1 to 30%.

It is preferred that the (meth)acrylic polymer for use in the invention further contain a crosslinkable group. The term "crosslinkable group" as used herein means a group capable of crosslinking the binder polymer in the process of a radical polymerization reaction which is caused in the image-recording layer, when the lithographic printing plate precursor is exposed to light. The crosslinkable group is not particularly restricted as long as it has such a function and includes, for example, an ethylenically unsaturated bond group, an amino group and an epoxy group as a functional group capable of undergoing an addition polymerization reaction. Also, a functional group capable of forming a radical upon irradiation with light may be used and such a crosslinkable group includes, for example, a thiol group and a halogen atom. Among them, the ethylenically unsaturated bond group is preferred. The ethylenically unsaturated bond group preferably includes a styryl group, a (meth)acryloyl group and an allyl group.

In the binder polymer, for example, a free radical (a polymerization initiating radical or a propagating radical in the process of polymerization of the polymerizable compound) is added to the crosslinkable functional group to cause addition polymerization between the polymers directly or through a polymerization chain of the polymerizable compound and as a result, crosslinking is formed between the polymer molecules to effect curing. Alternatively, an atom (for example, a hydrogen atom on the carbon atom adjacent to the functional crosslinkable group) in the polymer is withdrawn by a free radical to produce a polymer radical and the polymer radicals combine with each other to form crosslinking between the polymer molecules to effect curing.

The content of the crosslinkable group (content of radical-polymerizable unsaturated double bond determined by iodine titration) in the (meth)acrylic polymer is preferably from 0.01 to 10.0 mmol, more preferably from 0.05 to 9.0 mmol, particularly preferably from 0.1 to 8.0 mmol, per g of the binder polymer.

The (meth)acrylic polymer for use in the invention may contain a polymerization unit of alkyl (meth)acrylate or aralkyl (meth)acrylate, a polymerization unit of (meth)acrylamide or a derivative thereof, a polymerization unit of $\alpha$-hydroxymethyl acrylate or a polymerization unit of a styrene derivative, in addition to the polymerization unit having an acid group and the polymerization unit having a crosslinkable group described above. The alkyl group in the alkyl (meth)acrylate is preferably an alkyl group having from 1 to 5 carbon atoms or an alkyl group having from 2 to 8 carbon atoms and the substituent described above, and more preferably a methyl group. The aralkyl (meth)acrylate includes, for example, benzyl (meth)acrylate. The (meth)acrylamide derivative includes, for example, N-isopropylacrylamide, N-phenylmethacrylamide, N-(4-methoxycarbonylphenyl)methacrylamide, N,N-dimethylacrylamide and morpholinoacrylamide. The $\alpha$-hydroxymethyl acrylate includes, for example, ethyl $\alpha$ -hydroxymethyl acrylate and cyclohexyl $\alpha$-hydroxymethyl acrylate. The styrene derivative includes, for example, styrene and 4-tret-butylstyrene.

Further, in case of the lithographic printing plate precursor to which on-press development is applied, the binder polymer preferably has a hydrophilic group. The hydrophilic group contributes to impart the on-press development property to the image-recording layer. In particular, coexistence of the crosslinkable group and the hydrophilic group makes it possible to achieve a good balance between the printing durability and the on-press development property.

The hydrophilic group includes, for example, a hydroxy group, a carboxyl group, an alkyleneoxide structure, an amino group, an ammonium group, an amido group, a sulfo group and a phosphoric acid group. In particular, an alkyleneoxide structure having from 1 to 9 alkyleneoxide units having 2 or 3 carbon atoms is preferred. In order to impart a hydrophilic group to the binder polymer, for example, copolymerization of a monomer having the hydrophilic group may be conducted.

Preferable examples of the polyurethane resin for use in the invention include polyurethane resins described in Paragraph Nos. [0099] to [0210] of JP-A-2007-18783 6, Paragraph Nos. [0019] to [0100] of JP-A-2008 -276155, Paragraph Nos. [0018] to [0107] of JP-A-2005-250438 and Paragraph Nos. [0021] to [0083] of JP-A-2005-250158.

Preferable examples of the polyvinyl butyral resin for use in the invention include polyvinyl butyral resins described in Paragraph Nos. [0006] to [0013] ofJP-A-2001-75279.

A part of the acid groups in the binder polymer may be neutralized with a basic compound. Examples of the basic compound include a compound containing a basic nitrogen atom, an alkali metal hydroxide and a quaternary ammonium salt of an alkali metal.

The binder polymer preferably has a weight average molecular weight of 5,000 or more, more preferably from 10,000 to 300,000, and a number average molecular weight of 1,000 or more, more preferably from 2,000 to 250,000. The polydispersity (weight average molecular weight/number average molecular weight) is preferably from 1.1 to 10.

The binder polymers may be used individually or in combination of two or more thereof.

The content of the binder polymer is preferably from 5 to 75% by weight, more preferably from 10 to 70% by weight, still more preferably from 10 to 60% by weight, based on the total solid content of the image-forming layer from the standpoint of good strength of the image area and good image- forming property.

The total content of the polymerizable compound and the binder polymer is preferably 90% by weight or less based on the total solid content of the image-forming layer. When it exceeds 90% by weight, decrease in the sensitivity and deterioration in the developing property may be caused sometimes. The total content thereof is more preferably

from 35 to 80% by weight.

(F) Hydrophilic low molecular weight compound

The image-recording layer according to the invention may contain a hydrophilic low molecular weight compound in order to improve the on-press development property without accompanying the decrease in the printing durability.

The hydrophilic low molecular weight compound includes a water-soluble organic compound, for example, a glycol compound, e.g., ethylene glycol, diethylene glycol, triethylene glycol, propylene glycol, dipropylene glycol or tripropylene glycol, or an ether or ester derivative thereof, a polyol compound, e.g., glycerine, pentaerythritol or tris(2-hydroxyethyl) isocyanurate, an organic amine compound, e.g., triethanol amine, diethanol amine or monoethanol amine, or a salt thereof, an organic sulfonic acid compound, e.g., an alkyl sulfonic acid, toluene sulfonic acid or benzene sulfonic acid, or a salt thereof, an organic sulfamic acid compound, e.g., an alkyl sulfamic acid, or a salt thereof, an organic sulfuric acid compound, e.g., an alkyl sulfuric acid or an alkyl ether sulfuric acid, or a salt thereof, an organic phosphoric acid compound, e.g., phenyl phosphonic acid, or a salt thereof, an organic carboxylic acid, e.g., tartaric acid, oxalic acid, citric acid, malic acid, lactic acid, gluconic acid or an amino acid, or a salt thereof and a betaine compound.

According to the invention, it is preferred to incorporate at least one compound selected from a polyol compound, an organic sulfate compound, an organic sulfonate compound and a betaine compound.

Specific examples of the organic sulfonate compound include an alkylsulfonate, for example, sodium n-butylsulfonate, sodium n-hexylsulfonate, sodium 2-ethylhexylsulfonate, sodium cyclohexylsulfonate or sodium n-octylsulfonate, an alkylsulfonate containing an ethylene oxide chain, for example, sodium 5,8,11-trioxapentadecane-1-sulfonate, sodium 5,8,11-trioxaheptadecane-1-sulfonate, sodium 13-ethyl-5,8,11-trioxaheptadecane-1-sulfonate or sodium 5,8,11,14-tetraoxatetracosane-1-sulfonate, an arylsulfonate, for example, sodium benzenesulfonate, sodium p-toluenesulfonate, sodium p-hydroxybenzenesulfonate, sodium p-styrenesulfonate, sodium isophthalic acid dimethyl-5-sulfonate, sodium 1-naphtylsulfonate, sodium 4-hydroxynaphtylsulfonate, disodium 1,5-naphtyldisulfonate or Trisodium 1,3,6-naphtyltrisulfonate, and compounds described in Paragraph Nos. [0026] to [0031] of JP-A-2007-276454 and Paragraph Nos. [0020] to [0047] of JP-A-2009-154525. The salt may also be a potassium salt or a lithium salt.

The organic sulfate compound includes a sulfate of alkyl, alkenyl, alkynyl, aryl or heterocyclic monoether of polyethylene oxide. The number of unit of ethylene oxide is preferably from 1 to 4. The salt is preferably a sodium salt, a potassium salt or a lithium salt. Specific examples thereof include compounds described in Paragraph Nos. [0034] to [0038] of JP-A-2007-276454.

As the betaine compound, a compound wherein a number of carbon atoms included in a hydrocarbon substituent on the nitrogen atom is from 1 to 5 is preferred. Specific examples thereof include trimemylammonium acetate, dimethylpropylammonium acetate, 3-hydroxy-4-trimethylammoniobutyrate, 4-(1-pyridinio)butyrate, 1-hydroxyethyl-1-imidazolioacetate, trimethylammonium methanesulfonate, dimethylpropylammonium methanesulfonate, 3-trimethylammonio-1-porpanesulfonate and 3-(1-pyridinio)-1-porpanesulfonate.

Since the hydrophilic low molecular weight compound has a small structure of hydrophobic portion and almost no surface active function, degradations of the hydrophobicity and film strength in the image area due to penetration of dampening water into the exposed area (image area) of the image-recording layer are prevented and thus, the ink receptive-property and printing durability of the image-recording layer can be preferably maintained.

The content of the hydrophilic low molecular weight compound in the image-recording layer is preferably from 0.5 to 20% by weight, more preferably from 1 to 15% by weight, still more preferably from 2 to 10% by weight, based on the total solid content of the image-recording layer. In the range described above, good on-press development property and printing durability are achieved. The hydrophilic low molecular weight compounds may be used individually or as a mixture of two or more thereof.

(G) Oil -sensitizing agent

In order to improve the ink-receptive property, an oil-sensitizing agent, for example, a phosphonium compound, a nitrogen-containing low molecular weight compound or an ammonium group-containing polymer can be incorporated into the image-recording layer. In particular, in the case where an inorganic stratiform compound is incorporated into a protective layer described hereinafter, the oil-sensitizing agent functions as a surface covering agent of the inorganic stratiform compound and prevents deterioration of the ink-receptive property due to the inorganic stratiform compound during printing.

As preferable examples of the phosphonium compound, phosphonium compounds described in JP-A-2006-297907 and JP-A-2007-50660 are exemplified. Specific examples of the phosphonium compound include tetrabutylphosphonium iodide, butyltriphenylphosphonium bromide, tetraphenylphosphonium bromide, 1,4-bis(triphenylphosphonio)butane di(hexafluorophosphate), 1,7-bis(triphenylphosphonio)heptane sulfate and 1,9-bis(triphenylphosphonio)nonane naphthalene-2,7-disulfonate.

As the nitrogen-containing low molecular weight compound, an amine salt and a quaternary ammonium salt are exemplified. Also, an imidazolinium salt, a benzimidaxolimum salt, a pyridinium salt and a quinolinium salt are exemplified. Of the nitrogen-containing low molecular weight compounds, the quaternary ammonium salt and pyridinium salt are preferably used. Specific examples the nitrogen-containing low molecular weight compound include tetramethylammonium hexafluorophosphate, tetrabutylammonium hexafluorophosphate, dodecyltrimethylammonium p-toluenesulfonate, benzyltriethylammonium hexafluorophosphate, benzyidimethyloctylammonium hexafluorophosphate, benzyldimethyldodecylammonium hexafluorophosphate, and compounds described in Paragraph Nos. [0021] to [0037] of JP-A-2008-284858 and Paragraph Nos. [0030] to [0057] of JP-A-2009-90645.

The ammonium group-containing polymer may be any polymer containing an ammonium group in its structure and is preferably a polymer containing from 5 to 80% by mole of (meth)acrylate having an ammonium group in its side chain as a copolymerization component. Specific examples thereof include compounds described in Paragraph Nos. [0089] to [0105] of JP-A-2009-208458.

As to the ammonium group-containing polymer, its reduced specific viscosity value (unit: ml/g) determined according to the measuring method described below is preferably from 5 to 120, more preferably from 10 to 110, particularly preferably from 15 to 100. When the reduced specific viscosity value described above is calculated in terms of weight average molecular weight, from 10,000 to 150,000 is preferred, from 17,000 to 140,000 is more preferred, and 20,000 to 130,000 is particularly preferred.

<Measuring method of reduced specific viscosity>

In a 20 ml measuring flask is weighed 3.33 g of a 30% by weight polymer solution (1 g as a solid content) and the measuring flask is filled up to the gauge line with N-methyl pyrrolidone. The resulting solution is allowed to stand in a thermostatic bath of 30°C for 30 minutes and put into an Ubbelohde viscometer (viscometer constant: 0.010 cSt/s) and a period for running down of the solution is measured at 30°C. The measurement is conducted twice for the same sample and an average value of the measurement is determined. The measurement is also conducted for a blank (only N-methyl pyrrolidone) in the same manner. The reduced specific viscosity is calculated according to the formula shown below.

$$\frac{\dfrac{\text{Period for running down of sample solution (sec)} - \text{Period for running down of blank (sec)}}{\text{Period for running down of blank (sec)}}}{\dfrac{3.33\ (\text{g}) \times \dfrac{30}{100}}{20\ (\text{ml})}}$$

Specific examples of the ammonium group-containing polymer are set forth below.

(1) 2-(Trimethylammonio)ethyl methacrylate p-toluenesulfouate/3,6-dioxaheptyl methacrylate copolymer (molar ratio: 10/90, weight average molecular weight: 45,000)
(2) 2-(Trimethylammonio)ethyl methacrylate hexafluorophosphate /3,6-dioxaheptyl methacrylate copolymer (molar ratio: 20/80, weight average molecular weight: 60,000)
(3) 2-(Ethyldimethylammonio)ethyl methacrylate p-toluenesulfonate/hexyl methacrylate copolymer (molar ratio: 30/70, weight average molecular weight: 45,000)
(4) 2-(Trimethylammonio)ethyl methacrylate hexafluorophosphate /2-ethylhexyl methacrylate copolymer (molar ratio: 20/80, weight average molecular weight: 60,000)
(5) 2-(Trimethylammonio)ethyl methacrylate methylsulfate/hexyl methacrylate copolymer (molar ratio: 40/60, weight average molecular weight: 70,000)
(6) 2-(Butyldimethylammonio)ethyl methacrylate hexafluorophosphate/3,6-dioxaheptyl methacrylate copolymer (molar ratio: 25/75, weight average molecular weight: 65,000)
(7) 2-(Butyldimethylammonio)ethyl acrylate hexafluorophosphate/3,6-dioxaheptyl methacrylate copolymer (molar ratio: 20/80, weight average molecular weight: 65,000)
(8) 2-(Butyldimethylammonio)ethyl methacrylate 13-ethyl-5,8,1 1-trioxa-1-heptadecanesulfonate/3,6-dioxaheptyl

methacrylate copolymer (molar ratio: 20/80, weight average molecular weight: 75,000)
(9) 2-(Butyldimethylammomo)ethyl methacrylate hexafluorophosphate/3,6-dioxaheptyl methacrylate/2-hydroxy-3-methacryloyloxypropyl methacrylate copolymer (molar ratio: 15/80/5, weight average molecular weight: 65,000)

The content of the oil-sensitizing agent is preferably from 0.01 to 30.0% by weight, more preferably from 0.1 to 15.0% by weight, still more preferably from 1 to 5% by weight, based on the total solid content of the image-recording layer.

(H) Hydrophobilizing precursor

Into the image-recording layer, a hydrophobilizing precursor may be incorporated in order to improve the on-press development property. The hydrophobilizing precursor means a fine particle capable of converting the image-recording layer to be hydrophobic when heat is applied. The fine particle is preferably at least one fine particle selected from hydrophobic thermoplastic polymer fine particle, thermo-reactive polymer fine particle, polymer fine particle having a polymerizable group, microcapsule having a hydrophobic compound encapsulated and microgel (crosslinked polymer fine particle). Among them, the polymer fine particle having a polymerizable group and microgel are preferred.
As the hydrophobic thermoplastic polymer fine particle, hydrophobic thermoplastic polymer fine particles described, for example, in Research Disclosure, No. 33303, January (1992), JP-A-9-123387, JP-A-9-131850, JP-A-9-171249, JP-A-9-171250 and European Patent 931,647 are preferably exemplified.
Specific examples of the polymer constituting the hydrophobic thermoplastic polymer fine particle include a homopolymer or copolymer of a monomer, for example, ethylene, styrene, vinyl chloride, methyl acrylate, ethyl acrylate, methyl methacrylate, ethyl methacrylate, vinylidene chloride, acrylonitrile, vinyl carbazole or an acrylate or methacrylate having a polyalkylene structure and a mixture thereof. Among them, polystyrene, a copolymer containing styrene and acrylonitrile and polymethyl methacrylate are more preferred.
The average particle size of the hydrophobic thermoplastic polymer fine particle for use in the invention is preferably from 0.01 to 2.0 μm.
The thermo-reactive polymer fine particle for use in the invention includes a polymer fine particle having a thermo-reactive group and forms a hydrophobilized region by crosslinkage due to thermal reaction and change in the functional group involved therein.
As the thermo-reactive group of the polymer fine particle having a thermo-reactive group for use in the invention, a functional group performing any reaction can be used as long as a chemical bond is formed and a polymerizable group is preferred. For instance, an ethylenically unsaturated group (for example, an acryloyl group, a methacryloyl group, a vinyl group or an allyl group) performing a radical polymerization reaction, a cationic polymerizable group (for example, a vinyl group, a vinyloxy group, an epoxy group or oxetanyl group), an isocyanate group or a blocked form thereof an epoxy group or a vinyloxy group performing an addition reaction and a functional group having an active hydrogen atom (for example, an amino group, a hydroxy group or a carboxyl group) as the reaction partner thereof, a carboxyl group performing a condensation reaction and a hydroxyl group or an amino group as the reaction partner thereof, and an acid anhydride performing a ring opening addition reaction and an amino group or a hydroxyl group as the reaction partner thereof are preferably exemplified.
As the microcapsule for use in the invention, microcapsules having all or part of the constituting components of the image-recording layer encapsulated as described, for example, in JP-A-2001-277740 and JP-A-2001-277742 are exemplified. The constituting components of the image-recording layer may be present outside the microcapsules. It is a more preferred embodiment of the image-recording layer containing microcapsules that hydrophobic constituting components are encapsulated in microcapsules and hydrophilic components are present outside the microcapsules.
The microgel for use in the invention can contain a part of the constituting components of the image-recording layer at least one of in the inside and on the surface thereof. Particularly, an embodiment of a reactive microgel having a radical polymerizable group on the surface thereof is preferred in view of the image-forming sensitivity and printing durability.
In order to make microencapsulation or microgelation of the constituting components of the image-recording layer, known methods can be used.
The average particle size of the microcapsule or microgel is preferably from 0.01 to 3.0 μm, more preferably from 0.05 to 2.0 μm, particularly preferably from 0.10 to 1.0 μm. In the range described above, good resolution and good time-lapse stability can be achieved.
The content of the hydrophobilizing precursor is preferably from 5 to 90% by weight based on the total solid content of the image-recording layer.

(I) Other components for image-recording layer

The image-recording layer preferably contains a chain transfer agent. The chain transfer agent is defined, for example, in Kobunshi Jiten (Polymer Dictionary), Third Edition, pages 683 to 684, edited by The Society of Polymer Science, Japan (2005). As the chain transfer agent, for example, compounds having SH, PH, SiH or GeH in their molecules are used. The compound donates a hydrogen to a low active radical species to generate a radical or is oxidized and then deprotonized to generate a radical. In the image-recording layer according to the invention, a thiol compound (for example, a 2-mercaptobenzimidazole, a 2-mereaptobenzothiazole, a 2-mercaptobenzoxazole, a 3-mercaptotriazole or a 5-mercaptotetrazole) is preferably used.

The content of the chain transfer agent is preferably from 0.01 to 20 parts by weight, more preferably from 1 to 10 parts by weight, particularly preferably from 1 to 5 parts by weight, per 100 parts by weight of the total solid content of the image-recording layer.

Into the image-recording layer, various additives can be further incorporated, if desired. Examples of the additive include a surfactant for progressing the developing property and improving the surface state of coated layer, a hydrophilic polymer for improving the developing property and improving dispersion stability of microcapsule, a coloring agent or print-out agent for visually distinguishing the image area from the non-image area, a polymerization inhibitor for preventing undesirable thermal polymerization of the polymerizable compound during the production and preservation of the image-recording layer, a hydrophobic low molecular weight compound, for example, a higher fatty acid derivative for avoiding polymerization inhibition due to oxygen, an inorganic fine particle for increasing strength of the cured layer in the image area, a co-sensitizer for increasing sensitivity and a plasticizer for improving plasticity. As the additives, known compounds, for example, compounds described in Paragraph Nos. [0161] to [0215] of JP-A-2007-206217, Paragraph No. [0067] of JP-T-2005-509192 and Paragraph Nos. [0023] to [0026] and [0059] to [0066] of JP-A-2004-310000 are used. With respect to the surfactant, surfactants which may be added to the developer described hereinafter may be used.

<Formation of image-recording layer>

The image-recording layer according to the invention is formed by dispersing or dissolving each of the necessary components for image-recording layer described above in a solvent to prepare a coating solution and coating the solution. The solvent used include, for example, methyl ethyl ketone, ethylene glycol monomethyl ether, 1-methoxy-2-propanol, 2-methoxyethyl acetate, 1-methoxy-2-propyl acetate and γ-butyrolactone, but the invention should not be construed as being limited thereto. The solvents may be used individually or as a mixture. The solid content concentration of the coating solution is preferably from 1 to 50% by weight.

The coating amount (solid content) of the image-recording layer is preferably from 0.3 to 3.0 g/$m^2$. Various methods can be used for the coating. Examples of the method include bar coater coating, spin coating, spray coating, curtain coating, dip coating, air knife coating, blade coating and roll coating.

[Protective layer]

In the lithographic printing plate precursor according to the invention, a protective layer (oxygen-blocking layer) is preferably provided on the image-recording layer in order to prevent diffusion and penetration of oxygen which inhibits the polymerization reaction at the time of exposure. As a material for the protective layer, any water-soluble polymer and water-insoluble polymer can be appropriately selected to use. The polymers may be used in combination of two or more thereof, if desired. Specifically, for example, polyvinyl alcohol, a modified polyvinyl alcohol, polyvinyl pyrrolidone, a water-soluble cellulose derivative and poly(meth)acrylonile are exemplified. Among them, a water-soluble polymer compound relatively excellent in crystallizability is preferably used. Specifically, when polyvinyl alcohol is used as the main component, particularly preferred results can be obtained in the fundamental characteristics, for example, the oxygen-blocking property and removability by development.

Polyvinyl alcohol for use in the protective layer may be partially substituted with ester, ether or acetal as long as it contains unsubstituted vinyl alcohol units necessary for achieving the desired oxygen-blocking property and water solubility. Also, polyvinyl alcohol may partly have other copolymer component. Polyvinyl alcohol is obtained by hydrolysis of polyvinyl acetate. As specific examples of the polyvinyl alcohol, those having a hydrolysis degree of 69.0 to 100% by mole and a polymerization repeating unit number of 300 to 2,400 are exemplified. Specific examples thereof include PVA-102, PVA-103, PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-235, PVA-217EE, PVA-217E, PVA-220E, PVA-224E, PVA-403, PVA-405, PVA-420, PVA-424H, PVA-505, PVA-617, PVA-613, PVA-706 and L-8 (produced by Kuraray Co., Ltd.). The polyvinyl alcohols can be used individually or as a mixture. The content of polyvinyl alcohol in the protective layer is preferably from 20 to 95% by weight, and more preferably from 30 to 90% by weight.

Modified polyvinyl alcohol can also be preferably used. Particularly, an acid-modified polyvinyl alcohol having

a carboxylic acid group or a sulfonic acid group is preferably used. Specifically, modified polyvinyl alcohols described in JP-A-2005-250216 and JP-A-2006-259137 are preferably exemplified.

When the polyvinyl alcohol is used as a mixture with other material, as the other material mixed, a modified polyvinyl alcohol, polyvinyl pyrrolidone or a modified product thereof is preferred from the viewpoint of the oxygen-blocking property and removability by development. The content thereof in the protective layer is ordinarily from 3.5 to 80% by weight, preferably from 10 to 60% by weight, and more preferably from 15 to 30% by weight.

To the protective layer, glycerin, dipropylene glycol or the like can be added in an amount corresponding to several % by weight of the polymer to provide flexibility. Further, an anionic surfactant, for example, sodium alkylsulfate or sodium alkylsulfonate, an amphoteric surfactant, for example, alkylaminocarboxylate and alkylaminodicarboxylate, or a nonionic surfactant, for example, polyoxyethylene alkyl phenyl ether can be added in an amount corresponding to several % by weight of the polymer.

Further, it is also preferred to incorporate an inorganic stratiform compound into the protective layer for the purpose of improving the oxygen-blocking property and property for protecting the surface of image-recording layer. Of the inorganic stratiform compounds, fluorine based swellable synthetic mica, which is a synthetic inorganic stratiform compound, is particularly useful. Specifically, inorganic stratiform compounds described in JP-A-2005-119273 are preferably exemplified.

The coating amount of the protective layer is preferably from 0.05 to 10 g/$m^2$. When the protective layer contains the inorganic stratiform compound, it is more preferably from 0.1 to 5 g/$m^2$, and when the protective layer does not contain the inorganic stratiform compound, it is more preferably from 0.5 to 5 g/$m^2$.

[Support]

A support for use in the lithographic printing plate precursor according to the invention is not particularly restricted as long as it is a dimensionally stable plate-like hydrophilic support. Particularly, an aluminum plate is preferred as the support. In advance of the use of an aluminum plate, the aluminum plate is preferably subjected to a surface treatment, for example, roughening treatment or anodizing treatment. The roughening treatment of the surface of the aluminum plate is conducted by various methods and includes, for example, mechanical roughening treatment, electrochemical roughening treatment (roughening treatment of electrochemically dissolving the surface) and chemical roughening treatment (roughening treatment of chemically dissolving the surface selectively). With respect to the treatments, methods described in Paragraph Nos. [0241] to [0245] of JP-2007-206217 are preferably used.

Further, for the purpose of increasing hydrophilicity of the non-image area to prevent printing stain, a hydrophilizing treatment may be applied to the surface of support. The hydrophilizing treatment of the surface of support includes, for example, an alkali metal silicate treatment method wherein the support is subjected to an immersion treatment or an electrolytic treatment in an aqueous solution, for example, of sodium silicate, a method of treating with potassium fluorozirconate and a method of treating with polyvinylphosphonic acid. An immersion treatment in an aqueous polyvinylphosphonic acid solution is preferably used.

The center line average roughness of the support is preferably from 0.10 to 1.2 $\mu$m. In the range described above, good adhesion property to the image-recording layer and good printing durability and good resistance to stain are achieved.

The color density of the support is preferably from 0.15 to 0.65 in terms of the reflection density value. In the range described above, good image-forming property by preventing halation at the image exposure and good aptitude for plate inspection after development are achieved.

The thickness of the support is preferably from 0.1 to 0.6 mm, more preferably from 0.15 to 0.4 mm, and still more preferably from 0.2 to 0.3 mm.

[Undercoat layer]

According to one embodiment of the lithographic printing plate precursor of the invention, an undercoat layer is provided between the support and the image-recording layer and the undercoat layer contains the specific polymer compound.

The undercoat layer may contain, if desired, a compound ordinarily used in the undercoat layer in addition to the specific polymer compound. For instance, a compound having an acid group, for example, a phosphonic acid group, a phosphoric acid group or a sulfonic acid group is exemplified. It is preferred for the compound to further have a polymerizable group in order to increase the adhesion property to the image-recording layer. As the polymerizable group, an ethylenically unsaturated bond group is preferred. Also, a compound further having a hydrophilic group, for example, an ethyleneoxy group is exemplified as a preferable compound. These compounds may be low molecular weight compounds or polymer compounds. Specifically, for example, a silane coupling agent having an ethylenically unsaturated bond group described in JP-A-10-282679, a polymer compound having an ethylenically unsaturated bond group and a

functional group capable of interacting with a surface of the support, for example, a phosphonic acid group or a phosphoric acid group described in JP-A-2-304441, and a low molecular weight compound or polymer compound having a crosslinkable group (preferably an ethylenically unsaturated bond group), a functional group capable of interacting with a surface of the support and a hydrophilic group described in JP-A-2005-238816, JP-A-2005-125749, JP-A-2006-239867 and JP-A-2006-215263. These compounds may be used in combination of two or more thereof, if desired.

The undercoat layer can be formed according to a conventional method. For instance, the constituting component of the undercoat layer, for example, the specific polymer compound is dissolved in an appropriate solvent to prepare a coating solution and the solution is coated on the support to form the undercoat layer. The solvent includes, for example, water, an organic solvent, for example, methanol, ethanol or methyl ethyl ketone, and a mixed solvent thereof. The coating method includes, for example, bar coater coating, spin coating, spray coating and curtain coating.

The coating amount (solid content) of the undercoat layer is preferably from 0.1 to 100 mg/$m^2$, and more preferably from 1 to 30 mg/$m^2$.

[Backcoat layer]

In the lithographic printing plate precursor according to the invention, a backcoat layer can be provided on the back surface of the support, if desired. The backcoat layer preferably includes, for example, a layer comprising an organic polymer compound described in JP-A-5-45885 and a coating layer comprising a metal oxide obtained by hydrolysis and polycondensation of an organic metal compound or inorganic metal compound described in JP-A-6-35174. Among them, use of an alkoxy compound of silicon, for example, $Si(OCH_3)_4$, $Si(OC_2H_5)_4$, $Si(OC_3H_7)_4$ or $Si(OC_4H_9)_4$ is preferred since the starting material is inexpensive and easily available.

[Method of preparing lithographic printing plate]

The lithographic printing plate precursor according to the invention is exposed imagewise and then subjected to development processing to prepare a lithographic printing plate.

<Image exposure>

The lithographic printing plate precursor is, for example, exposed with laser through a transparent original having a line image, a halftone dot image or the like, or imagewise exposed by scanning of laser beam based on digital data.

The wavelength of the exposure light source preferably used is from 300 to 450 nm or from 750 to 1,400 nm. In case of using the exposure light source from 300 to 450 nm, the lithographic printing plate precursor having an image-recording layer containing a sensitizing dye having an absorption maximum in such a wavelength range is preferably used. In case of using the exposure light source from 750 to 1,400 nm, the lithographic printing plate precursor having an image-recording layer containing an infrared absorbing agent which is a sensitizing dye having an absorption maximum in such a wavelength range is preferably used. As the light source having a wavelength from 300 to 450 nm, a semiconductor laser is preferably used. As the light source having a wavelength from 750 to 1,400 nm, a solid laser or semiconductor laser emitting an infrared ray is preferably used. With respect to the infrared ray laser, the output is preferably 100 mW or more, the exposure time per pixel is preferably within 20 microseconds, and the irradiation energy is preferably from 10 to 300 mJ/$cm^2$. Further, in order to shorten the exposure time, it is preferred to use a multibeam laser device. The exposure mechanism may be any of an internal drum system, an external drum system and a flat bed system.

The image exposure can be performed in a conventional manner using, for example, a plate setter. In case of the on-press development, after the lithographic printing plate precursor is mounted on a printing machine, the image exposure may be performed on the printing machine.

<Development processing>

The development processing can be performed by (1) method (developer processing process) of developing with a developer having pH from 2 to 14 or (2) method (on-press development process) of developing by supplying dampening water and/or ink on a printing machine.

<Developer processing process>

In the developer processing process, the imagewise exposed lithographic printing plate precursor is processed with a developer having pH from 2 to 14 to remove the unexposed area of the image-recording layer, thereby preparing a lithographic printing plate.

In a development processing using a highly alkaline developer (having pH of 12 or higher), ordinarily, a protective layer is removed in a pre-water washing step, the alkali development is conducted, the alkali is removed by washing with water in a post-water washing step, gum solution treatment is conducted and drying is conducted in a drying step, thereby preparing a lithographic printing plate.

According to a preferred embodiment of the invention, a developer having pH from 2 to 10.5 is used. In the embodiment, it is preferred to be incorporated a surfactant or a water-soluble polymer compound into the developer so that the development and gum solution treatment step can be conducted at the same time. Thus, the post-water washing step is not particularly necessary, and the development and gum solution treatment can be performed with one solution. Further, the pre-water washing step is not particularly necessary and removal of the protective layer can be conducted at the same time together with the development and gum solution treatment. After the development and gum solution treatment, the excess developer is preferably removed, for example, using a squeeze roller, followed by drying.

The processing of the lithographic printing plate precursor according to the invention with a developer is performed in a conventional manner at temperature ordinarily from 0 to 60°C, preferably from about 15 to about 40°C, using, for example, a method wherein the exposed lithographic printing plate precursor is immersed in the developer and rubbed with a brush or a method wherein the developer is sprayed to the exposed lithographic printing plate precursor and the exposed lithographic printing plate precursor is rubbed with a brush.

The development processing with the developer having pH from 2 to 14 according to the invention is preferably performed by an automatic development processor equipped with a supplying means for the developer and a rubbing member. An automatic development processor using a rotating brush roll as the rubbing member is particularly preferred. Further, the automatic development processor is preferably provided with a means for removing the excess developer, for example, a squeeze roller or a drying means, for example, a hot air apparatus, subsequently to the development processing means. Moreover, the automatic development processor may be provided with a pre-heating means for heat treatment of the exposed lithographic printing plate precursor prior to the development processing means.

The automatic development processor for use in the method of preparing a lithographic printing plate according to the invention includes, for example, that having a structure as shown in Fig. 1. The automatic development processor shown in Fig. 1 comprises a pre-heating unit 4 for performing heat treatment of the whole surface of a lithographic printing plate precursor 1 before development, a developing unit 6 for developing the lithographic printing plate precursor 1 and a drying unit 10 for drying the lithographic printing plate precursor 1. The exposed lithographic printing plate precursor 1 is carried in through a carrying-in slot into the pre-heating unit 4 by carrying-in rollers 12 and subjected to heat treatment in a heating chamber 5. In the heating chamber 5, a skewer roller 14 is provided. In the heating chamber 5, a heating means (not shown), for example, a heat generating means or a hot air supplying means is also provided. In a developing tank 20 of the developing unit 6, transport rollers 22, a brush roller 24 and squeeze rollers 26 are provided in order from the upstream side in the transporting direction of lithographic printing plate precursor and backup rollers 28 are disposed in appropriate positions therebetween. The lithographic printing plate precursor 1 is immersed in the developer while being transported by the transport rollers 22 and the non-image area of lithographic printing plate precursor 1 is removed by rotation of the brush roller 24 to conduct development processing. The lithographic printing plate precursor 1 subjected to the development processing is transported into the drying unit 10 by the squeeze rollers (carrying-out rollers).

In the drying unit 10, a guide roller 36 and a pair of skewer rollers 38 are disposed in order from the upstream side in the transporting direction. In the drying unit 10, a drying means (not shown), for example, a hot air supply means or a heat generating means is also provided. A discharge slot (not shown) is provided in the drying unit 10 and the lithographic printing plate dried by the drying means is discharged through the discharge slot. A shutter (not shown) is disposed in a passage between the drying unit 10 and the developing unit 6 and when the lithographic printing plate precursor 1 does not pass through the passage, the passage is closed by the shutter.

The developer for use in the processing with a developer in the invention is an aqueous solution having pH from 2 to 14. It is preferably an aqueous solution containing water as the main component (containing 60% by weight or more of water). In particular, an aqueous solution containing a surfactant (for example, an anionic, nonionic, cationic or amphoteric surfactant) or an aqueous solution containing a water-soluble polymer compound is preferred. An aqueous solution containing both the surfactant and the water-soluble polymer compound is also preferred. The pH of the developer is preferably from 3.5 to 13, more preferably from 6 to 13, and particularly preferably from 6.5 to 10.5.

The anionic surfactant for use in the developer of the invention is not particularly limited and includes, for example, fatty acid salts, abietic acid salts, hydroxyalkanesulfonic acid salts, alkanesulfonic acid salts, dialkylsulfosuccinic acid salts, straight-chain alkylbenzenesulfonic acid salts, branched akylbenzenesulfonic acid salts, alkylnaphmalenesulfonic acid salts, alkyldiphenylether (di)sulfonic acid salts, alkylphenoxy polyoxyethylene alkylsulfonic acid salts, polyoxyethylene alkylsulfophenyl ether salts, N-alkyl-N-oleyltaurine sodium salt, N-alkylsulfosuccinic acid monoamide disodium salts, petroleum sulfonic acid salts, sulfated castor oil, sulfated beef tallow oil, sulfate ester slats of fatty acid alkyl ester, alkyl sulfate ester salts, polyoxyethylene alkyl ether sulfate ester salts, fatty acid monoglyceride sulfate ester salts, polyoxyethylene alkyl phenyl ether sulfate ester salts, polyoxyethylene styryl phenyl ether sulfate ester salts, alkyl phosphate ester salts, polyoxyethylene alkyl ether phosphate ester salts, polyoxyethylene alkyl phenyl ether phosphate ester

salts, partially saponified products of styrene-maleic anhydride copolymer, partially saponified products of olefin-maleic anhydride copolymer and naphthalene sulfonate formalin condensates. Of the compounds, alkylbenzenesulfonic acid salts, alkylnaphthalenesulfonic acid salts and alkyldiphenylether (di)sulfonic acid salts are particularly preferably used.

The cationic surfactant for use in the developer of the invention is not particularly limited and hitherto known cationic surfactants may be used. For example, alkylamine salts, quaternary ammonium salts, alkylimidazolinium salts, polyoxyethylene alkyl amine salts and polyethylene polyamine derivatives are exemplified.

The nonionic surfactant for use in the developer of the invention is not particularly limited and includes, for example, polyethylene glycol type higher alcohol ethylene oxide adducts, alkylphenol ethylene oxide adducts, alkylnaphthol ethylene oxide adducts, phenol ethylene oxide adducts, naphthol ethylene oxide adducts, fatty acid ethylene oxide adducts, polyhydric alcohol fatty acid ester ethylene oxide adducts, higher alkylamine ethylene oxide adducts, fatty acid amide ethylene oxide adducts, ethylene oxide addacts of fat, polypropylene glycol ethylene oxide adducts, dimethylsiloxane-ethylene oxide block copolymers, dimethylsiloxane-(propylene oxide-ethylene oxide) block copolymers, fatty acid esters of polyhydric alcohol type glycerol, fatty acid esters of pentaerythritol, fatty acid esters of sorbitol and sorbitan, fatty acid esters of sucrose, alkyl ethers of polyhydric alcohols and fatty acid amides of alkanolamines. Of the compounds, those having an aromatic ring and an ethylene oxide chain are preferred, and alkyl-substituted or unsubstituted phenol ethylene oxide adducts and alkyl-substituted or unsubstituted naphthol ethylene oxide adducts are more preferred.

The amphoteric surfactant for use in the developer of the invention is not particularly limited and includes, for example, amine oxide type, for example, alkyldimethylamine oxide, betaine type, for example, alkyl betaine and amino acid type, for example, sodium salt of alkylamino fatty acid.

In particular, an alkyldimethylamine oxide which may have a substituent, an alkyl carboxy betaine which may have a substituent and an alkyl sulfo betaine which may have a substituent are preferably used. As specific examples of the compound, for example, the compound represented by the formula (2) in Paragraph No. [0256] of JP-A-2008-203359, the compounds represented by the formula (I), the formula (II) and the formula (VI) in Paragraph No. [0028] of JP-A-2008-276166 and the compounds in Paragraphs No. [0022] to [0029] of JP-A-2009-47927 can be used.

Two or more kinds of the surfactants may be used in the developer. The amount of the surfactant incorporated into the developer is preferably from 0.01 to 20% by weight, and more preferably from 0.1 to 10% by weight.

The water-soluble polymer compound for use in the developer according to the invention includes, for example, soybean polysaccharide, modified starch, gum arabic, dextrin, a cellulose derivative (for example, carboxymethyl cellulose, carboxyethyl cellulose or methyl cellulose) or a modified product thereof, pllulan, polyvinyl alcohol or a derivative thereof, polyvinyl pyrrolidone, polyacrylamide, an acrylamide copolymer, a vinyl methyl ether/maleic anhydride copolymer, a vinyl acetate/maleic anhydride copolymer, a styrene/maleic anhydride copolymer, polyvinylsulfonic acid or a salt thereof and polystyrenesulfonic acid or a salt thereof.

As the soybean polysaccharide, known soybean polysaccharide can be used. For example, as a commercial product, SOYAFIVE (trade name, produced by Fuji Oil Co., Ltd.) is available and various grade products can be used. The soybean polysaccharide preferably used is that having viscosity in a range from 10 to 100 mPa/sec in the 10% by weight aqueous solution thereof.

As the modified starch, known modified starch can be used. The modified starch can be prepared, for example, by a method wherein starch, for example, of corn, potato, tapioca, rice or wheat is decomposed, for example, with an acid or an enzyme to an extent that the number of glucose residue per molecule is from 5 to 30 and then oxypropylene is added thereto in an alkali.

Two or more kinds of the water-soluble polymer compounds may be used in combination in the developer. The content of the water-soluble polymer compound in the developer is preferably from 0.1 to 20% by weight, and more preferably from 0.5 to 10% by weight.

Into the developer for use in the invention, a pH buffer agent may be incorporated. In the developer according to the invention, a buffer agent exhibiting a buffer function at pH from 2 to 14 can be used without particular restriction. In the invention, a weak alkaline buffer agent is preferably used and, for example, (a) a carbonate ion and a hydrogen carbonate ion, (b) a borate ion, (c) a water-soluble amine compound and an ion of the amine compound, and a combination thereof are exemplified. Specifically, for example, (a) a combination of a carbonate ion and a hydrogen carbonate ion, (b) a borate ion, or (c) a combination of a water-soluble amine compound and an ion of the amine compound exhibits a pH buffer function in the developer to prevent fluctuation of the pH even when the developer is used for a long period of time. As a result, for example, the deterioration of developing property resulting from the fluctuation of pH and the occurrence of development scum are restrained. The combination of a carbonate ion and a hydrogen carbonate ion or the combination of a water-soluble amine compound and an ion of the amine compound is preferred.

In order for a carbonate ion and a hydrogen carbonate ion to be present in the developer, a carbonate and a hydrogen carbonate may be added to the developer or a carbonate ion and a hydrogen carbonate ion may be generated by adding a carbonate or a hydrogen carbonate to the developer and then adjusting the pH. The carbonate or hydrogen carbonate used is not particularly restricted and it is preferably an alkali metal salt thereof. Examples of the alkali metal include lithium, sodium and potassium and sodium is particularly preferred. The alkali metals may be used individually

or in combination of two or more thereof.

The total amount of the carbonate ion and hydrogen carbonate ion is preferably from 0.05 to 5 mole/l, more preferably from 0.07 to 2 mole/l, particularly preferably from 0.1 to 1 mole/l, in the developer.

The water-soluble amine compound is not particularly restricted and preferably a water-soluble amine having a group capable of facilitating water solubility. The group capable of facilitating water solubility includes, for example, a carboxylic acid group, a sulfonic acid group, a sulfinic acid group, a phosphonic acid group and a hydroxy group. The water-soluble amine may have two or more groups capable of facilitating water solubility. The carboxylic acid group, sulfonic acid group, sulfinic acid group or phosphonic acid group may be in the form of salt. Among them, an amine compound having a hydroxy group is particularly preferred.

As specific examples of the water-soluble amine having a carboxylic acid group, sulfonic acid group or sulfinic acid group, an amino acid, for example, glycine, aminodiacatic acid, lysine, threonine, serine, asparaginic acid, parahydroxyphenyl glycine, dihydroxyethyl glycine, alanine, anthranilic acid or tryptophan, sulfamic acid, cyclohexylsulfamic acid, an aliphatic amine sulfonic acid, for example, taurine, and an aliphatic amine sulfinic acid, for example, aminoethanesulfinic acid, and sodium salts, potassium salts or ammonium salts thereof are useful. Of these compounds, glycine or aminodiacetic acid is preferred.

As specific examples of the water-soluble amine compound having a phosphonic acid group (including a phosphinic acid group), 2-aminoethylphosphonic acid, 1-aminoethane-1,1-diphosphonic acid, 1-amino-1-phenylmethane-1,1-diphosphonic acid, 1-dimethylaminoethane-1,1-diphosphonic acid, ethylenediaminopentamethylenephosphonic acid, and sodium salts, potassium salts or ammonium salts thereof are useful. Particularly, 2-aminoethylphosphonic acid or a salt thereof is preferred.

As specific examples of the water-soluble amine having a hydroxy group, monoethanolamine, diethanolamine, triethanolamine, N-hydroxyethylmorpholine, monoisopropanolamine, diisopropanolamine, triisopropanolamine and N,N-diethanolaniline are useful. Among them, monoethanolamine, diethanolamine, triethanolamine or N-hydroxyethylmorpholine is preferred.

The ion of water-soluble amine can be generated in an aqueous solution of the water-soluble amine. To the aqueous solution of water-soluble amine may further be added an alkali or an acid. Alternatively, the ion of water-soluble amine may be contained in an aqueous solution by adding a compound which is a salt of water-soluble amine per se. The alkali which can be used includes, for example, sodium hydroxide, potassium hydroxide, lithium hydroxide, sodium carbonate, potassium carbonate, ammonium carbonate, sodium hydrogen carbonate, potassium hydrogen carbonate, ammonium hydrogen carbonate, and a combination thereof. The acid which can be used includes, for example, an inorganic acid, for example, hydrochloric acid, sulfuric acid, nitric acid or phosphoric acid. By adding such an alkali or acid, the pH can be finely adjusted.

The total amount of the water-soluble amine and ion of the amine in the developer is preferably from 0.5 to 20% by weight, more preferably from 1 to 15% by weight, particularly preferably from 1 to 12% by weight, based on the total weight of the developer.

The developer according to the invention may contain an organic solvent. As the organic solvent capable of being contained, for example, an aliphatic hydrocarbon (e.g., hexane, heptane, Isopar E, Isopar H or Isopar G (produced by Esso Chemical Co., Ltd.)), an aromatic hydrocarbon (e.g., toluene or xylene), a halogenated hydrocarbon (methylene dichloride, ethylene dichloride, trichlene or monochlorobenzene) or a polar solvent is exemplified. Examples of the polar solvent include an alcohol (e.g., methanol, ethanol, propanol, isopropanol, 1-butanol, 1-pentanol, 1 -hexanol, 1-heptanol, 1-octanol, 2-octanol, 2-ethyl-1-hexanol, 1-nonanol, 1-decanol, benzyl alcohol, ethylene glycol monomethyl ether, 2-ethyoxyethanol, diethylene glycol monoethyl ether, diethylene glycol monohexyl ether, triethylene glycol monomethyl ether, propylene glycol monoethyl ether, propylene glycol monomethyl ether, polyethylene glycol monomethyl ether, polypropylene glycol, tetraethylene glycol, ethylene glycol monobutyl ether, ethylene glycol monobenzyl ether, ethylene glycol monophenyl ether, propylene glycol monophenyl ether, methyl phenyl carbinol, n-amyl alcohol or methylamyl alcohol), a ketone (e.g., acetone, methyl ethyl ketone, ethyl butyl ketone, methyl isobutyl ketone or cyclohexanone), an ester (e.g., ethyl acetate, propyl acetate, butyl acetate, aryl acetate, benzyl acetate, methyl lactate, butyl lactate, ethylene glycol monobutyl acetate, polyethylene glycol monomethyl ether acetate, diethylene glycol acetate, diethyl phthalate or butyl levulinate) and others (e.g., triethyl phosphate, tricresyl phosphate, N-phenylethanolamine, N-phenyldiethanolamine, N-methyldiethanolamine, N-ethyldiethanolamine, 4-(2-hydroxyethyl)morpholine, N,N-dimethylacetamide or N-methylpyrrolidone).

Two or more kinds of the organic solvents may be used in combination in the developer. When the organic solvent is insoluble in water, it may be employed by being solubilized in water using a surfactant or the like. When the developer contains an organic solvent, the concentration of the organic solvent is desirably less than 40% by weight, in view of safety and inflammability.

The developer of the invention may contain a preservative, a chelating agent, a defoaming agent, an organic acid, an inorganic acid, an inorganic salt or the like in addition the components described above. Specifically, compounds described in Paragraph Nos. [0266] to [0270] of JP-A-2007-206217 are preferably used.

The developer of the invention can be used as a developer and a development replenisher for the exposed lithographic printing plate precursor. The developer can be preferably applied to the automatic development processor as described above. In the case of conducting the development processing using an automatic development processor, the developer becomes fatigued in accordance with the processing amount, and hence the processing ability may be restored using a replenisher or a fresh developer.

<On-press development process>

In the on-press development process, an oily ink and an aqueous component are supplied to the imagewise exposed lithographic printing plate precursor on a printing machine to remove the non-image area of the image-recording layer, thereby preparing a lithographic printing plate.

Specifically, the lithographic printing plate precursor is imagewise exposed and then mounted on a printing machine as it is without undergoing any development processing or the lithographic printing plate precursor is mounted on a printing machine and then imagewise exposed on the printing machine, and thereafter, when an oily ink and an aqueous component are supplied to the imagewise exposed lithographic printing plate precursor to perform printing, in the non-image area, the uncured image-recording layer is removed by dissolution or dispersion with the oily ink and/or aqueous component supplied to reveal the hydrophilic surface in the area. On the other hand, in the exposed area of the image-recording layer, the image-recording layer cured by the exposure forms the oily ink receptive area having the oleophilic surface. While either the oily ink or aqueous component may be supplied at first on the surface of exposed lithographic printing plate precursor, it is preferred to supply the oily ink at first in view of preventing the aqueous component from contamination with the component of the image-recording layer removed. Thus, the lithographic printing plate precursor is subjected to the on-press development on a printing machine and used as it is for printing a large number of sheets. For the oily ink and aqueous component, printing ink and dampening water for conventional lithographic printing are preferably used respectively.

In the method of preparing a lithographic printing plate from the lithographic printing plate precursor according to the invention, regardless of the development process used, the lithographic printing plate precursor may be heated its entire surface before or during the exposure or between the exposure and the development, if desired. By the heating, the image-forming reaction in the image-recording layer is accelerated and advantages, for example, improvement in the sensitivity and printing durability and stabilization of the sensitivity are achieved. Further, in the developer processing process, for the purpose of increasing the image strength and printing durability, it is also effective to perform entire after-heating or entire exposure of the image after the development processing. Ordinarily, the heating before the development is preferably performed under a mild condition of 150°C or lower. When the temperature is too high, a problem may arise sometimes in that the non-image area is also cured. On the other hand, the heating after the development can be performed using very strong conditions. Ordinarily, the heat treatment is carried out in a temperature range from 100 to 500°C. When the temperature is too low, a sufficient effect of strengthening the image may not be obtained, whereas when it is excessively high, problems of deterioration of the support and thermal decomposition of the image area may occur sometimes.

## EXAMPLES

The present invention will be described in more detail with reference to the following examples, but the invention should not be construed as being limited thereto.

Synthesis examples of the specific polymer compound according to the invention are described below.

### Synthesis of Specific polymer compound (P-1)

In a 300 ml flask equipped with a condenser and a stirrer were put 16.21 g of benzyl alcohol, 120 ml of tetrahydrofuran and 12.46 g of pyridine and the mixture was cooled to 0°C. Then, 23.60 g of 2-bromoacetyl chloride was dropwise added thereto over a period of one hour and after the completion of the dropwise addition, the mixture was stirred at 25°C for 2 hours. The reaction product was filtered and the filtrate was dried under a reduced pressure to obtain 37.2 g of yellow liquid. Then, to the solution prepared by dissolving 20.3 g of (3-dimethylaminopropyl)acrylamide in 50 g of acetonitrile was dropwise added 30 g of the yellow liquid at 30°C with stirring over a period of 30 minutes, followed by stirring at 30°C for 60 minutes to complete the reaction. After the reaction, the reaction solution was dried under a reduced pressure to distill off acetonitrile. Thereafter, the reaction solution was dropwise added to an aqueous solution of potassium hexafluorophosphate to precipitate, thereby preparing 51.2 g of 3-acrylamido-N-(2-benzyloxy)-2-oxoethyl)-N,N-diinethylpropane-1-ammonium hexafluorophosphate as a white solid.

In a 200 ml flask equipped with a condenser and a stirrer were put 14.66 g of N-methylpyrrolidone and 3.78 g of vinylphosphonic acid and the mixture was heated to 70°C under nitrogen stream. To the mixture was dropwise added

a solution containing 15.76 g of 3-acrylamido-N-(2-benzyloxy)-2-oxoethyl)-N,N-dimethylpropane-1-ammonium hexafluorophosphate, 0.161 g of V-601 (produced by Wako Pure Chemical Industries, Ltd.) and 14.66 g of N-methylpyrrolidone over a period of 4 hours. After the completion of the dropwise addition, 0.161 g of V-601 was added and the temperature was raised to 80°C, followed by stirring for 2 hours to obtain Specific polymer compound (P-1). A weight average molecular weight of Specific polymer compound (P-1) thus-obtained was measured by a gel permeation chromatography (GPC) method using polyethylene glycol as a standard substance and found to be 18,000.

Synthesis of Specific polymer compound (P-25)

In a 200 ml flask equipped with a condenser and a stirrer, 20.7 g of 3-acrylamido-N-(sulffonatemethyl)-N, N-dimethylpropane-1-ammonium was dissolved in 100 ml of acetonitrile and 11.59 g of silver oxide (I) was added to the solution, followed by stirring at room temperature for 30 minutes. Then, 17.1 g of benzyl bromide was added thereto, followed by stirring for 4 hours. After the completion of the reaction, the reaction solution was filtered and the filtrate was concentrated under a reduced pressure and purified by silica gel column chromatography to obtain benzyl 2-acrylamido-2-methylpropanesulfonate. Then, 3-acrylamido- N-(benzylsulfonatemethyl)-N, N-dimetllylpropane-1-almmonium hexafluorophosphate was copolymerized with vinylphosphonic acid in the same manner as in Synthesis of Specific polymer compound (P-1) to obtain Specific polymer compound (P-25). A weight average molecular weight of Specific polymer compound (P-25) thus-obtained was measured by a gel permeation chromatography (GPC) method using polyethylene glycol as a standard substance and found to be 22,000.

Synthesis of Specific polymer compound (P-26)

In a 500 ml flask equipped with a condenser and a stirrer, 57.94 g of (3-(benzyloxy)-3-oxoisopropyl)(hydroxymethyl)(methyl)sulfonium hexafluorophosphate was dissolved in 166.9 g of tetrahydrofuran and the solution was cooled to 0°C. Then, 13.58 g of acrylic chloride was dropwise added thereto with stirring over a period of one hour and after the completion of the dropwise addition, the mixture was stirred at 10°C for one hour. After the reaction, the reaction solution was dried under a reduced pressure to distill off tetrahydrofuran and the residue was washed with ethyl acetate to obtain 59.44 g of (acryloxymethyl)(3-(berizyloxy)-3-oxoisopropyl)(hydroxymethyl)(methyl)sulfonium hexafluorophosphate, Then, the compound was copolymerized with vinylphosphonic acid in the same manner as in Synthesis of Specific polymer compound (P-1) to obtain Specific polymer compound (P-26). A weight average molecular weight of Specific polymer compound (P-26) thus-obtained was measured by a gel permeation chromatography (GPC) method using polyethylene glycol as a standard substance and found to be 22,000.

Examples I to 73 and Comparative Examples 1 to 11

(1) Preparation of Lithographic printing plate precursor

[Preparation of Aluminum support 1]

An aluminum plate (material: JIS A 1050) having a thickness of 0.3 mm was subjected to a degreasing treatment at 50°C for 30 seconds using a 10% by weight aqueous sodium aluminate solution in order to remove rolling oil on the surface thereof and then grained the surface thereof using three nylon brushes embedded with bundles of nylon bristle having a diameter of 0.3 mm and an aqueous suspension (specific gravity: 1.1 g/cm$^3$) of pumice having a median size of 25 $\mu$m, followed by thorough washing with water. The plate was subjected to etching by immersing in a 25% by weight aqueous sodium hydroxide solution of 45°C for 9 seconds, washed with water, then immersed in a 20% by weight aqueous nitric acid solution at 60°C for 20 seconds, and washed with water. The etching amount of the grained surface was about 3 g/m$^2$.

Then, using an alternating current of 60 Hz, an electrochemical roughening treatment was continuously carried out on the plate. The electrolytic solution used was a 1% by weight aqueous nitric acid solution (containing 0.5% by weight of aluminum ion) and the temperature of electrolytic solution was 50°C. The electrochemical roughening treatment was conducted using an alternating current source, which provides a rectangular alternating current having a trapezoidal waveform such that the time TP necessary for the current value to reach the peak from zero was 0.8 msec and the duty ratio was 1:1, and using a carbon electrode as a counter electrode. A ferrite was used as an auxiliary anode. The current density was 34 A/dm$^2$ in terms of the peak value of the electric current and 5% of the electric current flowing from the electric source was divided to the auxiliary anode. The quantity of electricity in the nitric acid electrolysis was 175 C/dm$^2$ in terms of the quantity of electricity when the aluminum plate functioned as an anode. The plate was then washed with water by spraying.

The plate was further subjected to an electrochemical roughening treatment in the same manner as in the nitric

acid electrolysis above using as an electrolytic solution, a 0.5% by weight aqueous hydrochloric acid solution (containing 0.5% by weight of aluminum ion) having temperature of 50°C and under the condition that the quantity of electricity was 50 C/dm$^2$ in terms of the quantity of electricity when the aluminum plate functioned as an anode. The plate was then washed with water by spraying. The plate was then subjected to an anodizing treatment using as an electrolytic solution, a 15% by weight aqueous sulfuric acid solution (containing 0.5% by weight of aluminum ion) at a current density of 15 A/dm$^2$ to form a direct current anodized film of 2.5 g/m$^2$, washed with water and dried to prepare Aluminum support 1.

The surface roughness of the support thus obtained was measured and found to be 0.51 μm (Ra indication according to JIS B0601).

[Preparation of Aluminum support 2]

Aluminum support 1 was treated with a 1% by weight aqueous sodium silicate solution at 20°C for 10 seconds to prepare Aluminum support 2. The surface roughness of the support was measured and found to be 0.54 μm (Ra indication according to JIS B0601).

[Preparation of Aluminum support 3]

An aluminum plate (material: 1050, refining: H16) having a thickness of 0.24 mm was immersed in an aqueous 5% by weight sodium hydroxide solution maintained at 65°C to conduct a degreasing treatment for one minute, followed by washed with water. The aluminum plate was immersed in an aqueous 10% by weight hydrochloric acid solution maintained at 25°C for one minute to neutralize, followed by washed with water. Subsequently, the aluminum plate was subjected to an electrolytic surface-roughening treatment with alternating current under condition of current density of 100 A/dm$^2$ in an aqueous 0.3% by weight hydrochloric acid solution at 25°C for 60 seconds and then subjected to a desmut treatment in an aqueous 5% by weight sodium hydroxide solution maintained at 60°C for 10 seconds. The aluminum plate was subjected to an anodizing treatment under conditions of current density of 10 A/dm$^2$ and voltage of 15 V in an aqueous 15% by weight sulfuric acid solution at 25°C for one minute to prepare Aluminum support 3. The surface roughness of the support was measured and found to be 0.44 μm (Ra indication according to JIS B0601).

[Formation of Undercoat layer]

Coating solution for undercoat layer having the composition shown below was coated by a bar coater and dried at 100°C for one minute to prepare an undercoat layer. A dry coating amount of the undercoat layer was 12 mg/m$^2$.

<Coating solution for undercoat layer>

| | |
|---|---|
| Specific polymer compound or Comparative polymer compound shown in Table 1 | 0.50 g |
| Methanol | 90.0 g |
| Water | 10.0 g |

Comparative polymer compounds (R-1) to (R-5) are shown below. Comparative polymer compound

(R-1) 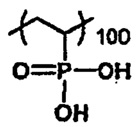 Mw:12,000

(R-2) 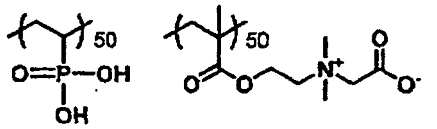 Mw:20,000

(R-3) 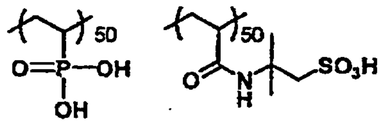 Mw:32,000

(R-4) 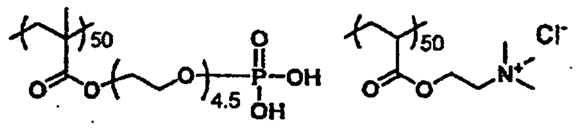 Mw:26,000

(R-5) 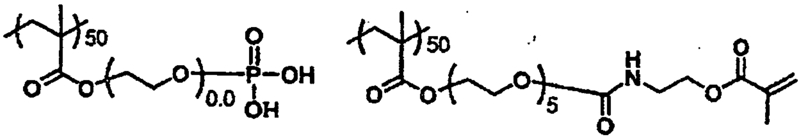 Mw:18,000

[Formation of image-recording layer 1]

Coating solution 1 for image-recording layer having the composition shown below was coated using a bar and dried in an oven at 90°C for 60 seconds to form Image-recording layer 1 having a dry coating amount of 1.3 g/m$^2$. [0234]

<Coating solution 1 for image-recording layer>

| | |
|---|---|
| Binder polymer (1) shown below (weight average molecular weight: 80,000) | 0.34 g |
| Polymerizable compound (1) shown below (PLEX 6661-O, produced by Degussa Japan co., Ltd.) | 0.68g |
| Sensitizing dye (1) shown below | 0.06g |
| Polymerization initiator (1) shown below | 0.18 g |
| Chain transfer agent (1) shown below | 0.02 g |
| Dispersion of ε-phthalocyanine pigment (pigment: 15 parts by weight; dispersing agent (allyl methacrylate/methacrylic acid copolymer (copolymerization molar ratio: 83/17, weight average molecular weight: 60,000)): 10 parts by weight; cyclohexanone: 15 parts by weight) | 0.40 g |
| Thermal polymerization inhibitor N-nitrosophenylhydroxylamine aluminum salt | 0.01 g |
| Fluorine-based surfactant (1) shown below (weight average molecular weight: 10,000) | 0.001 g |
| Polyoxyethylene-polyoxypropylene condensate (PLURONIC L44, produced by ADEKA Corp.) | 0.02 g |
| Dispersion of yellow pigment (yellow pigment (NOVOPERM YELLOW H2G, produced by Clariant Corp.): 15 parts by weight; dispersing agent (allyl methacrylate/methacrylic acid copolymer (copolymerization molar ratio: 83/17, weight average molecular weight: 60,000,)): 10 parts by weight; cyclohexanone: 15 parts by weight) | 0.04 g |
| 1 -Methoxy-2-propanol | 3.5 g |
| Methyl ethyl ketone | 8.0 g |

Binder polymer (1) :

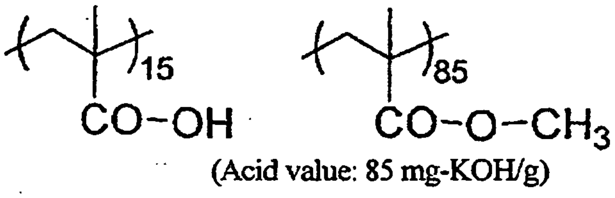

(Acid value: 85 mg-KOH/g)

Polymerizable compound (1):

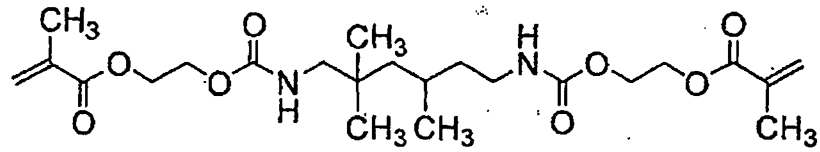

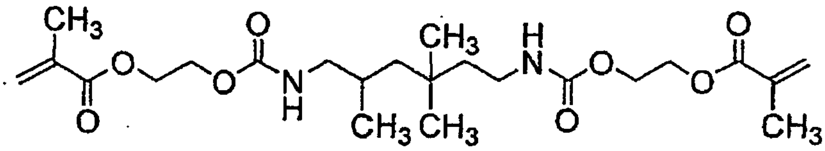

A mixture of the isomers described above.

Sensitizing dye (1):

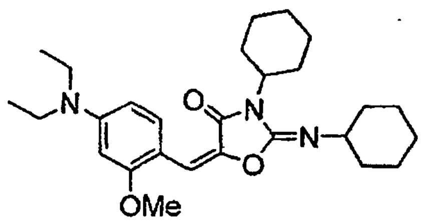

Polymerization initiator (1):

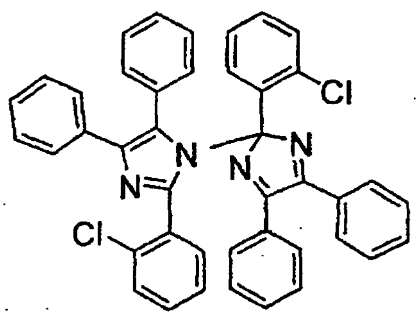

Chain transfer agent (1):

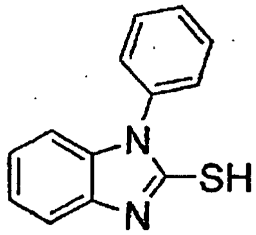

Fluorine-based surfactant (1):

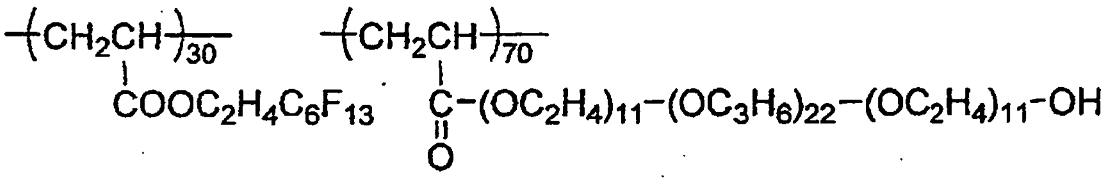

[Formation of Image-recording layer 2]

Coating solution 2 for image-forming layer having the composition shown below was coated using a bar and dried in an oven at 90°C for 60 seconds to form Image-recording layer 2 having a dry coating amount of 1.3 g/$m^2$.

| | |
|---|---|
| <Coating solution 2 for image-recording layer> | |
| Binder polymer (1) shown above (weight average molecular weight: 80,000) | 0.04g |
| Binder weight (2) polymer shown below (weight average molecular 80,000) | 0.30g |
| Polymerizable compound (1) shown above (PLEX 6661-O, produced by Degussa Japan Co., Ltd.) | 0.17 g |
| Polymerizable compound (2) shown below | 0.51 g |
| Sensitizing dye (2) shown below | 0.03g |
| Sensitizing dye (3) shown below | 0.015 g |
| Sensitizing dye (4) shown below | 0.015 g |
| Polymerization initiator (1) shown above | 0.13 g |
| Chain transfer agent Mercaptobenzothiazole | 0.01 g |
| Dispersion of ε-phthalocyanine pigment (pigment: 15 parts by weight; dispersing agent (allyl methacrylate/methacrylic acid copolymer (copolymerization molar ratio: 83/17, weight average molecular weight: 60,000)): 10 parts by weight; cyclohexanone: 15 parts by weight) | 0.40 g |
| Thermal polymerization inhibitor N-Nitrosophenylhydroxylamine aluminum salt | 0.01 g |
| Fluorine-based surfactant (1) shown above (weight average molecular weight: 10,000) | 0.001 g |
| 1-Methoxy-2-propanol | 3.5 g |
| Methyl ethyl ketone | 8.0 g |

Binder polymer (2):

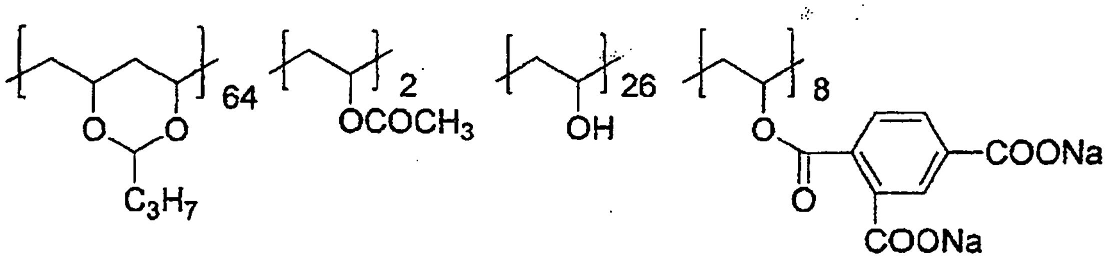

Polymerizable compound (2):

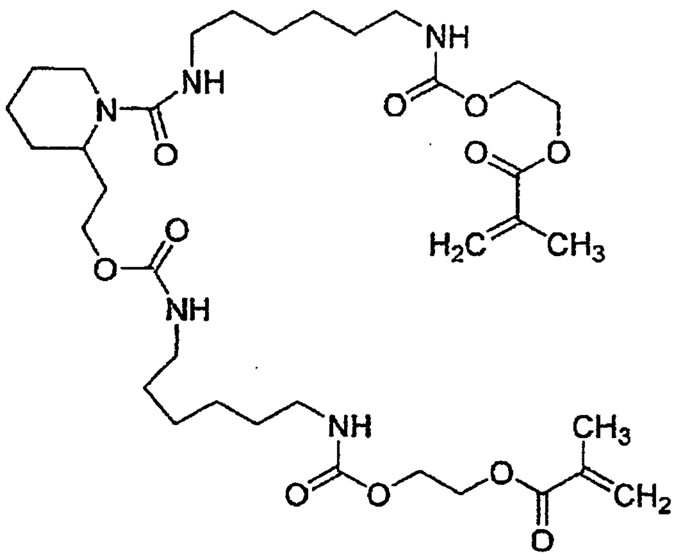

Sensitizing dye (2):

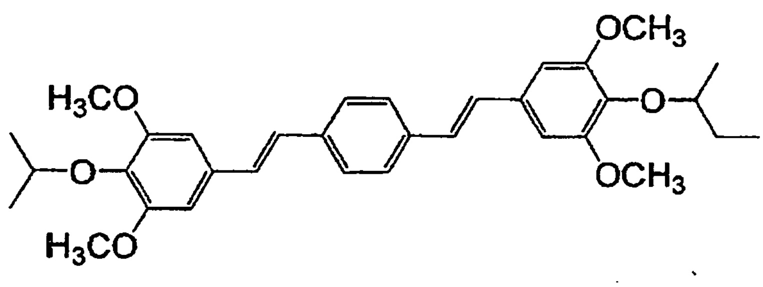

Sensitizing dye (3):

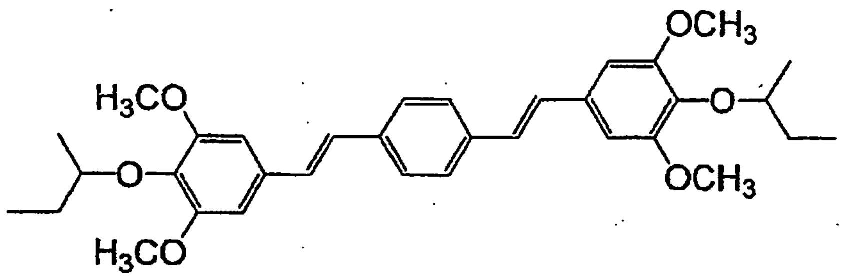

Sensitizing dye (4):

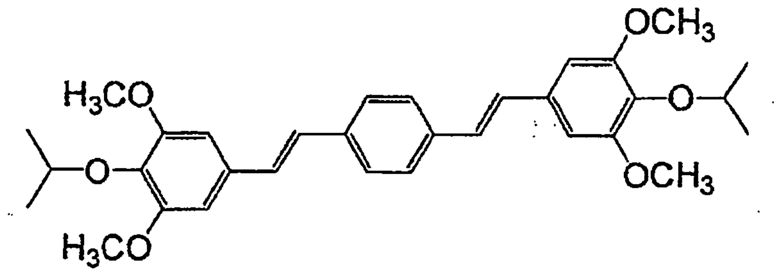

[Formation of Image-recording layer 3]

Coating solution 3 for image-forming layer having the composition shown below was coated using a bar and dried in an oven at 100°C for 60 seconds to form Image-recording layer 3 having a dry coating amount of 1.0 g/$m^2$ . Coating solution 3 for image-recording layer was prepared by mixing Photosensitive solution (1) shown below with Hydrophobilizing precursor solution (1) shown below just before the coating, followed by stirring.

| | |
|---|---|
| <Photosensitive solution (1)> | |
| Binder polymer (3) shown below | 0.162 g |
| Infrared absorbing agent (1) shown below | 0.030 g |
| Polymerization initiator (3) shown below | 0.162 g |
| Polymerizable compound (ARONIX M-215, produced by Toagosei Co., Ltd.) | 0.385 g |
| PIONIN A-20 (produced by Takemoto Oil & Fat Co., Ltd.) | 0.055 g |
| Oil-sensitizing agent (1) shown below | 0.044 g |
| Fluorine-based surfactant (1) shown above | 0.008 g |
| Methyl ethyl ketone | 1.091 g |
| 1-Methoxy-2-propanol | 8.609 g |

| | |
|---|---|
| <Hydrophobilizing precursor solution (1)> | |
| Aqueous dispersion of hydrophobilizing precursor (1) shown below | 2.640 g |
| Distilled water | 2.425 g |

Binder polymers (3):

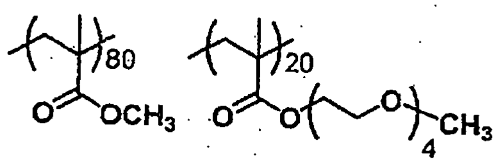

Mw=80,000

Infrared absorbing agent (1):

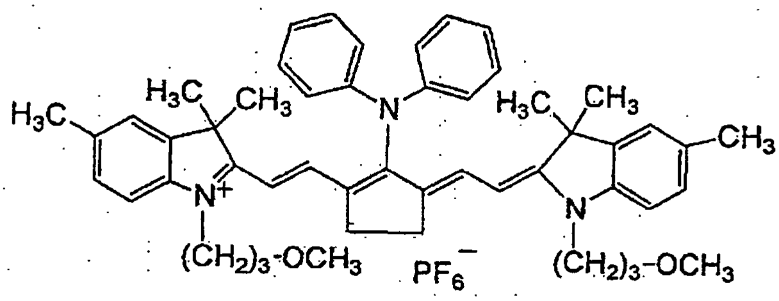

Polymerization initiator (3):

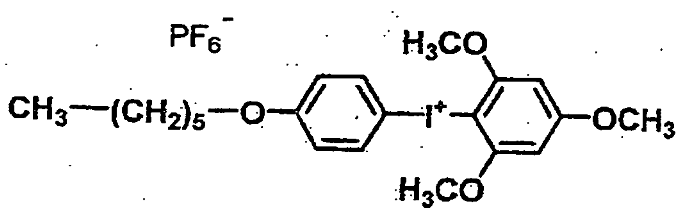

Oil-sensitizing agent (1):

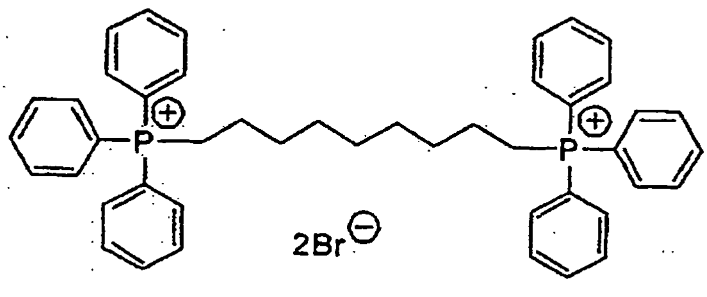

(Preparation of Aqueous dispersion of hydrophobilizing precursor (1))

A stirrer, a thermometer, a dropping funnel, a nitrogen inlet tube and a reflux condenser were attached to a 1,000 ml four-neck flask and while carrying out deoxygenation by introduction of nitrogen gas, 350 ml of distilled water was charged therein and heated until the internal temperature reached 80°C. Then, 1.5 g of sodium dodecylsulfate was added as a dispersing agent, then 0.45 g of ammonium persulfate was added as an initiator and thereafter a mixture of

45.0 g of glycidyl methacrylate and 45.0 g of styrene was dropwise added through the dropping funnel over a period of about one hour. After the completion of the dropwise addition, the reaction was continued as it was for 5 hours. Then, the unreacted monomer was removed by steam distillation. The reaction solution was cooled and adjusted its pH to 6 with aqueous ammonia, and finally pure water was added thereto so as to have the nonvolatile component of 15% by weight to prepare Aqueous dispersion of hydrophobilizing precursor (1). The particle size distribution of the polymer fine particle had the maximum value at the particle size of 60 nm.

The particle size distribution was determined by taking an electron microphotograph of the polymer fine particle, measuring particle sizes of 5,000 fine particles in total on the photograph, and dividing a range from the largest value of the particle size measured to 0 on a logarithmic scale into 50 parts to obtain occurrence frequency of each particle size by plotting. With respect to the aspherical particle, a particle size of a spherical particle having a particle area equivalent to the particle area of the aspherical particle on the photograph was defined as the particle size.

[Formation of Protective layer 1]

Coating solution 1 for protective layer having the composition shown below was coated using a bar so as to have a dry coating amount of 0.75 g/m$^2$ and dried at 125°C for 70 seconds to form Protective layer 1.

| <Coating solution 1 for protective layer> | |
|---|---|
| Polyvinyl alcohol (saponification degree: 98% by mole; polymerization degree: 500) | 40 g |
| Polyvinyl pyrrolidone (weight average molecular weight: 50,000) | 5g |
| Vinyl pyrrolidone/vinyl acetate (1/1) copolymer (weight average molecular weight: 70,000) | 0.5 g |
| Surfactant (EMALEX 710, produced by Nihon-Emulsion Co., Ltd.) | 0.5 g |
| Ion-exchanged water | 950 g |

[Formation of Protective layer 2]

Coating solution 2 for protective layer having the composition shown below was coated using a bar so as to have a dry coating amount of 0.75 g/m$^2$ and dried at 125°C for 70 seconds to form Protective layer 2.

| <Coating solution 2 for protective layer> | |
|---|---|
| Dispersion of inorganic stratiform compound (1) shown below | 1.5 g |
| Aqueous 6% by weight solution of sulfonic acid-modified polyvinyl alcohol (CKS 50, saponification degree: 99% by mole or more, polymerization degree: 300, produced by Nippon Synthetic Chemical Industry Co., Ltd.) | 0.55 g |
| Aqueous 6% by weight solution of polyvinyl alcohol (PVA-405, saponification degree: 81.5 % by mole, polymerization degree: 500, produced by Kuraray Co., Ltd.) | 0.03 g |
| Aqueous 1% by weight solution of surfactants (EMALEX 710, produced by Nihon Emulsion Co., Ltd.) | 0.86g |
| Ion-exchanged water | 6.0 g |

(Preparation of Dispersion of inorganic stratiform compound (1))

To 193.6 g of ion-exchanged water was added 6.4 g of synthetic mica.(SOMASIF ME-100, produced by CO-OP Chemical Co., Ltd.) and the mixture was dispersed using a homogenizer until an average particle size (according to a laser scattering method) became 3 μm to prepare Dispersion of inorganic stratiform compound (1). The aspect ratio of the inorganic stratiform compound particle thus-dispersed was 100 or more.

The aluminum supports, undercoat layer, image-recording layers and protective layers described above were used in combination as shown in Table 1 below to prepare Lithographic printing plate precursors A-1a to A-68 and B-1 to B-10, respectively.

TABLE 1

| Lithographic Printing Plate Precursor | Aluminum Support | Specific Polymer Compound or Comparative Polymer Compound in Undercoat Layer | Image-Recording Layer | Protective Layer |
|---|---|---|---|---|
| A-1a | 1 | P-1 | 1 | 1 |

(continued)

| Lithographic Printing Plate Precursor | Aluminum Support | Specific Polymer Compound or Comparative Polymer Compound in Undercoat Layer | Image-Recording Layer | Protective Layer |
|---|---|---|---|---|
| A-1b | 1 | P-1 | 1(*1) | 1 |
| A-2 | 1 | P-2 | 1 | 1 |
| A-3 | 1 | P-3 | 1 | 1 |
| A-4 | 1 | P-4 | 1 | 1 |
| A-5 | 1 | P-5 | 1 | 1 |
| A-6 | 1 | P-6 | 1 | 1 |
| A-7 | 1 | P-7 | 1 | 1 |
| A-8 | 1 | P-8 | 1 | 1 |
| A-9 | 1 | P-9 | 1 | 1 |
| A-10 | 1 | P-10 | 1 | 1 |
| A-11 | 1 | P-1 | 1 | 1 |
| A-12 | 1 | P-12 | 1 | 1 |
| A-13 | 1 | P-13 | 1 | 1 |
| A-14 | 1 | P-14 | 1 | 1 |
| A-15 | 1 | P-15 | 1 | 1 |
| A-16 | 1 | P-16 | 1 | 1 |
| A-17 | 1 | P-17 | 1 | 1 |
| A-18 | 1 | P-18 | 1 | 1 |
| A-19 | 1 | P-19 | 1 | 1 |
| A-20 | 1 | P-20 | 1 | 1 |
| A-21 | 1 | P-21 | 1 | 1 |
| A-22 | 1 | P-22 | 1 | 1 |
| A-23 | 1 | P-23 | 1 | 1 |
| A-24 | 1 | P-24 | 1 | 1 |
| A-25 | 1 | P-25 | 1 | 1 |
| A-26 | 1 | P-26 | 1 | 1 |
| A-27 | 1 | P-27 | 1 | 1 |
| A-28 | 1 | P-28 | 1 | 1 |
| A-29 | 1 | P-29 | 1 | 1 |
| A-30 | 1 | P-30 | 1 | 1 |
| A-31 | 1 | P-31 | 1 | 1 |
| A-32 | 1 | P-32 | 1 | 1 |
| A-33 | 1 | P-33 | 1 | 1 |
| A-34 | 1 | P-34 | 1 | 1 |
| A-35 | 1 | P-35 | 1 | 1 |
| A-36 | 1 | P-36 | 1 | 1 |

(continued)

| Lithographic Printing Plate Precursor | Aluminum Support | Specific Polymer Compound or Comparative Polymer Compound in Undercoat Layer | Image-Recording Layer | Protective Layer |
|---|---|---|---|---|
| A-37 | 1 | P-37 | 1 | 1 |
| A-38 | 1 | P-38 | 1 | 1 |
| A-39 | 1 | P-39 | 1 | 1 |
| A-40 | 1 | P-40 | 1 | 1 |
| A-41 | 1 | P-41 | 1 | 1 |
| A-42 | 1 | P-42 | 1 | 1 |
| A-43 | 1 | P-03 | 1 | 1 |
| A-44 | 1 | P-44 | 1 | 1 |
| A-45 | 1 | P-45 | 1 | 1 |
| A-46 | 1 | P-46 | 1 | 1 |
| A-47 | 1 | P-47 | 1 | 1 |
| A-48 | 1 | P-48 | 1 | 1 |
| A-49 | 1 | P-49 | 1 | 1 |
| A-50 | 1 | P-50 | 1 | 1 |
| A-51 | 1 | P-51 | 1 | 1 |
| A-52 | 1 | P-52 | 1 | 1 |
| A-53 | 1 | P-53 | 1 | 1 |
| A-54 | 1 | P-54 | 1 | 1 |
| A-55a | 3 | P-1 | 2 | 1 |
| A-55b | 3 | P-1 | 2(*2) | 1 |
| A-56 | 3 | P-2 | 2 | 1 |
| A-57 | 3 | P-7 | 2 | 1 |
| A-58 | 3 | P-8 | 2 | 1 |
| A-59 | 3 | P-12 | 2 | 1 |
| A-60 | 3 | P-24 | 2 | 1 |
| A-61 | 3 | P-25 | 2 | 1 |
| A-62a | 2 | P-1 | 3 | 2 |
| A-62b | 2 | P-1 | 3(*3) | 2 |
| A-63 | 2 | P-2 | 3 | 2 |
| A-64 | 2 | P-7 | 3 | 2 |
| A-65 | 2 | P-8 | 3 | 2 |
| A-66 | 2 | P-12 | 3 | 2 |
| A-67 | 2 | P-24 | 3 | 2 |
| A-68 | 2 | P-25 | 3 | 2 |
| B-1 | 1 | R-1 | 1 | 1 |
| B-2 | 1 | R-2 | 1 | 1 |

(continued)

| Lithographic Printing Plate Precursor | Aluminum Support | Specific Polymer Compound or Comparative Polymer Compound in Undercoat Layer | Image-Recording Layer | Protective Layer |
|---|---|---|---|---|
| B-3 | 1 | R-3 | 1 | 1 |
| B-4 | 1 | R-4 | 1 | 1 |
| B-5 | 1 | R-5 | 1 | 1 |
| B-6 | 3 | R-1 | 2 | 1 |
| B-7 | 3 | R-2 | 2 | 1 |
| B-8 | 3 | R-5 | 2 | 1 |
| B-9 | 2 | R-2 | 3 | 2 |
| B-10 | 2 | R-5 | 3 | 2 |
| *1, *2 and *3: Undercoat layer was not provided and the coating solution for undercoat layer containing Specific polymer compound P-1 was mixed with the coating solution for image-recording layer just before coating to from the image-recording layer. | | | | |

(2) Evaluation of Lithographic printing plate precursor

[Exposure, Development and Printing>

Each of the lithographic printing plate precursors shown in Tables 2, 3 and 4 was subjected to image exposure by Violet semiconductor laser platesetter Vx9600 (having InGaN semiconductor laser (emission wavelength: 405 nm $\pm$ 10 nm/output: 30 mW)) produced by FUJIFILM Electronic Imaging Ltd. (FFEI). The image exposure was performed at resolution of 2,438 dpi using FM screen (TAFFETA 20, produced by FUJIFILM Corp.) in a plate surface exposure amount of 0.05 mJ/cm$^2$ so as to have a halftone dot area ratio of 50%.

Then, the exposed lithographic printing plate precursor was subjected to development processing in an automatic development processor having a structure as shown in Fig. 1 using Developer 1, 3 or 4 shown below. The automatic development processor was equipped with one brush roller having an outer diameter of 50 mm and being implanted with fiber of polybutylene terephthalate (bristle diameter: 200 $\mu$m, bristle length: 17 mm), and the brush roller was rotated at 200 rpm (peripheral velocity at the tip of brush: 0.52 m/sec) in the same direction as the transporting direction of the lithographic printing plate precursor. In the pre-heating unit, a heater was set so as to reach the surface temperature of the lithographic printing plate precursor 100°C. The temperature of the developer was 30°C. The transportation of the lithographic printing plate precursor was performed at transporting speed of 100 cm/min. After the development processing, drying was performed in the drying unit. The temperature of drying was 80°C.

Also, the development processing was performed by an automatic development machine (LP-850P2, produced by FUJIFILM Corp.) using Developer 2 shown below. The automatic development machine comprised a pre-heating unit, a pre-water washing unit, a developing unit, a post-water washing unit and a gum solution treating unit. Developer 2 was charged in the developing unit and tap water was charged in the post-water washing unit. In the pre-water washing unit and gum solution treating unit was not charged a processing solution and only their transporting functions were used. The development processing was performed under conditions of the pre-heating temperature of 100°C, the developer temperature of 30°C and the developing time of 18 seconds.

The compositions of Developers 1 to 4 are described below. In the compositions described below, NEWCOL B 13 (produced by Nippon Nyukazai Co., Ltd.) was polyoxyethylene $\beta$— naphthyl ether (average number of oxyethylene: n = 13) and the gum arabic had a weight average molecular weight of 200,000.

(Developer 1)

| | |
|---|---|
| Sodium carbonate | 13.0 parts by weight |
| Sodium hydrogen carbonate | 7.0 parts by weight |
| NEWCOLB13 | 50.0 parts by weight |
| Ammonium primary phosphate | 2.0 parts by weight |
| 2-Bromo-2-nitropropane-1,3-diol | 0.01 part by weight |
| 2- Methyl-4-isothiazoline-3-one | 0.01 part by weight |

(continued)

| | |
|---|---|
| (Developer 1) | |
| Trisodiun citrate | 15.0 parts by weight |
| Distilled water | 913.98 parts by weight |
| (pH: 9.8) | |

| | |
|---|---|
| (Developer 2) | |
| Potassium hydroxide | 0.15 parts by weight |
| NEWCOL B13 | 5.0 parts by weight |
| CHELEST 400 (chelating agent) | 0.1 part by weight |
| Distilled water | 94.75 parts by weight |
| (pH: 12.05) | |

| | |
|---|---|
| (Developer 3) | |
| Gum arabic | 25.0 parts by weight |
| Enzyme-modified potato starch | 70.0 parts by weight |
| Sodium salt of dioctylsulfosuccinate ester | 5.0 parts by weight |
| Ammonium primary phosphate | 1.0 parts by weight |
| Citric acid | 1.0 parts by weight |
| 2-Bromo-2-nitropropane-1,3-diol | 0.01 part by weight |
| 2-Methyl-4-isothiazoline-3-one | 0.01 part by weight |
| Amphoteric surfactant (W-1) shown below | 70.0 parts by weight |
| Anionic surfactant (AN-1) shown below | 3.0 parts by weight |
| Distilled water | 824.98 parts by weight |

(pH was adjusted to 4.5 by adding phosphoric acid and so

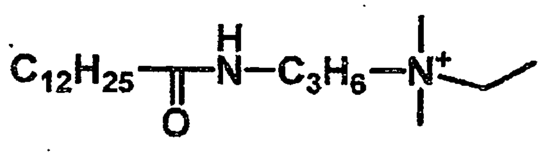

(W−1)

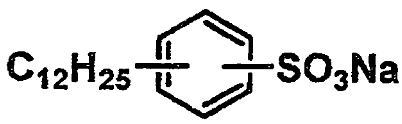

(AN−1)

| | |
|---|---|
| (Developer 4) | |
| Water | 88.6 parts by weight |
| Nonionic Surfactant (W-2) shown below | 2.4 parts by weight |
| Nonionic Surfactant (W-3) shown below | 2.4 parts by weight |
| Nonionic surfactant (EMALEX 710, produced by Nihon Emulsion Co., Ltd.) | 1.0 parts by weight |
| Phenoxypropanol | 1.0 parts by weight |

(continued)

| | |
|---|---|
| (Developer 4) | |
| Octanol | 0.6 parts by weight |
| N-(2-Hydroxyethyl)morpholine | 1.0 parts by weight |
| Triethanolamine | 0.5 parts by weight |
| Sodium gluconate | 1.0 parts by weight |
| Trisodium citrate | 0.5 parts by weight |
| Tetrasodium ethylenediaminetetraacetate | 0.05 parts by weight |
| Polystyrenesulfonic acid (VERSA TL77 (30% solution) produced by Alco Chemical Inc.) | 1.0 parts by weight |

(pH was adjusted to 7.0 by adding phosphoric acid)

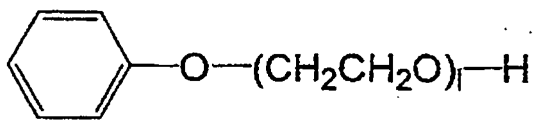

l=13-28

(W-2)

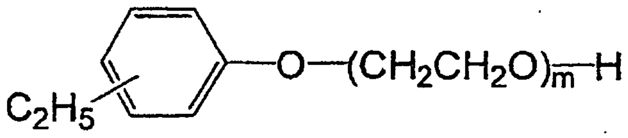

m=12-26

(W-3)

The lithographic printing plate thus-obtained was mounted on a printing machine (SOR-M, produced by Heidelberg) and printing was performed at a printing speed of 6,000 sheets per hour using dampening water (EU-3 (etching solution, produced by FUJIFILM Corp.))/water/isopropyl alcohol = 1/89/10 (by volume ratio)) and TRANS-G (N) black ink (produced by Dai-Nippon Ink & Chemicals, Inc.).

[Evaluation]

With each lithographic printing plate precursor, printing durability, stain resistance, stain resistance after the lapse of time, developing property and chemical resistance were evaluated in the manner described below. The results obtained are shown in Tables 2 to 4.

(Printing durability)

With the increase in the number of printing sheets, the image-recording layer was gradually abraded to cause decrease in the ink receptivity, resulting in decrease of ink density on printing paper. With respect to the lithographic printing plate obtained by exposure in the same exposure amount a number of printing sheets obtained until the ink density (reflection density) decreased by 0.1 from that at the initiation of printing was determined to evaluate the printing durability. The evaluation of printing durability was conducted by a relative printing durability as defined below using as the criterion (1.0), the number of printing sheets of Comparative Examples 1, 6 and 9 in Tables 2, 3 and 4, respectively. When the value of the relative printing durability is larger, it is meant that the printing durability is higher.

Relative printing durability = (Number of printing sheets of subject lithographic printing plate precursor)/(Number of printing sheets of criterion lithographic printing plate precursor)

(Stain resistance)

The 20th sheet of the printed material from the initiation of printing was picked up and the density of ink adhered on the non-image area was visually observed to evaluate the stain resistance on scales of 10 to 0 shown below. When the value is larger, it is meant that the stain resistance is better.

TABLE A

| Stain Resistance | Ink Density by Visual Observation |
|---|---|
| 10 | Ink density was not confirmed. |
| 9 | Ink density was slightly confirmed. |
| 8 | Ink density was somewhat confirmed, but did not cause problem. |
| 7 | Less than 5% in density |
| 6 | From 6 to 10% in density |
| 5 | From 11 to 20% in density |
| 4 | From 21 to 30% in density |
| 3 | From 31 to 50% in density |
| 2 | From 51 to 70% in density |
| 1 | From 71 to 90% in density |
| 0 | From 91 to 100% in density |

(Stain resistance after lapse of time)

The lithographic printing plate precursor was allowed to stand in a constant temperature and constant humidity chamber set at a temperature of 60°C and a relative humidity of 60% for 3 days. Then, using the lithographic printing plate precursor allowed to stand, a lithographic printing plate was prepared and the stain resistance after the lapse of time was evaluated in the same manner as in the evaluation of stain resistance described above. When the value is larger, it is meant that the stain resistance after the lapse of time is better.

(Developing property)

With the lithographic printing plates obtained by performing the development processing while varying the transporting speed described above, cyan density of the non-image area was measured by a Macbeth densitometer. The transporting speed at which the cyan density of the non-image area became equivalent to cyan density of the aluminum support was determined to evaluate the developing property. The evaluation of developing property was conducted by a relative developing property as defined below using as the criterion (1.0), the transporting speed of Comparative Examples 1, 6 and 9 in Tables 2, 3 and 4, respectively. When the value of the relative developing property is larger, it is meant that the developing property is higher and the performance is better.

Relative developing property = (Transporting speed of subject lithographic printing plate precursor)/(Transportmg speed of criterion lithographic printing plate precursor)

(Chemical resistance)

With respect to the lithographic printing plate obtained by exposure in the same exposure amount, a test solution for chemical resistance having the composition shown below was dropped on the image area (halftone dot area of 50%) and after 20 minutes the solution dropped was wiped off. A Scotch brand tape (produced by 3M) was stuck on the dropped area of the lithographic printing plate and then the tape was peeled off and decrease in the halftone dot area in the dropped area was visually observed to evaluate the chemical resistance on scales of 10 to 0 shown below. When the value is larger, it is meant that the chemical resistance is better.

(Test solution for chemical resistance)

| | |
|---|---|
| Butyl diglycol | 190.0 g |
| Butyl glycol | 140.0 g |
| Malic acid | 15.0 g |
| Citric acid | 8.0 g |
| Sodium hydroxide | 24.0 g |
| Ammonium nitrate | 15.0 g |

(continued)

| (Test solution for chemical resistance) | |
|---|---|
| Distilled water | 608.0 g |

TABLE B

| Chemical Resistance | Decrease in Halftone Dot Area by Visual Observation |
|---|---|
| 10 | Decrease in halftone dot area was not observed. |
| 9 | Decrease in halftone dot area was almost not observed. |
| 8 | Decrease in halftone dot area was somewhat observed, but did not cause problem. |
| 7 | Decrease in (halftone dot area was less than 5%. |
| 6 | Decrease in halftone dot area was from 6 to 10%. |
| 5 | Decrease in halftone dot area was from 11 to 20% |
| 4 | Decrease in halftone dot area was from 21 to 30%. |
| 3 | Decrease in halftone dot area was from 31 to 40%. |
| 2 | Decrease in halftone dot area was from 41 to 50%. |
| 1 | Decrease in halftone dot area was from 51 to 75%. |
| 0 | Decrease in halftone dot area was from 76 to 100%. |

TABLE 2

| | Lithographic Printing Plate Precursor | Developer | Performance | | | | |
|---|---|---|---|---|---|---|---|
| | | | Printing Durability | Stain Resistance | Satin Resistance after Lapse of Time | Developing Property | Chemical Resistance |
| Example 1 | A-1a | 1 | 1.6 | 9 | 8 | 1.2 | 8 |
| Example 2 | A-1a | 3 | 1.6 | 8 | 7 | 1.2 | 7 |
| Example 3 | A-1a | 4 | 1.5 | 8 | 8 | 1.0 | 7 |
| Example 4 | A-1b | 1 | 1.5 | 8 | 7 | 1.1 | 7 |
| Example 5 | A-2 | 1 | 1.6 | 8 | 8 | 1.1 | 10 |
| Example 6 | A-3 | 1 | 1.5 | 9 | 9 | 1.0 | 8 |
| Example 7 | A-4 | 1 | 1.5 | 10 | 9 | 1.1 | 7 |
| Example 8 | A-5 | 1 | 1.4 | 9 | 7 | 1.0 | 7 |
| Example 9 | A-6 | 1 | 1.6 | 8 | 7 | 1.1 | 8 |
| Example 10 | A-7 | 1 | 1.7 | 8 | 8 | 1.2 | 7 |
| Example 11 | A-8 | 1 | 1.7 | 8 | 7 | 1.1 | 7 |
| Example 12 | A-9 | 1 | 1.4 | 9 | 8 | 1.0 | 7 |
| Example 13 | A-10 | 1 | 1.4 | 10 | 8 | 1.1 | 8 |
| Example 14 | A-11 | 1 | 1.7 | 9 | 8 | 1.1 | 8 |
| Example 15 | A-12 | 1 | 1.8 | 9 | 8 | 1.1 | 10 |
| Example 16 | A-13 | 1 | 1.5 | 10 | 8 | 1.0 | 7 |
| Example 17 | A-14 | 1 | 1.5 | 9 | 9 | 1.3 | 7 |
| Example 18 | A-15 | 1 | 1.9 | 8 | 7 | 1.0 | 10 |
| Example 19 | A-16 | 1 | 1.9 | 8 | 7 | 1.0 | 10 |
| Example 20 | A-17 | 1 | 1.6 | 7 | 6 | 1.0 | 7 |
| Example 21 | A-18 | 1 | 1.5 | 7 | 7 | 1.0 | 8 |
| Example 22 | A-19 | 1 | 1.4 | 7 | 7 | 1.0 | 7 |
| Example 23 | A-20 | 1 | 1.4 | 7 | 7 | 1.0 | 7 |
| Example 24 | A-21 | 1 | 1.5 | 7 | 7 | 1.0 | 8 |

(continued)

| | Lithographic Printing Plate Precursor | Developer | Performance | | | | |
|---|---|---|---|---|---|---|---|
| | | | Printing Durability | Stain Resistance | Satin Resistance after Lapse of Time | Developing Property | Chemical Resistance |
| Example 25 | A-22 | 1 | 1.4 | 7 | 6 | 1.1 | 7 |
| Example 26 | A-23 | 1 | 1.4 | 8 | 6 | 1.1 | 6 |
| Example 27 | A-24 | 1 | 1.5 | 7 | 7 | 1.1 | 10 |
| Example 28 | A-25 | 1 | 1.5 | 8 | 7 | 1.1 | 8 |
| Example 29 | A-26 | 1 | 1.2 | 7 | 6 | 1.1 | 8 |
| Example 30 | A-27 | 1 | 1.4 | 7 | 6 | 1.0 | 7 |
| Example 31 | A-28 | 1 | 1.4 | 7 | 7 | 1.0 | 8 |
| Example 32 | A-29 | 1 | 1.5 | 7 | 7 | 1.0 | 8 |
| Example 33 | A-30 | 1 | 1.5 | 7 | 6 | 1.0 | 7 |
| Example 34 | A-31 | 1 | 1.2 | 6 | 6 | 1.1 | 8 |
| Example 35 | A-32 | 1 | 1.2 | 6 | 6 | 1.1 | 7 |
| Example 36 | A-33 | 1 | 1.2 | 6 | 6 | 1.1 | 6 |
| Example 37 | A-34 | 1 | 1.6 | 8 | 8 | 1.2 | 8 |
| Example 38 | A-35 | 1 | 1.6 | 8 | 8 | 1.2 | 7 |
| Example 39 | A-36 | 1 | 1.6 | 8 | 8 | 1.2 | 8 |
| Example 40 | A-37 | 1 | 1.6 | 7 | 7 | 1.1 | 7 |
| Example 41 | A-38 | 1 | 1.5 | 7 | 7 | 1.1 | 7 |
| Example 42 | A-39 | 1 | 1.4 | 7 | 7 | 1.1 | 8 |
| Example 43 | A-40 | 1 | 1.6 | 7 | 7 | 1.1 | 7 |
| Example 44 | A-41 | 1 | 1.5 | 7 | 6 | 1.1 | 7 |
| Example 45 | A-42 | 1 | 1.5 | 7 | 6 | 1.1 | 8 |
| Example 46 | A-43 | 1 | 1.5 | 8 | 8 | 1.2 | 8 |
| Example 47 | A-44 | 1 | 1.3 | 8 | 7 | 1.1 | 7 |

(continued)

| | Lithographic Printing Plate Precursor | Developer | Performance | | | | |
|---|---|---|---|---|---|---|---|
| | | | Printing Durability | Stain Resistance | Satin Resistance after Lapse of Time | Developing Property | Chemical Resistance |
| Example 48 | A-45 | 1 | 1.3 | 7 | 6 | 1.0 | 7 |
| Example 49 | A-46 | 1 | 1.2 | 7 | 6 | 1.1 | 7 |
| Example 50 | A-47 | 1 | 1.3 | 6 | 6 | 1.1 | 7 |
| Example 51 | A-48 | 1 | 1.2 | 8 | 6 | 1.1 | 7 |
| Example 52 | A-49 | 1 | 1.4 | 7 | 6 | 1.0 | 8 |
| Example 53 | A-50 | 1 | 1.6 | 8 | 7 | 1.2 | 8 |
| Example 54 | A-51 | 1 | 1.6 | 7 | 7 | 1.1 | 10 |
| Example 55 | A-52 | 1 | 1.6 | 7 | 7 | 1.2 | 8 |
| Example 56 | A-53 | 1 | 1.6 | 7 | 6 | 1.1 | 10 |
| Example 57 | A-54 | 1 | 1.4 | 9 | 8 | 1.2 | 8 |
| Comparative Example 1 | B-1 | 1 | 1.0 | 8 | 7 | 1.0 | 0 |
| Comparative Example 2 | B-2 | 1 | 1.2 | 9 | 3 | 0.5 | 0 |
| Comparative Example 3 | B-3 | 1 | 0.9 | 7 | 4 | 0.8 | 0 |
| Comparative Example 4 | B-4 | 1 | 1.1 | 6 | 3 | 0.4 | 1 |
| Comparative Example 5 | B-5 | 1 | 1.5 | 4 | 2 | 0.6 | 8 |

TABLE 3

| | Lithographic Printing Plate Precursor | Developer | Performance | | | | |
|---|---|---|---|---|---|---|---|
| | | | Printing Durability | Stain Resistance | Satin Resistance after Lapse of Time | Developing Property | Chemical Resistance |
| Example 58 | A-1a | 2 | 1.6 | 7 | 7 | 1.2 | 7 |
| Example 59 | A-2 | 2 | 1.5 | 7 | 6 | 1.0 | 8 |
| Example 60 | A-7 | 2 | 1.6 | 7 | 7 | 1.1 | 7 |
| Example 61 | A-8 | 2 | 1.4 | 7 | 6 | 1.2 | 6 |
| Example 62 | A-12 | 2 | 1.5 | 6 | 6 | 1.0 | 8 |
| Example 63 | A-24 | 2 | 1.4 | 7 | 7 | 1.1 | 7 |
| Example 64 | A-25 | 2 | 1.3 | 7 | 7 | 1.1 | 7 |
| Comparative Example 6 | B-1 | 2 | 1.0 | 7 | 5 | 1.0 | 0 |
| Comparative Example 7 | B-2 | 2 | 1.1 | 7 | 6 | 0.5 | 2 |
| Comparative Example 8 | B-5 | 2 | 1.6 | 4 | 1 | 1.0 | 8 |

TABLE 4

| Precursor | Lithographic Printing Plate Precursor | Developer | Perfonnance | | | | |
|---|---|---|---|---|---|---|---|
| | | | Printing Durability | Stain Resistance | Satin Resistance after Lapse of Time | Developing Property | Chemical Resistance |
| Example 65 | A-55a | 4 | 1.6 | 8 | 7 | 1.0 | 8 |
| Example 66 | A-55a | 1 | 1.5 | 9 | 8 | 1.1 | 8 |
| Example 67 | A-55b | 4 | 1.5 | 8 | 7 | 1.1 | 7 |
| Example 68 | A-56 | 4 | 1.6 | 7 | 7 | 1.0 | 9 |
| Example 69 | A-57 | 4 | 1.6 | 7 | 7 | 1.1 | 7 |
| Example 70 | A-58 | 4 | 1.4 | 7 | 7 | 1.0 | 6 |
| Example 71 | A-59 | 4 | 1.3 | 7 | 6 | 1.0 | 8 |
| Example 72 | A-60 | 4 | 1.4 | 7 | 7 | 1.1 | 7 |
| Example 73 | A-61 | 4 | 1.3 | 7 | 7 | 1.0 | 7 |
| Comparative Example 9 | B-6 | 4 | 1.0 | 6 | 5 | 1.0 | 0 |
| Comparative Example 10 | B-7 | 4 | 1.1 | 6 | 6 | 0.4 | 2 |
| Comparative Example 11 | B-8 | 4 | 1.6 | 4 | 1 | 1.0 | 8 |

As is apparent form the results shown in Tables 2 to 4, it can be seen that the good printing durability, stain resistance, stain resistance after the lapse of time and chemical resistance are obtained while maintaining the developing property by incorporating the specific polymer compound.

Examples 74 to 89 and Comparative Examples 12 to 15

[Exposure, Development and Prinking>

Each of the lithographic printing plate precursors shown in Tables 5 and 6 was subjected to image exposure with halftone dots of 50% by TRENDSETTER 3244VX, (produced by Creo Co.) equipped with a water-cooled 40 W infrared semiconductor laser (830 nm) under the conditions of output of 9 W, a rotational number of an external drum of 210 rpm and resolution of 2,400 dpi. The exposed lithographic printing plate precursor was then subjected to the development processing in the same manner as in Example 1 using Developer 1 or 4.

The lithographic printing plate thus-obtained was mounted on a printing machine (SOR-M, produced by Heidelberg) and printing was performed at a printing speed of 6,000 sheets per hour using dampening water (EU-3 (etching solution, produced by FUJIFILM Corp.))/water/isopropyl alcohol = 1/89/10 (by volume ratio)) and TRANS-G (N) black ink (produced by Dai-Nippon Ink & Chemicals, Inc.).

[Evaluation]

With each lithographic printing plate precursor, the printing durability, stain resistance, stain resistance after the lapse of time, developing property and chemical resistance were evaluated in the same manner as in Example 1. The evaluations of printing durability and developing property were conducted using as the criterion (1.0), Comparative Examples 12 and 14 in Tables 5 and 6, respectively. The results obtained are shown in Tables 5 and 6.

TABLE 5

| | Lithographic Printing Plate Precursor | Developer | Performance | | | | |
|---|---|---|---|---|---|---|---|
| | | | Printing Durability | Stain Resistance | Satin Resistance after Lapse of Time | Developing Property | Chemical Resistance |
| Example 74 | A-62a | 1 | 1.4 | 9 | 8 | 1.5 | 9 |
| Example 75 | A-62b | 1 | 1.3 | 8 | 7 | 1.5 | 9 |
| Example 76 | A-63 | 1 | 1.4 | 8 | 8 | 1.5 | 10 |
| Example 77 | A-64 | 1 | 1.3 | 8 | 7 | 1.5 | 9 |
| Example 78 | A-65 | 1 | 1.3 | 8 | 7 | 1.6 | 8 |
| Example 79 | A-66 | 1 | 1.3 | 8 | 8 | 1.5 | 7 |
| Example 80 | A-67 | 1 | 1.4 | 7 | 7 | 1.5 | 7 |
| Example 81 | A-68 | 1 | 1.3 | 7 | 6 | 1.5 | 7 |
| Comparative Example 12 | B-9 | 1 | 1.0 | 8 | 6 | 1.0 | 0 |
| Comparative Example 13 | B-10 | 1 | 1.4 | 4 | 2 | 1.3 | 8 |

TABLE 6

| | Lithographic Printing Plate Precursor | Developer | Performance | | | | |
|---|---|---|---|---|---|---|---|
| | | | Printing Durability | Stain Resistance | Satin Resistance after Lapse of Time | Developing Property | Chemical Resistance |
| Example 82 | A-62a | 4 | 1.5 | 9 | 9 | 1.6 | 9 |
| Example 83 | A-62b | 4 | 1.4 | 8 | 8 | 1.5 | 9 |
| Example 84 | A-63 | 4 | 1.5 | 9 | 8 | 1.6 | 10 |
| Example 85 | A-64 | 4 | 1.3 | 8 | 8 | 1.4 | 8 |
| Example 86 | A-65 | 4 | 1.4 | 8 | 7 | 1.5 | 9 |
| Example 87 | A-66 | 4 | 1.0 | 8 | 7 | 1.4 | 8 |
| Example 88 | A-67 | 4 | 1.4 | 7 | 7 | 1.6 | 8 |
| Example 89 | A-68 | 4 | 1.3 | 7 | 7 | 1.5 | 8 |
| Comparative Example 14 | B-9 | 4 | 1.0 | 8 | 7 | 1.0 | 0 |
| Comparative Example 15 | B-10 | 4 | 1.5 | 4 | 2 | 1.3 | 8 |

As is apparent form the results shown in Tables 5 and 6, it can be seen that the good printing durability, stain resistance, stain resistance after the lapse of time, developing property and chemical resistance are obtained by incorporating the specific polymer compound.

Examples 90 to 97 and Comparative Examples 1.6 and 17

[Exposure, Development and Printing>

Each of the lithographic printing plate precursors shown in Table 7 was exposed by LUXEL PLATESETTER T-6000III equipped with an infrared semiconductor laser (produced by FUJIFILM Corp.) under the conditions of a rotational number of an external drum of 1,000 rpm, a laser output of 70% and a resolution of 2,400 dpi. The exposed image contained a solid image and a 50% halftone dot chart of a 20 μm-dot FM screen.

The exposed lithographic printing plate precursor was mounted without undergoing development processing on a plate cylinder of a printing machine (LITHRONE 26, produced by Komori Corp.). Using dampening water (ECOLITY-2 (produced by FUJIFILM Corp.)/tap water 2/98 (volume ratio)) and VALUES-G (N) black ink (produced by Dai-Nippon Ink & Chemicals, Inc.), the dampening water and ink were supplied according to the standard automatic printing start method of LITHRONE 26 to conduct on-press development and then printing on 100 sheets of TOKUBISHI ART PAPER (76.5 kg) at a printing speed of 10,000 sheets per hour.

[Evaluation]

With each lithographic printing plate precursor, on-press development property, printing durability and chemical resistance were evaluated in the manner described below. Also, the stain resistance and stain resistance after the lapse of time were evaluated in the manner as in Example 1. The results obtained are shown in Table 7.

(On-press development property)

A number of the printing papers required until the on-press development of the non-image area of the image-recording layer on the printing machine was completed to reach a state where the ink was not transferred to the printing paper in the non-image area was measured to evaluate the on-press development property.

(Printing durability)

After performing the evaluation for the on-press development property described above, the printing was continued. With the increase in the number of printing sheets, the image-recording layer was gradually abraded to cause decrease in the ink density on the printed material. A number of the printing sheets wherein a value obtained by measuring a halftone dot area rate of the 50% halftone dot off screen on the printed material using a Gretag densitometer decreased by 5% from the value measured on the 100th paper of the printing was determined to evaluate the printing durability. The evaluation of printing durability was conducted by a relative printing durability as defined below using as the criterion (1.0), the number of printed materials of Comparative Example 16. When the value of the relative printing durability is larger, it is meant that the printing durability is higher.

Relative printing durability = (Number of printing sheets of subject lithographic printing plate precursor)/(Number of printing sheets of criterion lithographic printing plate precursor)

(Chemical resistance)

With respect to the lithographic printing plate obtained by exposure in the same exposure amount, the test solution for chemical resistance described in Example 1 was dropped on the image area (halftone dot area of 50%) and after 20 minutes the solution dropped was wiped off The decrease in the halftone dot area in the dropped area on the 300th printed material was visually observed to evaluate the chemical resistance on scales of 10 to 0 shown below. When the value is larger, it is meant that the chemical resistance is better.

TABLE C

| Chemical Resistance | Decrease in Halftone Dot Area by Visual Observation |
|---|---|
| 10 | Decrease in halftone dot area was not observed. |
| 9 | Decrease in halftone dot area was almost not observed. |

(continued)

| Chemical Resistance | Decrease in Halftone Dot Area by Visual Observation |
|---|---|
| 8 | Decrease in halftone dot area was somewhat observed, but did not cause problem. |
| 7 | Decrease in halftone dot area was less than 5%. |
| 6 | Decrease in halftone dot area was from6 to 10%. |
| 5 | Decrease in halftone dot area was from 11 to 20% |
| 4 | Decrease in halftone dot area was from 21 to 30%. |
| 3 | Decrease in halftone dot area was from 31 to 40%. |
| 2 | Decrease in halftone dot area was from 41 to 50%. |
| 1 | Decrease in halftone dot area was from 51 to 75%. |
| 0 | Decrease in Halftone dot area was from 76 to 100%. |

TABLE 7

| | Lithographic Printing Plate Precursor | Performance | | | | |
|---|---|---|---|---|---|---|
| | | Printing Durability | Stain Resistance | Satin Resistance after Lapse of Time | On-press Development Property | Chemical Resistance |
| Example 90 | A-62a | 1.4 | 8 | 8. | 20 | 8 |
| Example 91 | A-62b | 1.3 | 8 | 7 | 25 | 8 |
| Example 92 | A-63 | 1.3 | 7 | 8 | 25 | 10 |
| Example 93 | A-64 | 1.3 | 7 | 8 | 40 | 9 |
| Example 94 | A-65 | 1.3 | 8 | 8 | 30 | 8 |
| Example 95 | A-66 | 1.3 | 7 | 7 | 30 | 8 |
| Example 96 | A-67 | 1.3 | 7 | 7 | 35 | 8 |
| Example 97 | A-68 | 1.3 | 7 | 7 | 40 | 7 |
| Comparative Example 16 | B-9 | 1.0 | 8 | 7 | 40 | 0 |
| Comparative Example 17 | B-10 | 1.3 | 2 | 1 | 100 | 8 |

As is apparent form the results shown in Table 7, it can be seen that the good printing durability, stain resistance, stain resistance after the lapse of time, on-press development property and chemical resistance are obtained by incorporating the specific polymer compound,

## Claims

**1.** A lithographic printing plate precursor comprising an image-recording layer and a support, wherein the image-recording layer adjacent to the support or an undercoat layer provided between the support and the image-recording layer comprises (A) a polymer having a side chain having a structure represented by the following formula (I) or (II):

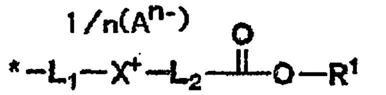 (I) 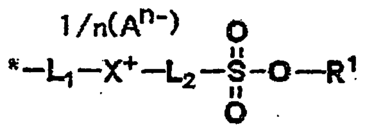 (II)

wherein $R^1$ represents a monovalent group, $L_1$ represents a divalent connecting group connecting to a main chain of the polymer, $L_2$ represents a divalent connecting group, $X^+$ represents $-N^+R^2R^3-$, $-S^+R^2-$, $-I^+-$, $-P^+R^2R^3-$ or a group represented by the following formula (III), $R^2$ and $R^3$ each independently represents an alkyl group, an aryl group or a heteroaryl group, each of which may be substituted, or $R^2$ and $R^3$ may be combined with each other to form a ring, $1/n(A^{n-})$ represents an anion for making the structure represented by the formula (I) or (II) neutral, n represents an integer of from 1 to 3, and * represents a site connecting to the main chain of the polymer:

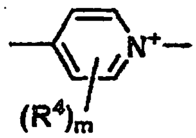 (III)

wherein $R^4$ represents a hydrogen atom or a monovalent group, and m represents an integer of from 1 to 4.

2. The lithographic printing plate precursor as claimed in claim 1, wherein the image-recording layer comprises (B) a polymerization initiator, (C) a polymerizable compound, (D) a sensitizing dye and (E) a binder polymer.

3. The lithographic printing plate precursor as claimed in claim 1 or 2, wherein the polymer (A) is contained in the undercoat layer.

4. The lithographic printing plate precursor as claimed in any one of claims 1 to 3, wherein $X^+$ in the formula (I) or (II) is $-N^+R^2R^3-$.

5. The lithographic printing plate precursor as claimed in any one of claims I to 4, wherein the polymer (A) is a polymer having a side chain having a structure represented by the formula (I).

6. A lithographic printing plate precursor according to any preceding claim, wherein $L_2$ in the formula (I) or (II) is an alkylene group which may be substituted.

7. A lithographic printing plate precursor according to Claim 6, wherein $L_2$ in the formula (I) or (II) is a methylene group which may be substituted.

8. A lithographic printing plate precursor according to any preceding claim, wherein $R^1$ in the formula (I) or (II) is an alkyl group having from 1 to 50 carbon atoms or an aryl group, each of which may be substituted.

9. A lithographic printing plate precursor according to Claim 8, wherein $R^1$ represents an alkyl group having from 1 to 40 carbon atoms or an aryl group.

10. A lithographic printing plate precursor according to Claim 9, wherein $R^1$ represents an alkyl group having from 3 to 30 carbon atoms which may be substituted or may be branched.

11. A lithographic printing plate precursor according to Claim 2, wherein the binder polymer (E) is a (meth)acrylic resin or a urethane resin.

12. A method for preparing a lithographic printing plate comprising:

exposing imagewise the lithographic printing plate precursor as claimed in any one of Claims 1 to 11; and removing a non-image area of the image-recording layer of the exposed lithographic printing plate precursor in the presence of a developer having pH of from 2 to 14, or removing a non-image area of the image-recording layer of the exposed lithographic printing plate precursor by supplying printing ink and dampening water on a printing machine.

## Patentansprüche

1. Lithografiedruckplattenvorläufer, umfassend eine Bildaufzeichnungsschicht und einen Träger, worin die Bildaufzeichnungsschicht, die an den Träger angrenzt, oder eine Unterzugsschicht, die zwischen dem Träger und der

Bildaufzeichnungsschicht vorgesehen ist, ein Polymer (A) umfasst, welches eine Seitenkette aufweist, die eine durch die folgenden Formel (I) oder (II) dargestellte Struktur aufweist:

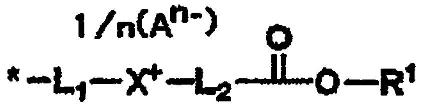 (I) 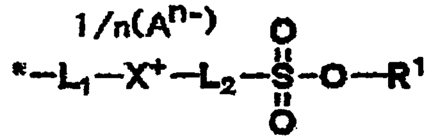 (II)

worin $R^1$ eine monovalente Gruppe darstellt, $L_1$ eine divalente Verknüpfungsgruppe darstellt, die mit einer Hauptkette des Polymers verknüpft ist, $L_2$ eine divalente Verknüpfungsgruppe darstellt, $X^+$ $-N^+R^2R^3-$, $-S^+R^2-$, $-I^+-$, $-P^+R^2R^3-$ oder eine durch die folgende Formel (III) dargestellte Gruppe darstellt, $R^2$ und $R^3$ jeweils unabhängig eine Alkylgruppe, eine Arylgruppe oder eine Heteroarylgruppe darstellen, von denen jede substituiert sein kann, oder $R^2$ und $R^3$ miteinander verbunden sein können, um einen Ring zu bilden, $1/n(A^{n-})$ ein Anion darstellt, um die durch die Formel (I) oder (II) dargestellte Struktur neutral zu gestalten, n eine ganze Zahl von 1 bis 3 darstellt und * eine Stelle darstellt, die mit der Hauptkette des Polymers verknüpft ist:

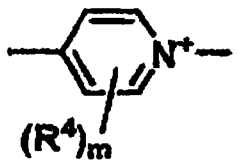 (III)

worin $R^4$ ein Wasserstoffatom oder eine monovalente Gruppe darstellt und m eine ganze Zahl von 1 bis 4 darstellt.

**2.** Lithografiedruckplattenvorläufer gemäß Anspruch 1, worin die Bildaufzeichnungsschicht (B) einen Polymerisationsinitiator, (C) eine polymerisierbare Verbindung, (D) einen Sensibilisierungsfarbstoff und (E) ein Bindepolymer enthält.

**3.** Lithografiedruckplattenvorläufer gemäß Anspruch 1 oder 2, worin das Polymer (A) in der Unterzugsschicht enthalten ist.

**4.** Lithografiedruckplattenvorläufer gemäß irgendeinem der Ansprüche 1 bis 3, worin $X^+$ in der Formel (I) oder (II) $-N^+R^2R^3-$ darstellt.

**5.** Lithografiedruckplattenvorläufer gemäß irgendeinem der Ansprüche 1 bis 4, worin das Polymer (A) ein Polymer ist, das eine Seitenkette aufweist, welche eine durch die Formel (I) dargestellte Struktur aufweist.

**6.** Lithografiedruckplattenvorläufer gemäß irgendeinem vorhergehenden Anspruch, worin $L_2$ in der Formel (I) oder (II) eine Alkylengruppe ist, die substituiert sein kann.

**7.** Lithografiedruckplattenvorläufer gemäß Anspruch 6, worin $L_2$ in der Formel (I) oder (II) eine Methylengruppe ist, die substituiert sein kann.

**8.** Lithografiedruckplattenvorläufer gemäß irgendeinem vorhergehenden Anspruch, worin $R^1$ in der Formel (I) oder (II) eine Alkylgruppe ist, die von 1 bis 50 Kohlenstoffatome aufweist, oder eine Arylgruppe ist, von denen jede substituiert sein kann.

**9.** Lithografiedruckplattenvorläufer gemäß Anspruch 8, worin $R^1$ eine Alkylgruppe mit 1 bis 40 Kohlenstoffatomen oder eine Arylgruppe darstellt.

**10.** Lithografiedruckplattenvorläufer gemäß Anspruch 9, worin $R^1$ eine Alkylgruppe mit 3 bis 30 Kohlenstoffatomen darstellt, die substituiert sein kann oder die verzweigt sein kann.

**11.** Lithografiedruckplattenvorläufer gemäß Anspruch 2, worin das Bindepolymer (E) ein (Meth)acrylharz oder ein Urethanharz ist.

**12.** Verfahren zur Herstellung einer Lithografiedruckplatte, umfassend:

bildweises Belichten des Lithografiedruckplattenvorläufers gemäß irgendeinem der Ansprüche 1 bis 11; und Entfernen eines Nicht-Bildbereiches der Bildaufzeichnungsschicht des belichteten Lithografiedruckplattenvorläufers in der Gegenwart eines Entwicklers mit einem pH-Wert von 2 bis 14, oder Entfernen eines Nicht-Bildbereichs der Bildaufzeichnungsschicht des belichteten Lithografiedruckplattenvorläufers durch Zuführen von Drucktinte und Anfeuchtwasser auf einer Druckmaschine.

**Revendications**

1. Précurseur de plaque d'impression lithographique comprenant une couche d'enregistrement d'image et un support, dans lequel la couche d'enregistrement adjacente au support ou une sous-couche prévue entre le support et la couche d'enregistrement d'image comprend (A) un polymère ayant une chaîne latérale ayant une structure représentée par la formule (I) ou (II) suivante :

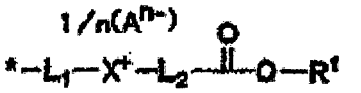 (I) 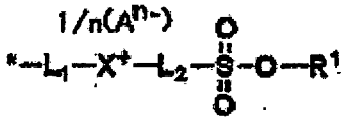 (II)

dans laquelle $R^1$ représente un groupe monovalent, $L_1$ représente un groupe de liaison divalent reliant à une chaîne principale du polymère, $L_2$ représente un groupe de liaison divalent, $X^+$ représente $-N^+R^2R^3-$, $-S^+R^2-$, $-I^+-$, $-P^+R^2R^3-$ ou un groupe représenté par la formule (III) suivante, $R^2$ et $R^3$ représentent chacun indépendamment un groupe alkyle, un groupe aryle ou un groupe hétéroaryle, qui peuvent chacun être substitués, ou $R^2$ et $R^3$ peuvent être combinés l'un avec l'autre pour former un cycle, $1/n(A^{n-})$ représente un anion pour rendre la structure représentée par la formule (I) ou (II) neutre, n représente un nombre entier de 1 à 3, et * représente un site de liaison à la chaîne principale du polymère :

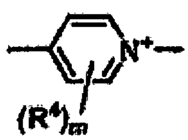 (III)

dans laquelle $R^4$ représente un atome d'hydrogène ou un groupe monovalent, et m représente un nombre entier de 1 à 4.

2. Précurseur de plaque d'impression lithographique selon la revendication 1, dans lequel la couche d'enregistrement d'image comprend (B) un initiateur de polymérisation, (C) un composé polymérisable, (D) un colorant sensibilisant et (E) un polymère liant.

3. Précurseur de plaque d'impression lithographique selon la revendication 1 ou 2, dans lequel le polymère (A) est contenu dans la sous-couche.

4. Précurseur de plaque d'impression lithographique selon l'une quelconque des revendications 1 à 3, dans lequel $X^+$ dans la formule (I) ou (II) est $-N^+R^2R^3-$.

5. Précurseur de plaque d'impression lithographique selon l'une quelconque des revendications 1 à 4, dans lequel le polymère (A) est un polymère ayant une chaîne latérale ayant une structure représentée par la formule (I).

6. Précurseur de plaque d'impression lithographique selon n'importe quelle revendication précédente, dans lequel $L_2$ dans la formule (I) ou (II) est un groupe alkylène qui peut être substitué.

7. Précurseur de plaque d'impression lithographique selon la revendication 6, dans lequel $L_2$ dans la formule (I) ou (II) est un groupe méthylène qui peut être substitué.

8. Précurseur de plaque d'impression lithographique selon n'importe quelle revendication précédente, dans lequel $R^1$ dans la formule (I) ou (II) est un groupe alkyle ayant de 1 à 50 atomes de carbone ou un groupe aryle, qui peuvent

chacun être substitués.

**9.** Précurseur de plaque d'impression lithographique selon la revendication 8, dans lequel $R^1$ représente un groupe alkyle ayant de 1 à 40 atomes de carbone ou un groupe aryle.

**10.** Précurseur de plaque d'impression lithographique selon la revendication 9, dans lequel $R^1$ représente un groupe alkyle ayant de 3 à 30 atomes de carbone qui peut être substitué ou peut être ramifié.

**11.** Précurseur de plaque d'impression lithographique selon la revendication 2, dans lequel le polymère liant (E) est une résine (méth)acrylique ou une résine uréthane.

**12.** Procédé de préparation d'une plaque d'impression lithographique comprenant :

l'exposition sous forme d'image du précurseur de plaque d'impression lithographique selon l'une quelconque des revendications 1 à 11 ; et
l'élimination d'une zone non-image de la couche d'enregistrement d'image du précurseur de plaque d'impression lithographique exposé en présence d'un révélateur ayant un pH de 2 à 14, ou l'élimination d'une zone non-image de la couche d'enregistrement d'image du précurseur de plaque d'impression lithographique exposé par l'alimentation en encre d'impression et eau de mouillage sur une machine à imprimer.

FIG. 1

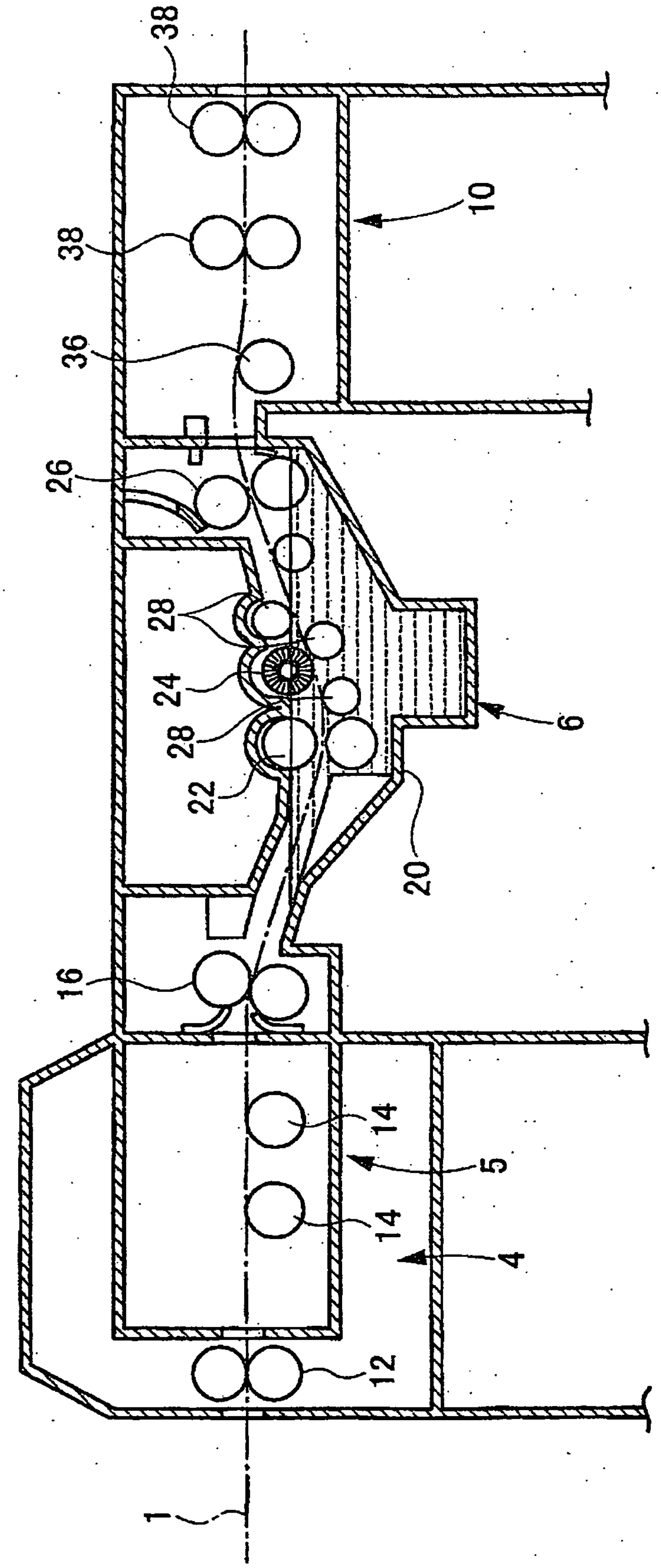

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 4708925 A
- JP 8276558 A
- US 2850445 A
- JP 4420189 B
- JP 2009098590 A
- JP 2009216924 A
- JP 2938397 B
- JP 2000211262 A
- JP 2001277740 A
- JP 2002029162 A
- JP 2002046361 A
- JP 2002137562 A
- JP 2002326470 A
- JP 2001166491 A
- JP 2003063166 A
- JP 2004276603 A
- JP 2008213177 A
- JP 2006078999 A
- JP 20036316C A
- US 2009114108 A
- US 2003190548 A
- EP 24629 A
- EP 107792 A
- US 4410621 A
- JP 5158230 A
- US 4069055 A
- JP 4365049 A
- US 4069056 A
- EP 104143 A
- US 20080311520 A
- JP 2150848 A
- JP 2008195018 A
- EP 370693 A
- EP 233567 A
- EP 297443 A
- EP 297442 A
- US 4933377 A
- US 4760013 A
- US 4734444 A
- US 2833827 A
- DE 2904626
- DE 3604580
- DE 3604581
- JP 2007206217 A
- JP 2006508380 T
- JP 2002287344 A
- JP 2008256850 A
- JP 2001342222 A
- JP 9179296 A
- JP 9179297 A
- JP 9179298 A
- JP 2004294935 A
- JP 2006243493 A
- JP 2002275129 A
- JP 2003064130 A
- JP 2003280187 A
- JP 10333321 A
- JP 48041708 B
- JP 51037193 A
- JP 2032293 B
- JP 2016765 B
- JP 2003344997 A
- JP 2006065210 A
- JP 58049860 B
- JP 56017654 B
- JP 62039417 B
- JP 62039418 B
- JP 2000250211 A
- JP 2007094138 A
- US 7153632 B
- JP 8505958 T
- JP 2007293221 A
- JP 2007293223 A
- JP 2007058170 A
- JP 2007093866 A
- JP 2007072816 A
- JP 2006189604 A
- JP 2007171406 A
- JP 2007206216 A
- JP 2007225701 A
- JP 2007225702 A
- JP 2007316582 A
- JP 2007328243 A
- JP 2001133969 A
- JP 2002023360 A
- JP 200240638 A
- JP 2002278057 A
- JP 2007090850 A
- JP 5005005 A
- JP 2001222101 A
- JP 2007187836 A
- JP 2008276155 A
- JP 2005250438 A
- JP 2005250158 A
- JP 2007276454 A
- JP 2009154525 A
- JP 2006297907 A
- JP 2007050660 A

- JP 2008284858 A
- JP 2009090645 A
- JP 2009208458 A
- JP 9123387 A
- JP 9131850 A
- JP 9171249 A
- JP 9171250 A
- EP 931647 A
- JP 2001277742 A
- JP 2005509192 T
- JP 2004310000 A
- JP 2005250216 A
- JP 2006259137 A
- JP 2005119273 A
- JP 10282679 A
- JP 2304441 A
- JP 2005238816 A
- JP 2005125749 A
- JP 2006239867 A
- JP 2006215263 A
- JP 5045885 A
- JP 6035174 A
- JP 2008203359 A
- JP 2008276166 A
- JP 2009047927 A

**Non-patent literature cited in the description**

- Shin Kobunshi Jikkengaku 3, Kobunsbi no Gosei.Hanno 1. Kyoritsu Shuppan Co., Ltd,
- Shin Jikken Kagaku Koza 19, Kobunshi Kagaku (1). Maruzen Co., Ltd,
- Busshitsu Kogaku Koza. Kobunshi Gosei Kagaku. Tokyo Denki University Press
- **S. I. SCHLESINGER.** *Photogr. Sci. Eng,* 1974, vol. 18, 387
- **T. S. BAL et al.** *Polymer,* 1980, vol. 21, 423
- **J.V. CRIVELLO et al.** *Macromolecules,* vol. 10 (6), 1307
- **J.V. CRIVELLO et al.** *J. Polymer Sci., Polymer Chem. Ed.,* 1979, vol. 17, 1047
- **C.S. WEN et al.** *Teh. Proc. Conf. Rad. Curing ASIA,* October 1988, 478
- *Research Disclosure, No. 33303,* January 1992
- Kobunshi Jiten. 2005, 683-684